# EUROPEAN PATENT APPLICATION

(11) **EP 2 208 745 A1**
(43) Date of publication of application: **21.07.2010**
(21) Application number: 08833921.3
(22) Date of filing: 25.09.2008
(51) Int. Cl.: C08G 61/10, C08G 61/12, C09D 11/00, H01L 29/786, H01L 51/05, H01L 51/30

(54) **POLYMER COMPOUND, METHOD FOR PRODUCING THE SAME, AND COMPOSITION CONTAINING THE POLYMER COMPOUND**

(30) Priority: 28.09.2007 JP 2007255941
(71) Applicant: Sumitomo Chemical Company, Limited, Tokyo 104-8260 (JP)
(72) Inventor: OGUMA, Jun, Cambridge Cambridgeshire CB3 OHH (GB); KOHIRO, Kenji, Tsukuba-shi Ibaraki 305-0032 (JP)
(74) Representative: Duckworth, Timothy John
(86) International application number: PCT/JP2008/067334
(87) International publication number: WO 2009/041527

(57) **Abstract**

It is an object of the invention to provide a polymer compound that can exhibit high charge mobility when used in an organic transistor. The polymer compound according to a preferred embodiment comprises a repeating unit represented by the following formula (1). 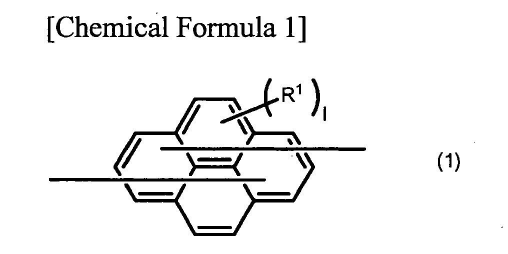 [In the formula, R¹ represents an alkyl group, alkoxy group, alkylthio group, aryl group, aryloxy group, arylthio group, arylalkyl group, arylalkoxy group, arylalkylthio group, substituted silyl group, substituted carboxyl group, monovalent heterocyclic group, cyano group or a fluorine atom, and 1 is an integer of 2 to 8. The multiple R¹ groups may be the same or different.]

## Description

### Technical Field

The present invention relates to a polymer compound and a method for producing it, to a composition containing the polymer compound, to an ink composition and thin-film, and to an organic transistor employing the thin-film.

### Background Art

Organic transistors having a semiconductor layer composed of an organic material that functions as a carrier transport layer (organic thin-film transistors) can be manufactured at low cost and have therefore been of great interest in recent years for their suitability for electronic paper and flexible displays, for example. Organic semiconductor materials are used as the organic materials composing such semiconductor layers (organic semiconductor layers).

Because organic semiconductor materials can simplify the production process, polymer compounds are being studied that can form organic semiconductor layers by dissolving such materials in solvents and coating them. For example, a polymer compound composed of an alternating copolymer of fluorene and bithiophene has been proposed (see Non-patent document 1).
[Non-patent document 1] APPLIED PHYSICS LETTERS, Vol.77, No.3, 2000, P.406-408.

### Disclosure of the Invention

### Problems to be Solved by the Invention

The characteristics of an organic transistor depend primarily on the mobility of charge (electrons or holes) in the organic semiconductor layer, and a higher charge mobility corresponds to superior organic transistor characteristics. With the widening variety of uses for organic transistors in recent years, there is a demand for higher charge mobility than can be conventionally achieved. However, it has been difficult to satisfactorily obtain the demanded high mobility when using the aforementioned conventional polymer compounds.

The present invention has been accomplished in light of these circumstances, and it is an object thereof to provide a polymer compound that allows high charge mobility to be obtained. It is another object of the invention to provide a method for producing the polymer compound, a composition containing the polymer compound, an ink composition and a thin-film, and an organic transistor employing the thin-film, as well as planar light sources and display devices comprising the organic transistor.

### Means for Solving the Problems

In order to achieve the objects stated above, the polymer compound invention has a repeating unit represented by the following formula (1). 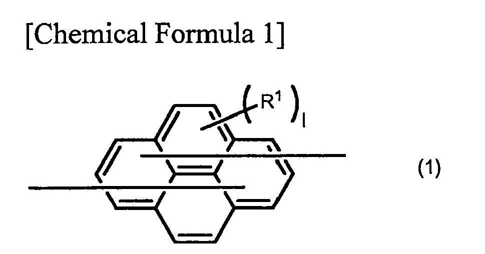 [In the formula, R¹ represents an alkyl group, alkoxy group, alkylthio group, aryl group, aryloxy group, arylthio group, arylalkyl group, arylalkoxy group, arylalkylthio group, substituted silyl group, substituted carboxyl group, monovalent heterocyclic group, cyano group or a fluorine atom, and 1 is an integer of 2 to 8. The multiple R¹ groups may be the same or different.]

A polymer compound having this structure comprises a pyrene structure represented by formula (1) above as a repeating unit, and the structure is a very highly planar conjugated structure. The polymer compound of the invention allows high charge mobility to be obtained when applied in an organic transistor, compared to the aforementioned conventional polymer compound comprising a fluorene-containing structure.

The repeating unit represented by formula (1) in the polymer compound of the invention is preferably a repeating unit selected from the group consisting of repeating units represented by the following formulas (2a) and (2b). These repeating units will tend to result in more excellent charge mobility. 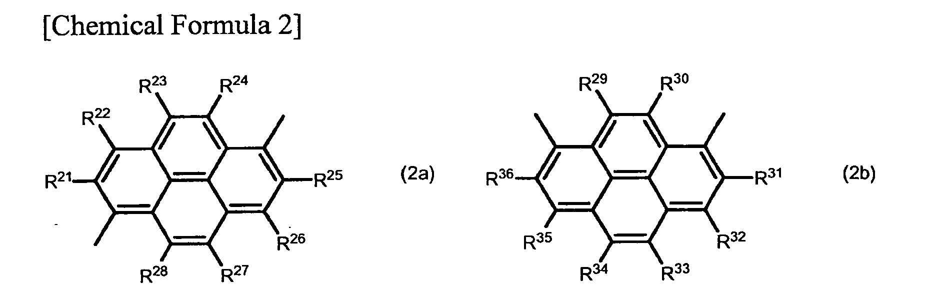 [In the formulas, R²¹ to R³⁶ each independently represent a hydrogen atom, an alkyl group, alkoxy group, alkylthio group, aryl group, aryloxy group, arylthio group, arylalkyl group, arylalkoxy group, arylalkylthio group, substituted silyl group, substituted carboxyl group, monovalent heterocyclic group, cyano group or a fluorine atom. This is with the provision that at least two of R²¹ to R²⁸ are groups other than hydrogen atom, and at least two of R²⁹ to R³⁶ are groups other than hydrogen atom.]

The polymer compound of the invention is more preferably one further comprising a repeating unit represented by the following formula (3). The presence of these additional repeating units will allow further increased charge mobility to be obtained. 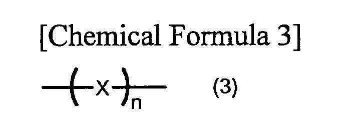 [In the formula, X represents an arylene group, a divalent heterocyclic group, divalent group with a metal complex structure, divalent aromatic amine, group represented by -CR⁴⁵=CR⁴⁶- (where R⁴⁵ and R⁴⁶ each independently represent hydrogen atom, an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, fluorine atom, monovalent heterocyclic group or cyano group), or a group represented by -C≡C-, and any of these may be optionally substituted. n represents an integer of 1 to 5. When several X groups are present, the X groups may be the same or different.]

More specifically, the effect of the invention can be obtained to a greater extent with the polymer compound of the invention if R²² and R²⁶ of formula (2a) are similar groups other than hydrogen atom, and/or R³² and R³⁵ in formula (2b) are similar groups other than hydrogen atom.

More preferably, R²¹, R²³, R²⁴, R²⁵, R²⁷ and R²⁸ in formula (2a) are hydrogen and/or R²⁹, R³⁰, R³¹, R³³, R³⁴ and R³⁶ in formula (2b) are hydrogen.

The repeating unit represented by formula (3) is preferably one wherein X is a divalent heterocyclic group. More preferably n in formula (3) is 2. If a repeating unit represented by formula (3) satisfying these conditions is present, it will tend to be easier to obtain particularly excellent charge mobility.

More specifically, the especially preferred repeating units represented by formula (3) are those having a structure represented by the following formula (4). In the structure represented by the following formula (4), the two thiophene rings are rotatable around the axis of the single bond through which they are bonded. The structure represented by the following formula (4), therefore, also includes structures with a configuration in which each thiophene ring has its sulfur atoms on opposite sides of the axis. 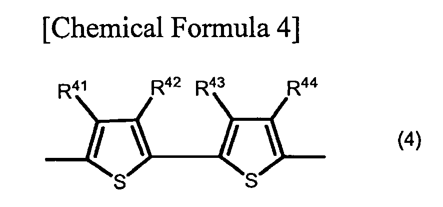 [In the formula, R⁴¹ to R⁴⁴ each independently represent a hydrogen atom, alkyl group, alkoxy group, alkylthio group, aryl group, aryloxy group, arylalkyl group, arylalkoxy group, substituted silyl group, carboxyl group, a monovalent heterocyclic group, cyano group or fluorine atom.]

The method for producing a polymer compound according to the invention is suitable for obtaining a polymer compound of the invention, and it is a method for producing a polymer compound with a repeating unit represented by the following formula (1), comprising a polymerization step in which a compound represented by the following formula (5) is polymerized. 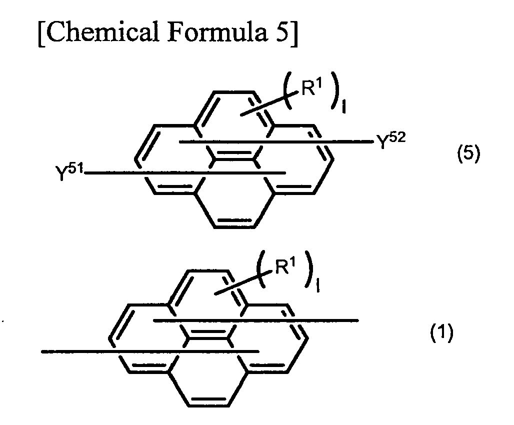 [In the formula, R¹ represents an alkyl group, alkoxy group, alkylthio group, aryl group, aryloxy group, arylthio group, arylalkyl group, arylalkoxy group, arylalkylthio group, substituted silyl group, substituted carboxyl group, a monovalent heterocyclic group, cyano group or fluorine atom, and 1 is an integer of 2 to 8. The multiple R¹ groups may be the same or different. Y⁵¹ and Y⁵² are each independently a polymerizable substituent.]

According to this production method it is possible to satisfactorily obtain a polymer compound of the invention comprising a repeating unit represented by formula (1) above.

The compound represented by formula (5) used in the method for producing a polymer compound of the invention is more preferably at least one compound selected from the group consisting of the following formulas (6a) and (6b). This will allow production of a polymer compound comprising a repeating unit represented by formula (2a) and/or (2b) above and exhibiting especially high charge mobility. 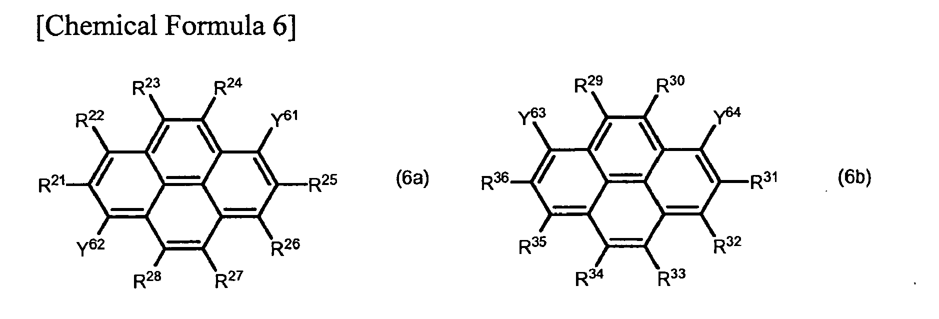 [In the formulas, R²¹ to R³⁶ each independently represent a hydrogen atom, alkyl group, alkoxy group, alkylthio group, aryl group, aryloxy group, arylthio group, arylalkyl group, arylalkoxy group, arylalkylthio group, substituted silyl group, substituted carboxyl group, a monovalent heterocyclic group, cyano group or fluorine atom. This is with the provision that at least two of R²¹ to R²⁸ are groups other than hydrogen atom, and at least two of R²⁹ to R³⁶ are groups other than hydrogen. Y⁶¹ to Y⁶⁴ are each independently a polymerizable substituent.]

Also, a compound represented by the following formula (7) is preferably further polymerized in the polymerization step of the method for producing a polymer compound of the invention. This will yield a polymer compound of the invention additionally comprising a repeating structure represented by formula (3) above.

[Chemical Formula 7] Y⁷¹(̵x)̵ₙY⁷² (7)

[In the formula, X represents an arylene group, a divalent heterocyclic group, a divalent group with a metal complex structure, or -C≡C-, and any of these may be optionally substituted. n represents an integer of 1 to 5. When several X groups are present, the X groups may be the same or different. Y⁷¹ and Y⁷² are each independently a polymerizable substituent.]

The present invention further provides a composition comprising a polymer compound of the invention, and especially an ink composition comprising a polymer compound of the invention and a solvent. The composition (ink composition) may be coated and then dried if necessary to form an organic layer containing a polymer compound of the invention, thus allowing an organic semiconductor layer for an organic transistor to be easily formed.

An ink composition of the invention with a 25°C viscosity of 1-20 mPa·s can form a satisfactorily uniform film by such coating and is even more effective for layer formation.

The invention further provides a thin-film comprising the polymer compound of the invention described above. Because such a thin-film comprises a polymer compound of the invention it is able to exhibit high charge mobility, and when applied in an organic semiconductor layer, for example, it allows formation of an organic transistor with high characteristics. Specifically, the invention can provide an organic transistor comprising a thin-film of the invention that has high mobility as a result.

The invention still further provides planar light sources and display devices comprising organic transistors according to the invention. Because such devices comprise organic transistors with high characteristics according to the invention, they can exhibit excellent properties as planar light sources and display devices.

### Effect of the Invention

According to the invention it is possible to provide a polymer compound that can exhibit high mobility when applied as an organic semiconductor layer in an organic transistor, as well as a method for producing it. Also according to the invention, it is possible to provide a composition, and especially an ink composition, that comprises the polymer compound and is advantageous for formation of the aforementioned organic semiconductor layer. Further according to the invention, it is possible to provide a thin-film comprising the polymer compound of the invention and organic transistors that comprise the thin-film and can exhibit excellent mobility. Such organic transistors are useful for driving circuits in display devices such as liquid crystal displays, electronic paper, segment type display devices, dot matrix flat panel displays and the like, and in switching circuits for curved or flat planar light sources for illumination.

The polymer compound of the invention also has excellent solubility in a variety of organic solvents, and it allows the aforementioned organic semiconductor layers, thin-films or organic transistors to be fabricated homogeneously with large areas and at low cost. For composition formation as well, it is possible to form highly homogeneous ink compositions.

### Brief Description of the Drawings

Fig. 1 is a schematic cross-sectional view of an organic thin-film transistor according to a first embodiment.
Fig. 2 is a schematic cross-sectional view of an organic thin-film transistor according to a second embodiment.
Fig. 3 is a schematic cross-sectional view of an organic thin-film transistor according to a third embodiment.
Fig. 4 is a schematic cross-sectional view of an organic thin-film transistor according to a fourth embodiment.
Fig. 5 is a schematic cross-sectional view of an organic thin-film transistor according to a fifth embodiment.
Fig. 6 is a schematic cross-sectional view of an organic thin-film transistor according to a sixth embodiment.
Fig. 7 is a schematic cross-sectional view of an organic thin-film transistor according to a seventh embodiment.
Fig. 8 is a schematic cross-sectional view of a solar cell according to a preferred embodiment.
Fig. 9 is a schematic cross-sectional view of an optical sensor according to a first embodiment.
Fig. 10 is a schematic cross-sectional view of an optical sensor according to a second embodiment.
Fig. 11 is a schematic cross-sectional view of an optical sensor according to a third embodiment.
Fig. 12 is a schematic cross-sectional view of an organic thin-film device fabricated in the examples.
Fig. 13 is a schematic cross-sectional view of an organic thin-film device fabricated in the examples.

### Explanation of Symbols

1: Panel, 2: active layer, 2a: active layer, 3: insulating layer, 4: gate electrode, 5: source electrode, 6: drain electrode, 7a: first electrode, 7b: second electrode, 8: charge generation layer, 10: gate electrode, 20: gate insulating film, 30: source electrode, 40: drain electrode, 50: active layer, 100,110,120,130,140,150,160: organic thin-film transistors, 200: solar cell, 300,310,320: optical sensors.

### Best Mode for Carrying Out the Invention

Preferred embodiments of the invention will now be explained. Throughout the following explanation, "repeating unit" means a structural unit of which one or more is present in the polymer compound. The term "n-valent heterocyclic group" (n is one or two.) means a group derived by removing n of hydrogen atoms from a heterocyclic compound (especially an aromatic heterocyclic compound). The term "heterocyclic compound" means an organic compound with a ring structure that also contains a heteroatom such as an oxygen atom, sulfur atom, nitrogen atom, phosphorus atom or boron atom in addition to the carbon atoms composing the ring.

### [Polymer compound]

Preferred embodiments of the polymer compound of the invention will now be explained.

The polymer compound of the invention comprises a repeating unit represented by formula (1) above. In formula (1), the two bonds without substituents represent bonds with other repeating units.

An alkyl group for the group represented by R¹ in formula (1) may be straight-chain, branched or cyclic, with preferably about 1-24 carbon atoms (hereinafter indicated as "C₁-C₂₄"), more preferably C₆-C₂₂ and even more preferably C₈-C₁₈. As specific examples of alkyl groups include methyl, ethyl, propyl, i-propyl, butyl, i-butyl, sec-butyl, t-butyl, pentyl, isoamyl, hexyl, cyclohexyl, heptyl, octyl, 2-ethylhexyl, nonyl, decyl, 3,7-dimethyloctyl, undecyl, dodecyl, tetradecyl, hexadecyl, octadecyl, trifluoromethyl, pentafluoroethyl, perfluorobutyl, perfluorohexyl and perfluorooctyl. Among these, methyl, ethyl, propyl, i-propyl, butyl, i-butyl, t-butyl, pentyl, isoamyl, hexyl, octyl, 2-ethylhexyl, decyl, 3,7-dimethyloctyl, undecyl, dodecyl, tetradecyl, hexadecyl and octadecyl are preferred, from the viewpoint of satisfactory balance between solubility in organic solvents and heat resistance of the polymer compound.

An alkoxy group may be straight-chain, branched or cyclic, and is preferably C₁-C₂₄ and more preferably C₆-C₂₂. As specific examples of alkoxy groups include methoxy, ethoxy, propyloxy, i-propyloxy, butoxy, i-butoxy, t-butoxy, pentyloxy, hexyloxy, cyclohexyloxy, heptyloxy, octyloxy, 2-ethylhexyloxy, nonyloxy, decyloxy, 3,7-dimethyloctyloxy, undecyloxy, dodecyloxy, tetradecyloxy, hexadecyloxy, octadecyloxy, trifluoromethoxy, pentafluoroethoxy, perfluorobutoxy, perfluorohexyl, perfluorooctyl, methoxymethyloxy, 2-methoxyethyloxy and 2-ethoxyethyloxy. Among these, hexyloxy, octyloxy, 2-ethylhexyloxy, decyloxy, 3,7-dimethyloctyloxy, undecyloxy, dodecyloxy, tetradecyloxy, hexadecyloxy and octadecyloxy are preferred, from the viewpoint of satisfactory balance between solubility in organic solvents and heat resistance of the polymer compound.

An alkylthio group may be straight-chain, branched or cyclic, and is preferably about C₁-C₂₄ and more preferably C₆-C₂₂. As specific examples of alkylthio groups include methylthio, ethylthio, propylthio, i-propylthio, butylthio, i-butylthio, t-butylthio, pentylthio, hexylthio, cyclohexylthio, heptylthio, octylthio, 2-ethylhexylthio, nonylthio, decylthio, 3,7-dimethyloctylthio, undecylthio, dodecylthio, tetradecylthio, hexadecylthio, octadecylthio and trifluoromethylthio. Among these, hexylthio, octylthio, 2-ethylhexylthio, decylthio, 3,7-dimethyloctylthio, undecylthio, dodecylthio, tetradecylthio, hexadecylthio and octadecylthio are preferred, from the viewpoint of satisfactory balance between solubility in organic solvents and heat resistance of the polymer compound.

An aryl group is an atomic group derived by removing one hydrogen from an aromatic hydrocarbon, and the term includes those with fused rings, and independent benzene rings or groups having two or more fused rings bonded directly or via a vinylene group. An aryl group is preferably about C₆-C₆₀, more preferably C₆-C₄₈, even more preferably C₆-C₂₀ and most preferably C₆-C₁₀. The number of carbon atoms of the substituents are not included in these carbon numbers.

As specific examples of aryl groups include phenyl, 1-naphthyl, 2-naphthyl, 1-anthracenyl, 2-anthracenyl, 9-anthracenyl, 1-tetracenyl, 2-tetracenyl, 5-tetracenyl, 1-pyrenyl, 2-pyrenyl, 4-pyrenyl, 2-perylenyl, 3-perylenyl, 2-fluorenyl, 3-fluorenyl, 4-fluorenyl, 1-biphenylenyl, 2-biphenylenyl, 2-phenanthrenyl, 9-phenanthrenyl, 6-chrysenyl, 1-coronenyl, 2-phenylphenyl, 3-phenylphenyl, 4-phenylphenyl, 4-(anthran-9-yl)phenyl; [1,1']binaphthalen-4-yl, 10-phenylanthracen-9-yl and [9,9']bianthracene-10-yl. These may be further optionally substituted with alkyl, alkoxy, alkyloxycarbonyl, acyl, N,N-dialkylamino, N,N-diarylamino, cyano or nitro groups, or chlorine or fluorine atoms.

An aryloxy group is preferably about C₆-C₆₀ and more preferably C₇-C₄₈. As specific examples of aryloxy groups include phenoxy, C₁-C₁₈ alkoxyphenoxy (C1-18 for the alkoxy portion, same hereunder), C₁-C₁₈ alkylphenoxy (C1-18 for the alkyl portion, same hereunder), 1-naphthyloxy, 2-naphthyloxy and pentafluorophenyloxy. A C₁-C₁₈ alkoxyphenoxy or C₁-C₁₈ alkylphenoxy group is preferred from the viewpoint of satisfactory balance between solubility in organic solvents and heat resistance of the polymer compound.

Specific examples of C₁-C₁₈ alkoxyphenoxy groups include methoxyphenoxy, ethoxyphenoxy, propyloxyphenoxy, i-propyloxyphenoxy, butoxyphenoxy, i-butoxyphenoxy, t-butoxyphenoxy, pentyloxyphenoxy, hexyloxyphenoxy, cyclohexyloxyphenoxy, heptyloxyphenoxy, octyloxyphenoxy, 2-ethylhexyloxyphenoxy, nonyloxyphenoxy, decyloxyphenoxy, 3,7-dimethyloctyloxyphenoxy, undecyloxyphenoxy, dodecyloxyphenoxy, tetradecyloxyphenoxy, hexadecyloxyphenoxy and octadecyloxyphenoxy. Specific examples of C₁-C₁₈ alkylphenoxy groups include methylphenoxy, ethylphenoxy, dimethylphenoxy, propylphenoxy, 1,3,5-trimethylphenoxy, methylethylphenoxy, i-propylphenoxy, butylphenoxy, i-butylphenoxy, t-butylphenoxy, pentylphenoxy, isoamylphenoxy, hexylphenoxy, heptylphenoxy, octylphenoxy, nonylphenoxy, decylphenoxy, undecylphenoxy, dodecylphenoxy, tetradecylphenoxy, hexadecylphenoxy and octadecylphenoxy.

An arylthio group is preferably about C₃-C₆₀. As specific examples of arylthio groups include phenylthio, C₁-C₁₈ alkoxyphenylthio, C₁-C₁₈ alkylphenylthio, 1-naphthylthio, 2-naphthylthio and pentafluorophenylthio. Among these, C₁-C₁₈ alkoxyphenylthio and C₁-C₁₈ alkylphenylthio groups are preferred, from the viewpoint of satisfactory balance between solubility in organic solvents and heat resistance of the polymer compound.

An arylalkyl group is preferably about C₇-C₆₀ and more preferably C₇-C₄₈. As specific examples of arylalkyl groups include phenyl-C₁-C₁₈ alkyl, C₁-C₁₈ alkoxyphenyl-C₁-C₁₈ alkyl, C₁-C₁₈ alkylphenyl-C₁-C₁₈ alkyl, 1-naphthyl-C₁-C₁₈ alkyl and 2-naphthyl-C₁-C₁₈ alkyl. C₁-C₁₈ alkoxyphenyl-C₁-C₁₈ alkyl and C₁-C₁₈ alkylphenyl-C₁-C₁₈ alkyl groups are preferred from the viewpoint of satisfactory balance between solubility in organic solvents and heat resistance of the polymer compound.

An arylalkoxy group is preferably about C₇-C₆₀ and more preferably C₇-C₄₈. As specific examples of arylalkoxy groups include phenyl-C₁-C₁₈ alkoxy groups such as phenylmethoxy, phenylethoxy, phenylbutoxy, phenylpentyloxy, phenylhexyloxy, phenylheptyloxy and phenyloctyloxy, and C₁-C₁₈ alkoxyphenyl-C₁-C₁₈ alkoxy, C₁-C₁₈ alkylphenyl-C₁-C₁₈ alkoxy, 1-naphthyl-C₁-C₁₈ alkoxy or 2-naphthyl-C₁-C₁₈ alkoxy. C₁-C₁₈ alkoxyphenyl-C₁-C₁₈ alkoxy and C₁-C₁₈ alkylphenyl-C₁-C₁₈ alkoxy groups are preferred from the viewpoint of satisfactory balance between solubility in organic solvents and heat resistance of the polymer compound.

An arylalkylthio group is preferably about C₇-C₆₀ and more preferably C₇-C₄₈. As specific examples of arylalkylthio groups include phenyl-C₁-C₁₈ alkylthio, C₁-C₁₈ alkoxyphenyl-C₁-C₁₈ alkylthio, C₁-C₁₈ alkylphenyl-C₁-C₁₈ alkylthio, 1-naphthyl-C₁-C₁₈ alkylthio and 2-naphthyl-C₁-C₁₈ alkylthio. C₁-C₁₈ alkoxyphenyl-C₁-C₁₈ alkylthio and C₁-C₁₈ alkylphenyl-C₁-C₁₈ alkylthio groups are preferred from the viewpoint of satisfactory balance between solubility in organic solvents and heat resistance of the polymer compound.

As substituted silyl groups there may be mentioned silyl groups substituted with 1, 2 or 3 groups selected from among alkyl, aryl, arylalkyl and monovalent heterocyclic groups. A substituted silyl group is preferably about C₁₋C₆₀ and more preferably C₃₋C₄₈. The alkyl, aryl, arylalkyl or monovalent heterocyclic group substituents on the silyl group may optionally be further substituted. Examples of substituted silyl groups include trimethylsilyl, triethylsilyl, tripropylsilyl, tri-i-propylsilyl, dimethyl-i-propylsilyl, diethyl-i-propylsilyl, t-butylsilyldimethylsilyl, pentyldimethylsilyl, hexyldimethylsilyl, heptyldimethylsilyl, octyldimethylsilyl, 2-ethylhexyl-dimethylsilyl, nonyldimethylsilyl, decyldimethylsilyl, 3,7-dimethyloctyldimethylsilyl, undecyldimethylsilyl, dodecyldimethylsilyl, tetradecyldimethylsilyl, hexadecyldimethylsilyl, octadecyldimethylsilyl, phenyl-C₁-C₁₈ alkylsilyl, C₁-C₁₈ alkoxyphenyl-C₁-C₁₈ alkylsilyl, C₁-C₁₈ alkylphenyl-C₁-C₁₈ alkylsilyl, 1-naphthyl-C₁-C₁₈ alkylsilyl, 2-naphthyl-C₁-C₁₈ alkylsilyl, phenyl-C₁-C₁₈ alkyldimethylsilyl, triphenylsilyl, tri-p-xylylsilyl, tribenzylsilyl, diphenylmethylsilyl, t-butyldiphenylsilyl and dimethylphenylsilyl.

As substituted carboxyl groups there may be mentioned carboxyl groups substituted with alkyl, aryl, arylalkyl or monovalent heterocyclic groups. A substituted carboxyl group is preferably about C₂₋C₆₀ and more preferably C₂₋C₄₈. As specific examples of substituted carboxyl groups include methoxycarbonyl, ethoxycarbonyl, propoxycarbonyl, i-propoxycarbonyl, butoxycarbonyl, i-butoxycarbonyl, t-butoxycarbonyl, pentyloxycarbonyl, hexyloxycarbonyl, cyclohexyloxycarbonyl, heptyloxycarbonyl, octyloxycarbonyl, 2-ethylhexyloxycarbonyl, nonyloxycarbonyl, decyloxycarbonyl, 3,7-dimethyloctyloxycarbonyl, undecyloxycarbonyl, dodecyloxycarbonyl, tetradecyloxycarbonyl, hexadecyloxycarbonyl, octadecyloxycarbonyl, trifluoromethoxycarbonyl, pentafluoroethoxycarbonyl, perfluorobutoxycarbonyl, perfluorohexyloxycarbonyl, perfluorooctyloxycarbonyl, phenoxycarbonyl, naphthoxycarbonyl and pyridyloxycarbonyl. The alkyl, aryl, arylalkyl or monovalent heterocyclic group substituents may optionally be further substituted, and the number of carbons of the substituents are not included in the preferred number of carbons for the substituted carboxyl groups.

A monovalent heterocyclic group is preferably about C₄₋C₆₀ and more preferably C₄₋C₂₀. The carbons of the substituents are not included in the number of carbon atoms of the monovalent heterocyclic group. Specific examples of monovalent heterocyclic groups include thienyl, pyrrolyl, furyl, pyridyl, piperidyl, quinolyl, isoquinolyl, pyrimidyl and triazinyl. Among these, thienyl, pyridyl, quinolyl, isoquinolyl, pyrimidyl and triazinyl are preferred, thienyl, pyridyl, pyrimidyl and triazinyl are more preferred. The monovalent heterocyclic group may be further substituted with alkyl, alkoxy or the like.

The repeating unit represented by formula (1) above in the polymer compound of this embodiment is preferably a repeating unit represented by formula (2a) or (2b) above. The repeating unit represented by formula (1) may include both of these. In formulas (2a) and (2b), the two bonds without substituents represent bonds with other repeating units. As preferred examples of the groups represented by R²¹-R³⁶ in formulas (2a) and (2b) there may be mentioned those for the group represented by R¹ in formula (1).

The repeating unit represented by formula (2a) may be any one represented by the following more specific chemical formulas. In the compounds represented by the following formulas, the two bonds without substituents such as Me on the ends are the bonding sites for bonding of other repeating units.

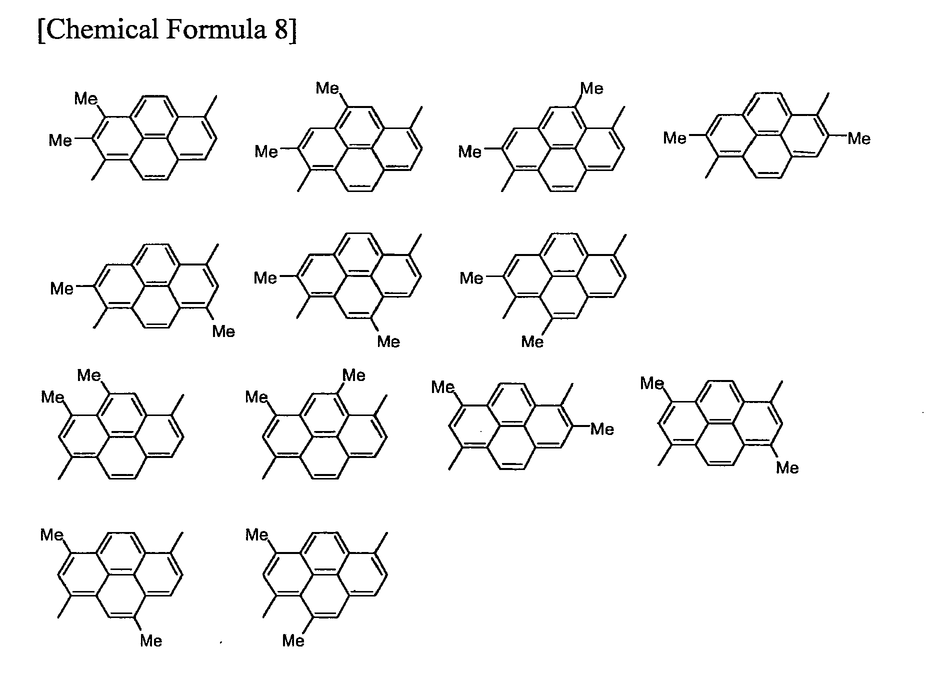

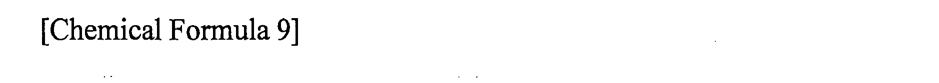

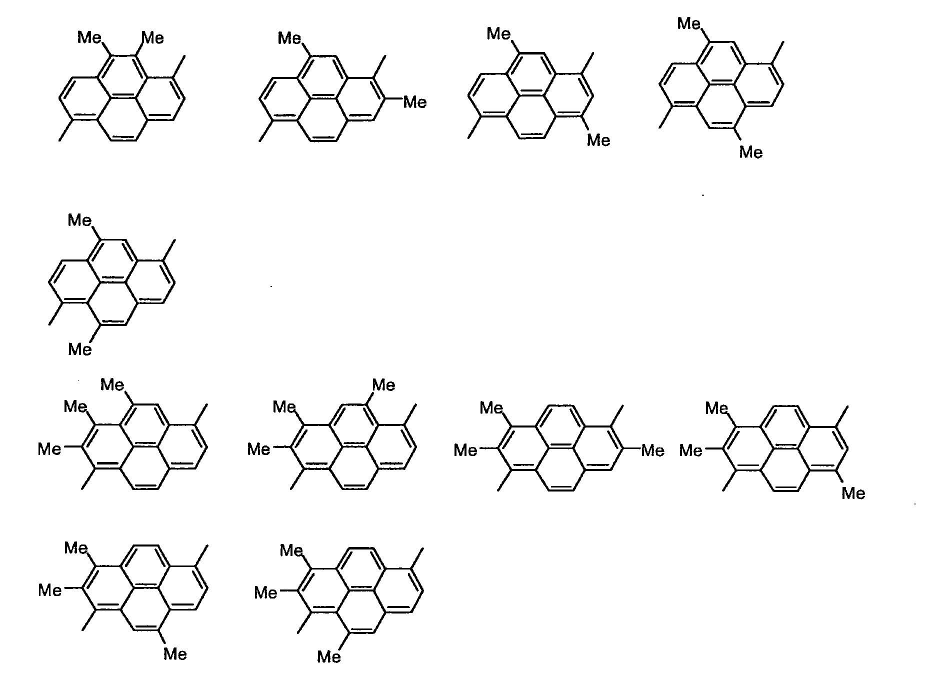

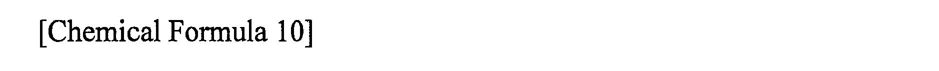

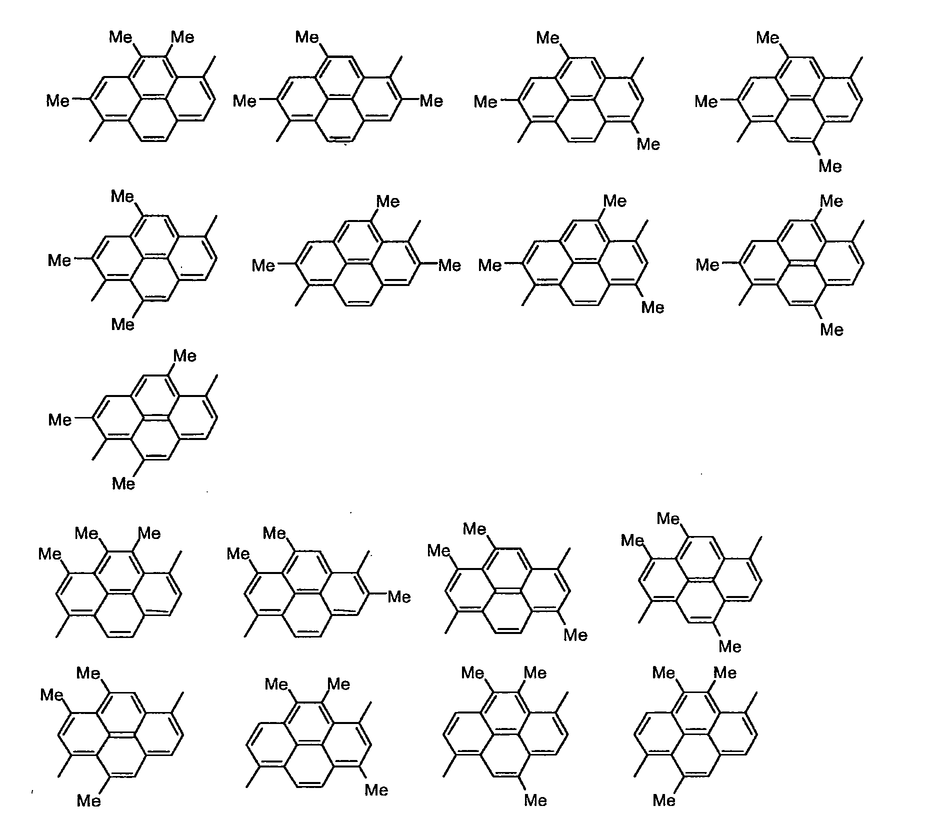

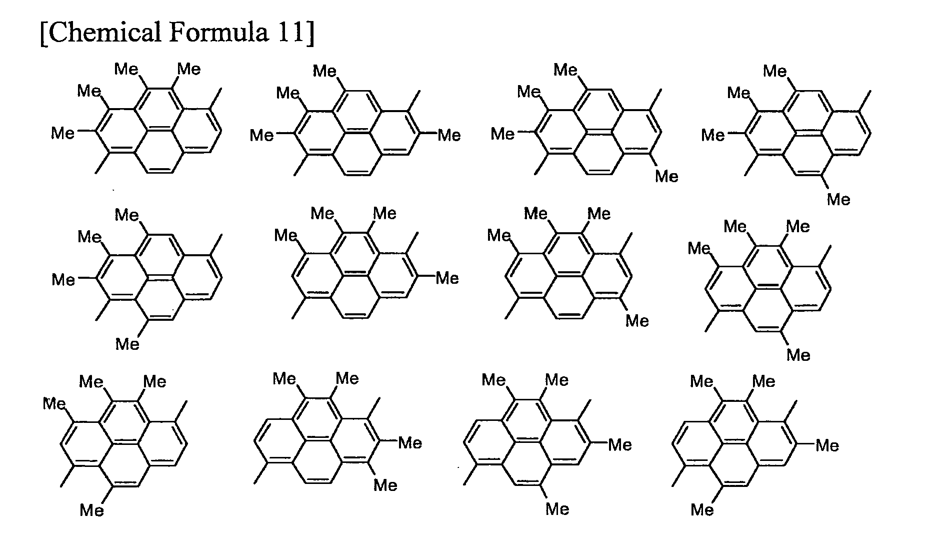

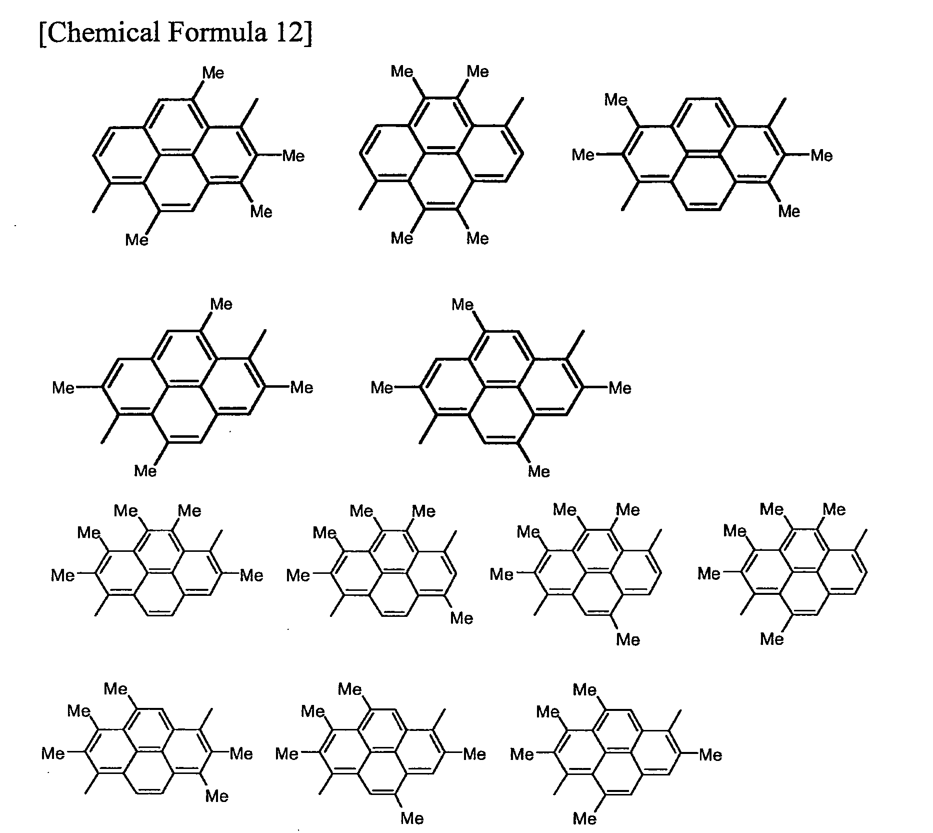

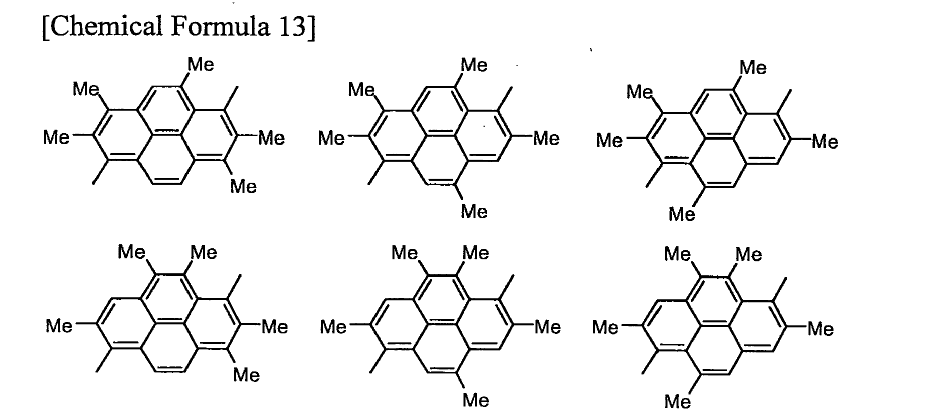

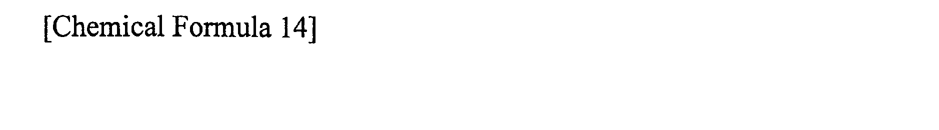

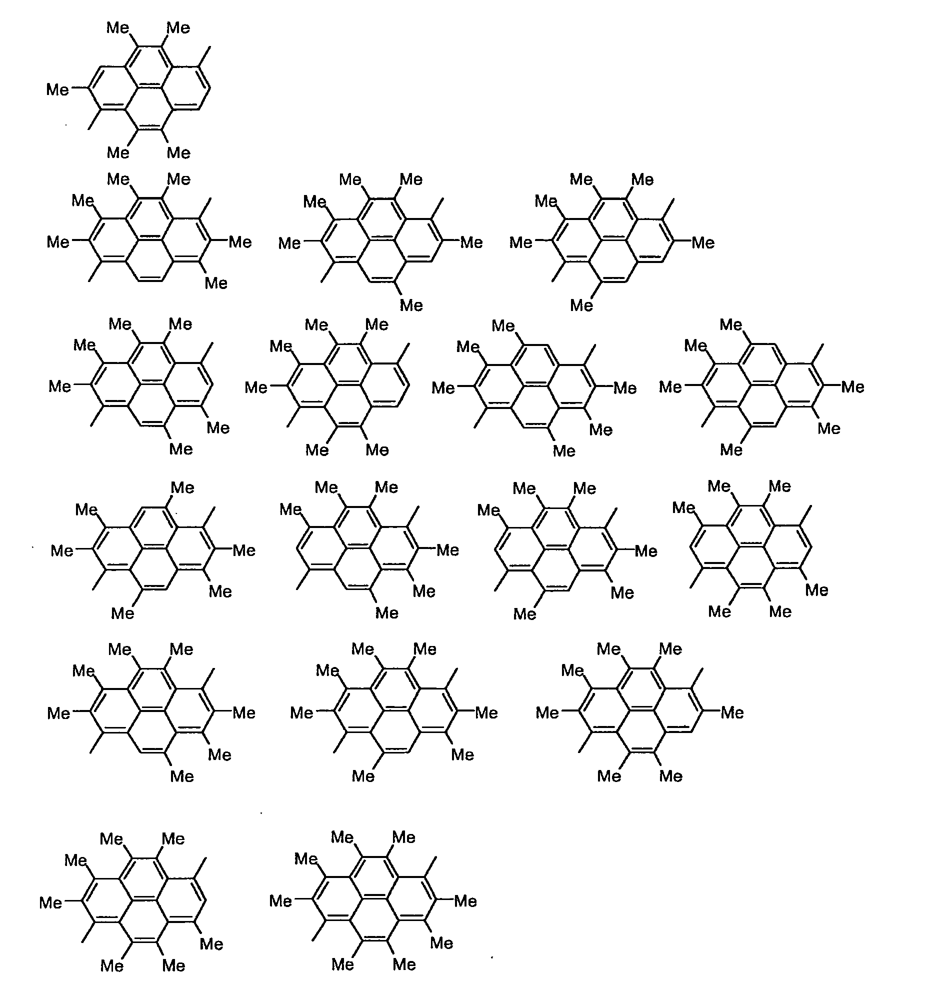

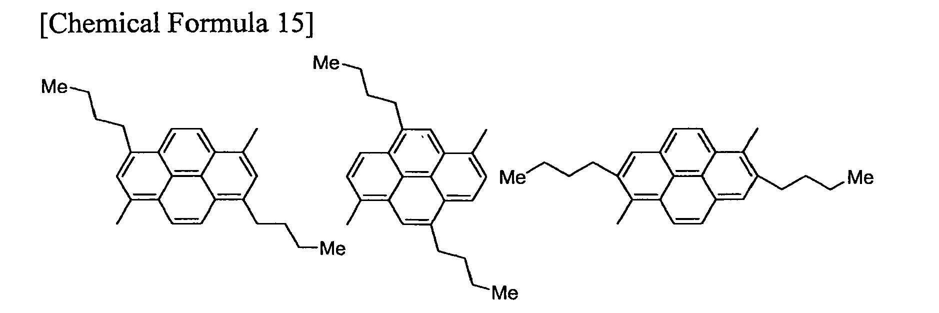

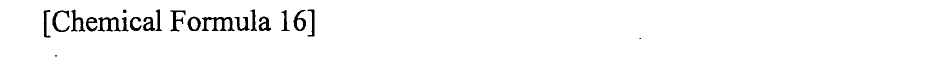

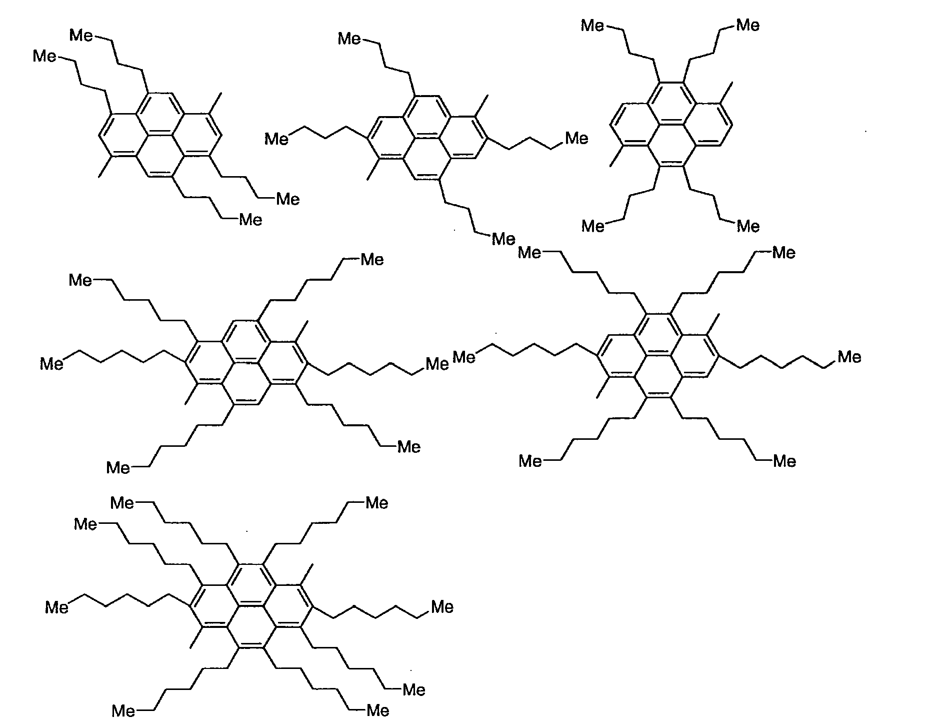

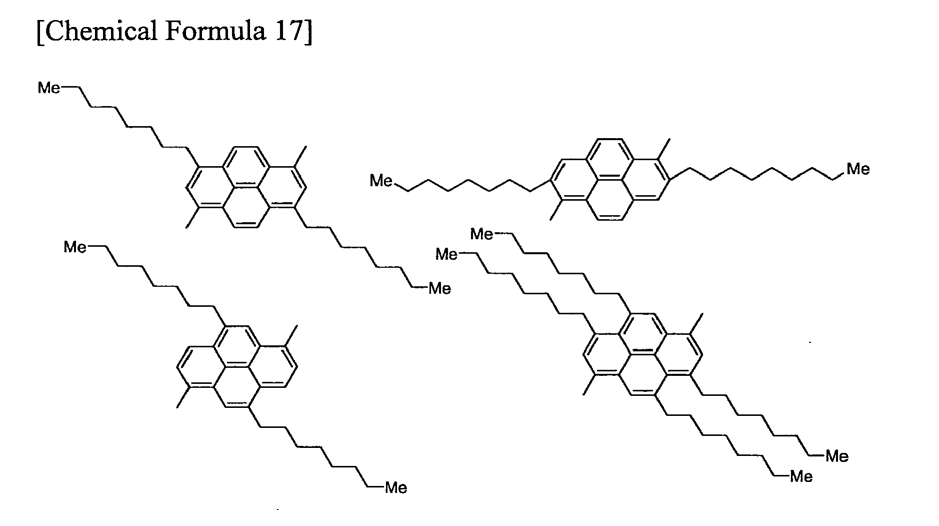

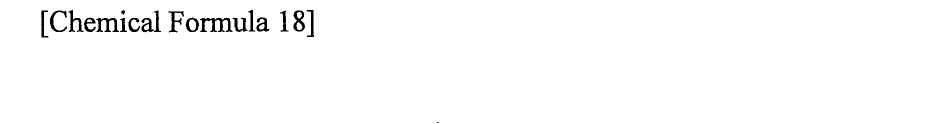

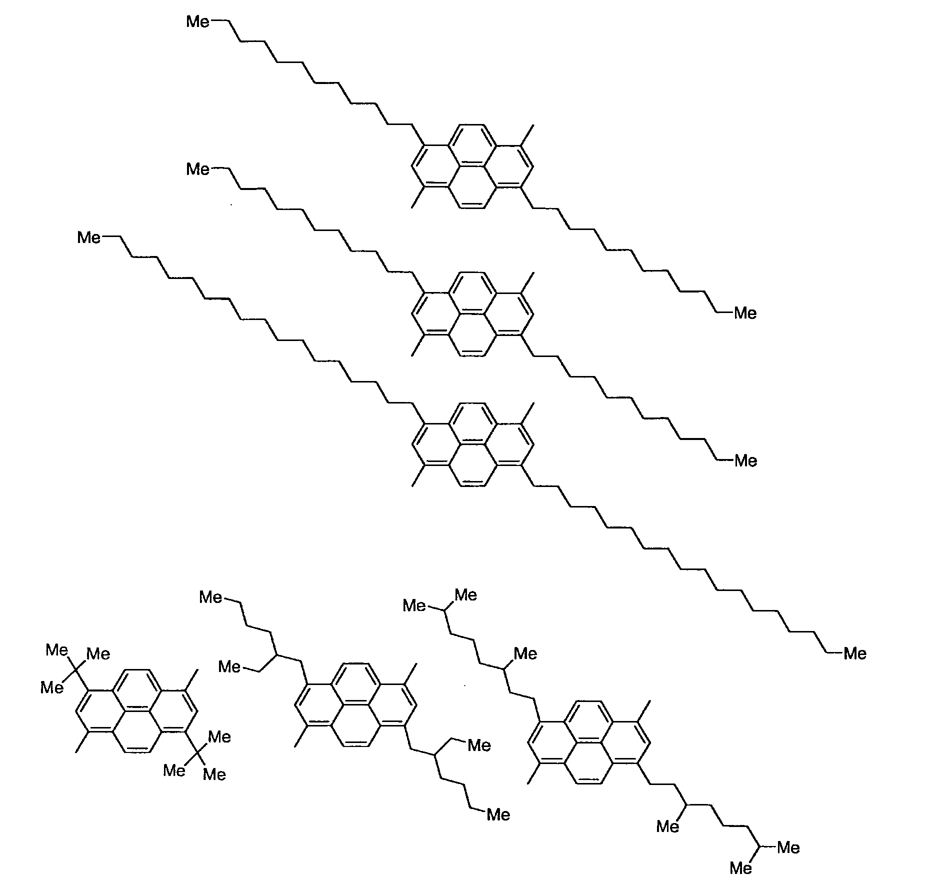

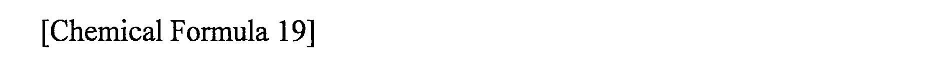

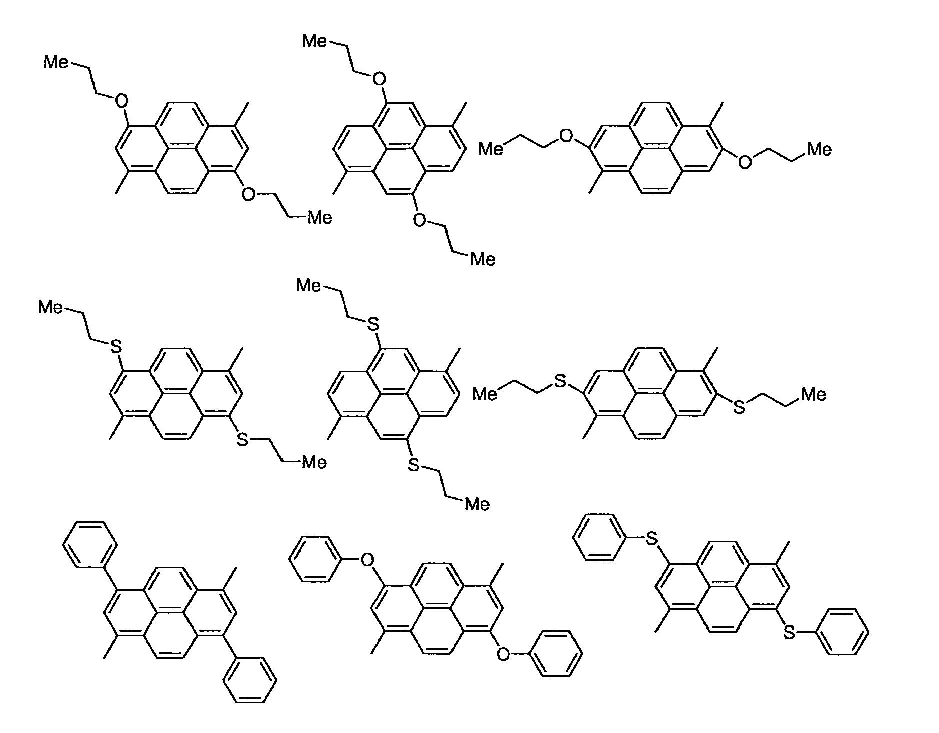

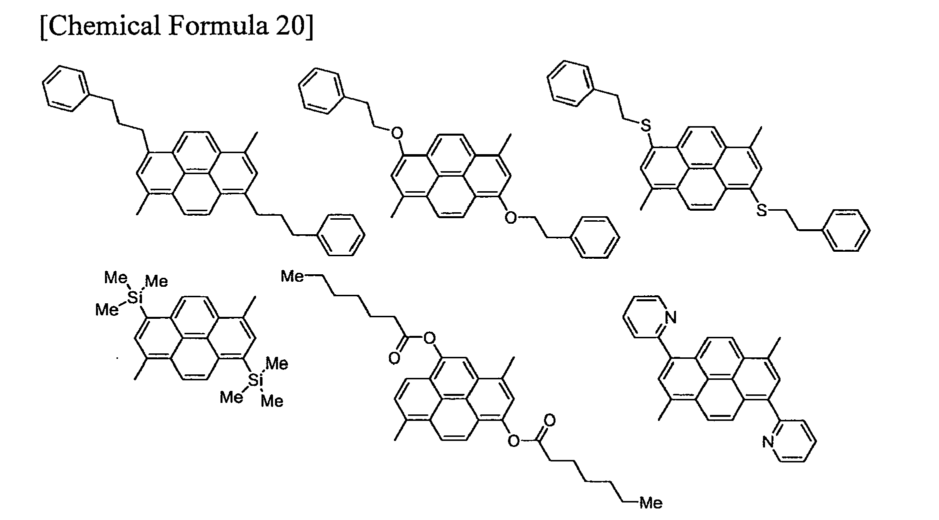

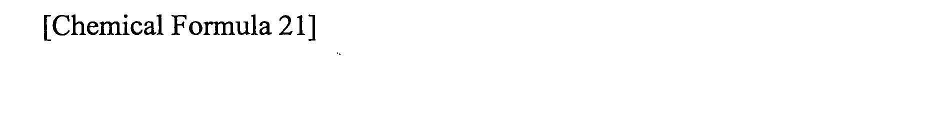

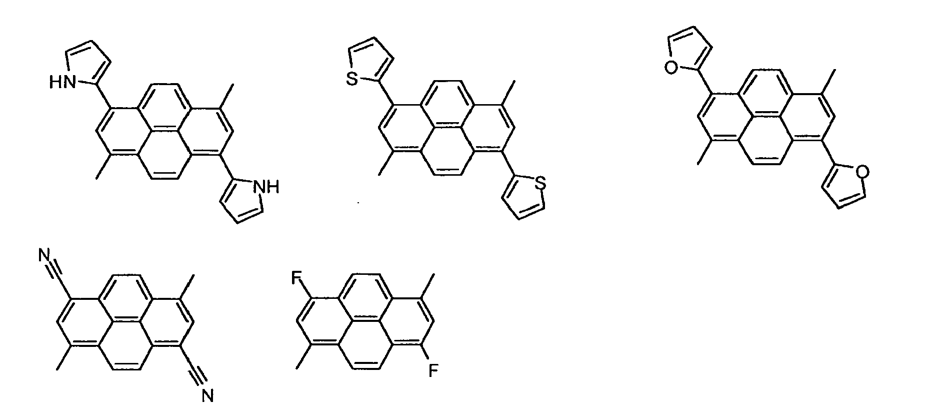

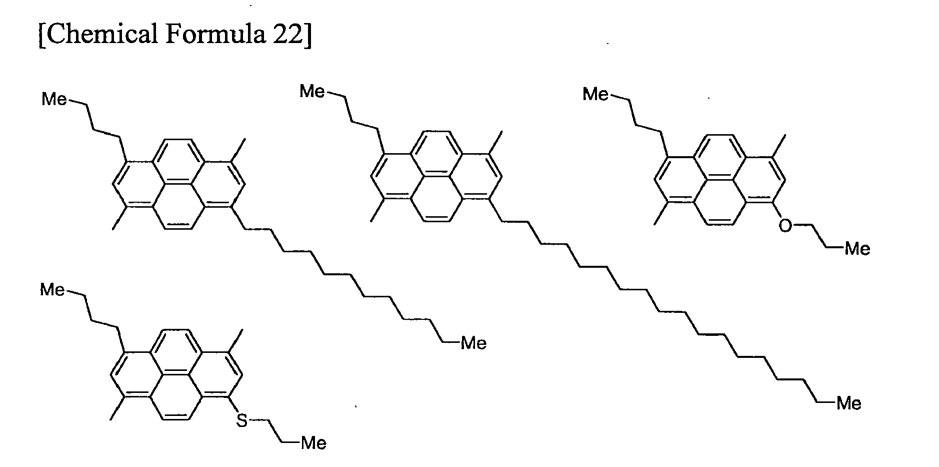

The repeating unit represented by formula (2b) may be any one represented by the following more specific chemical formulas. In the compounds represented by the following formulas, the two bonds without substituents such as Me on the ends are the bonding sites where other repeating units are bonded.

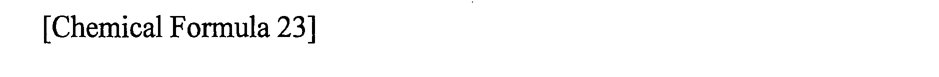

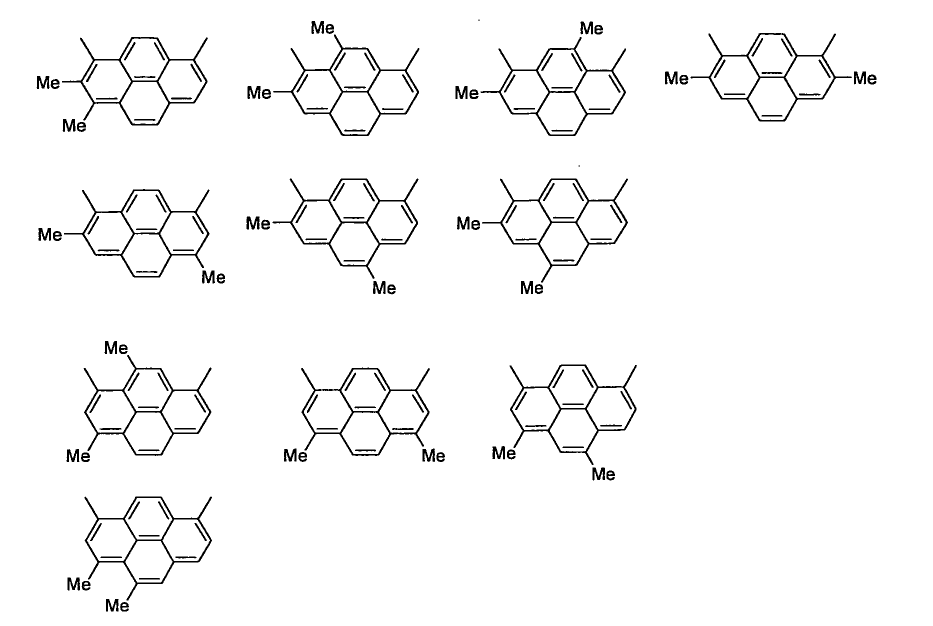

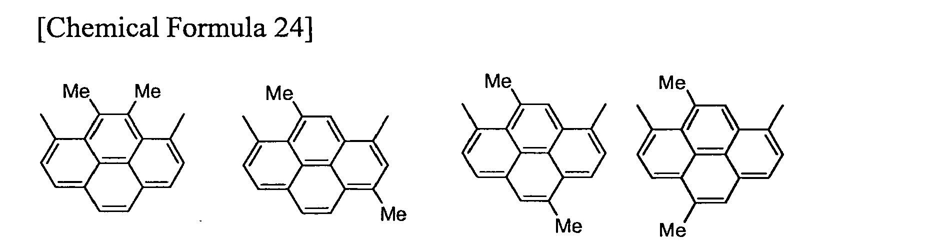

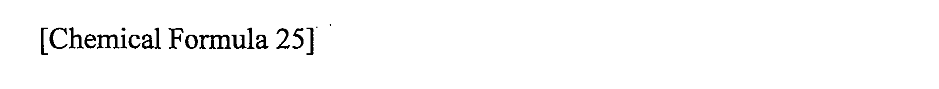

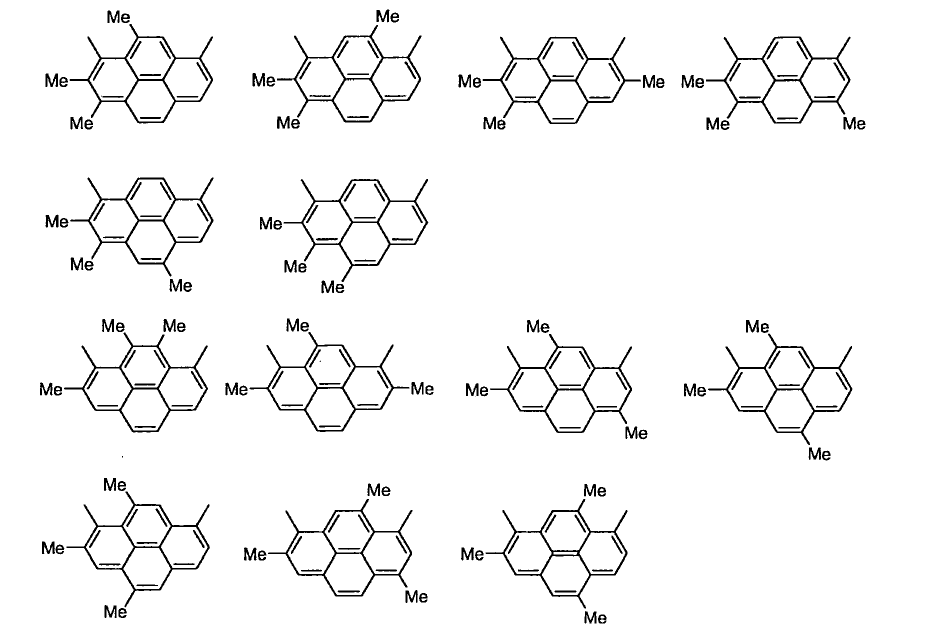

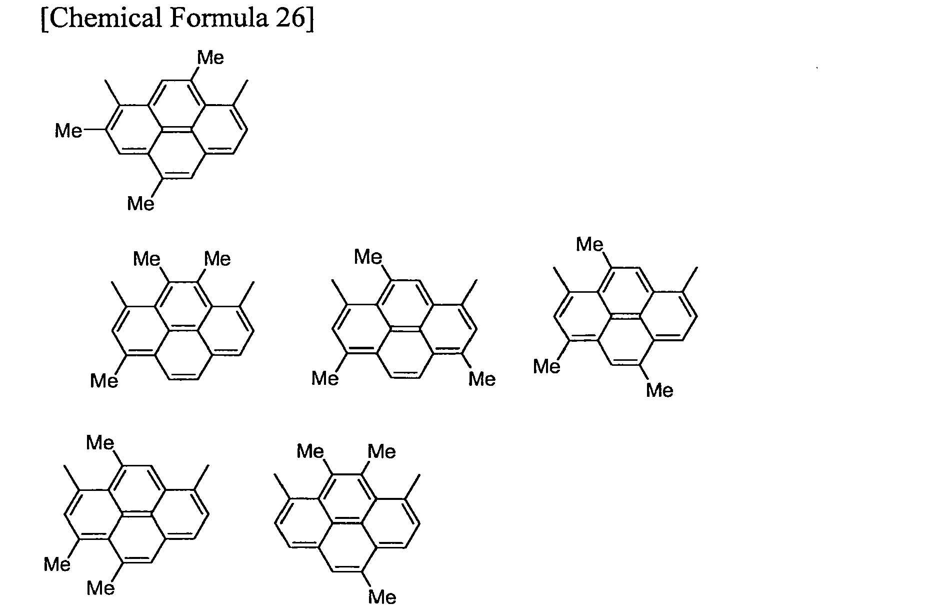

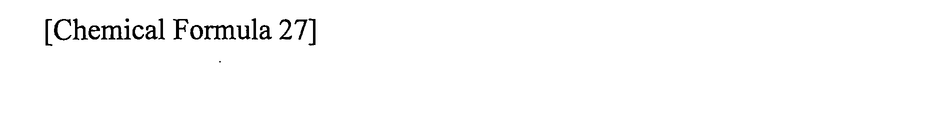

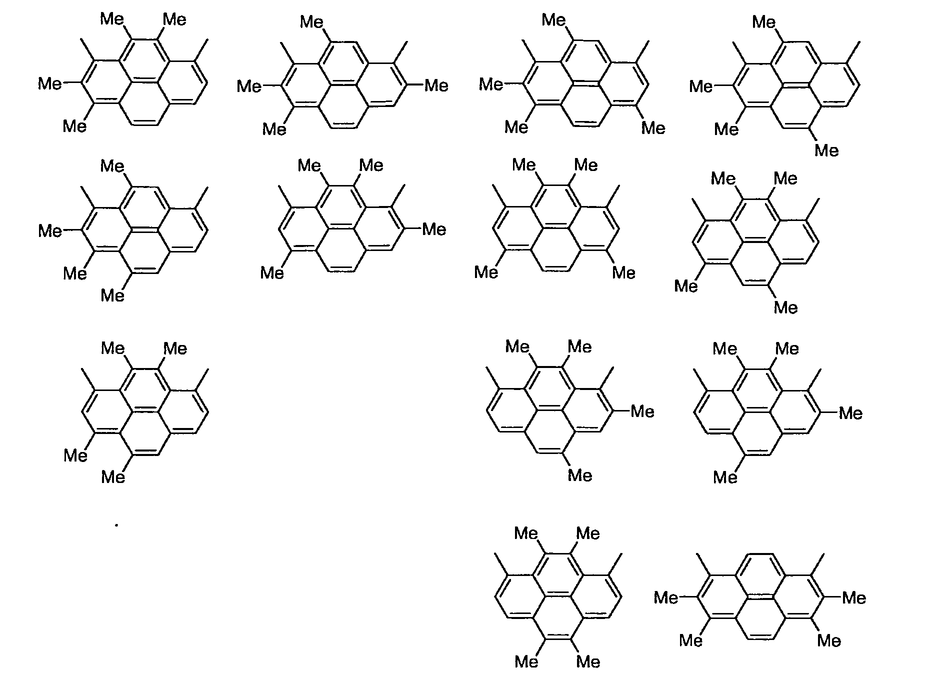

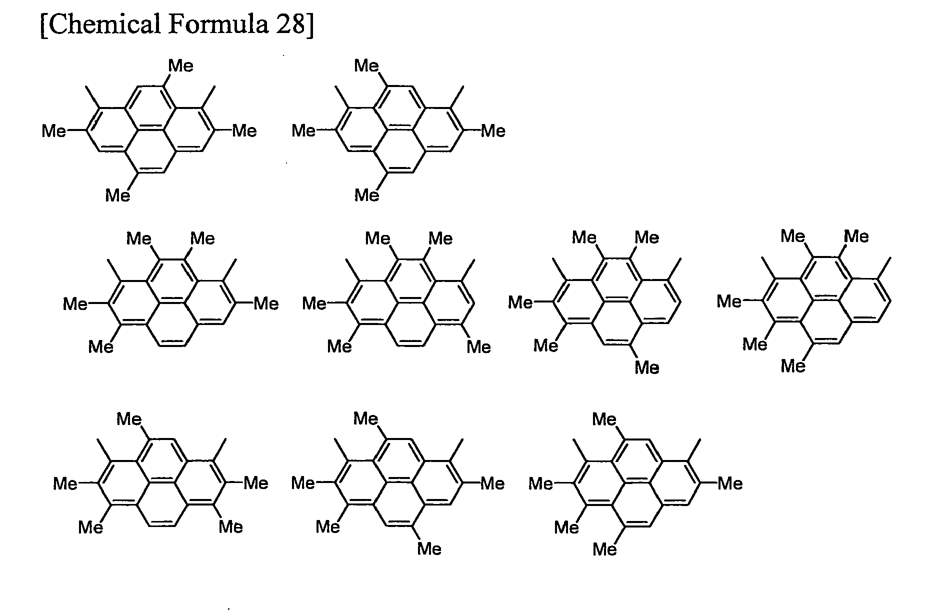

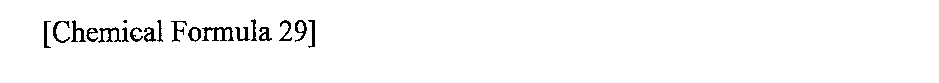

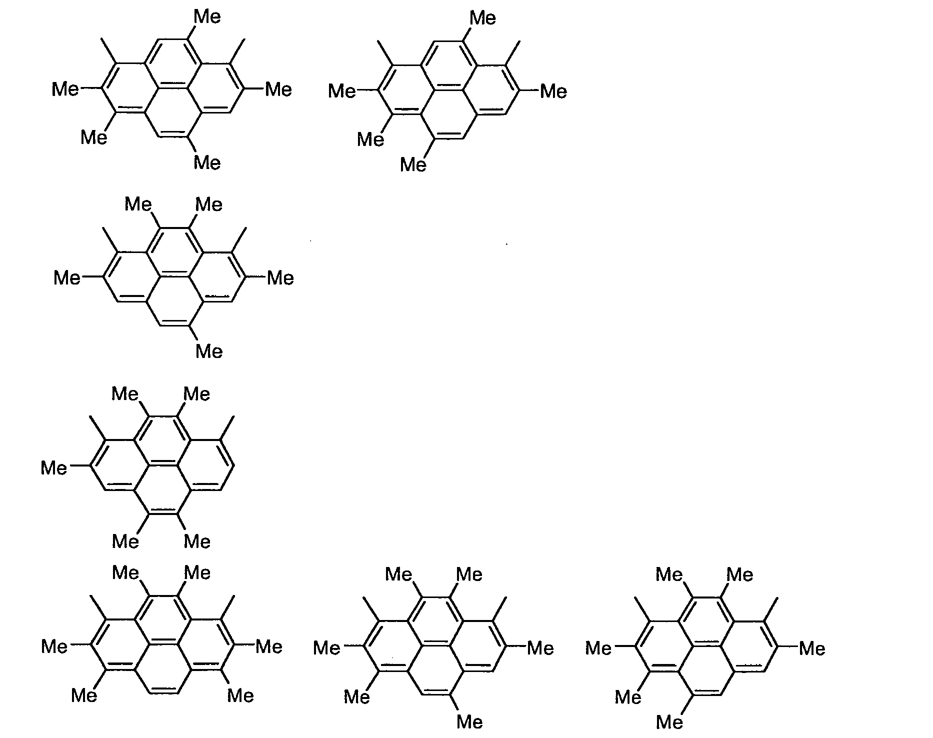

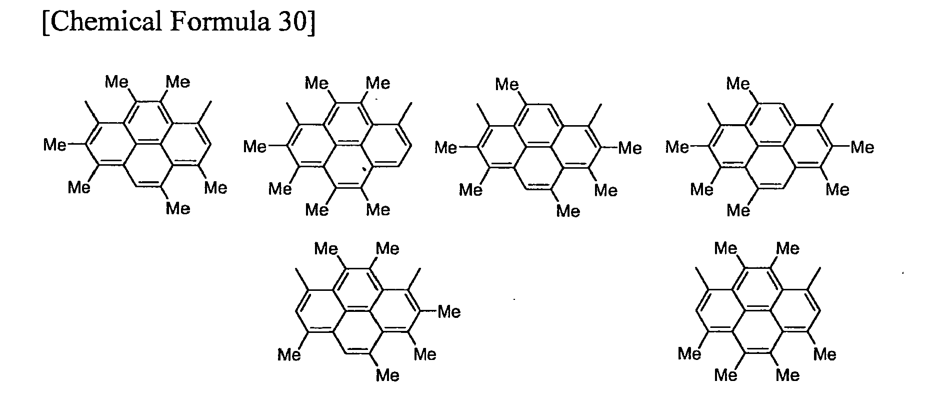

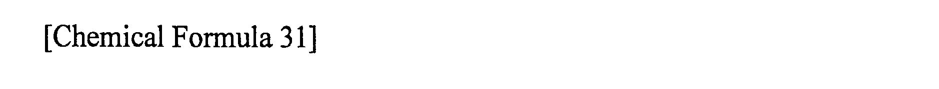

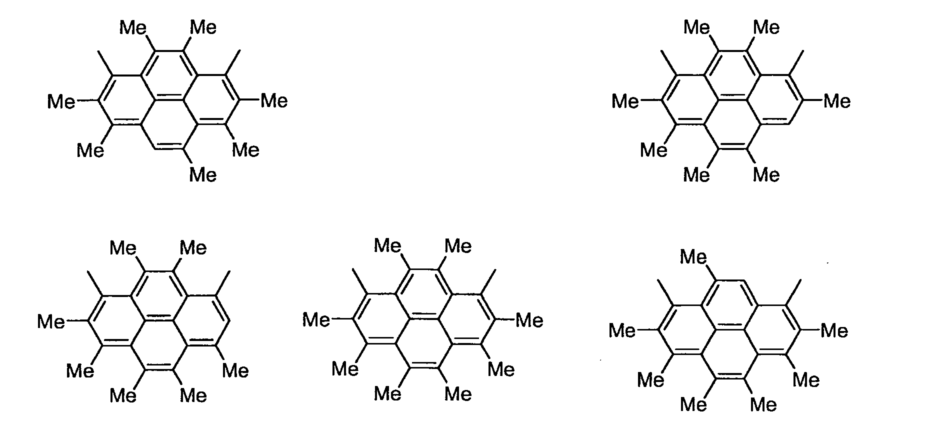

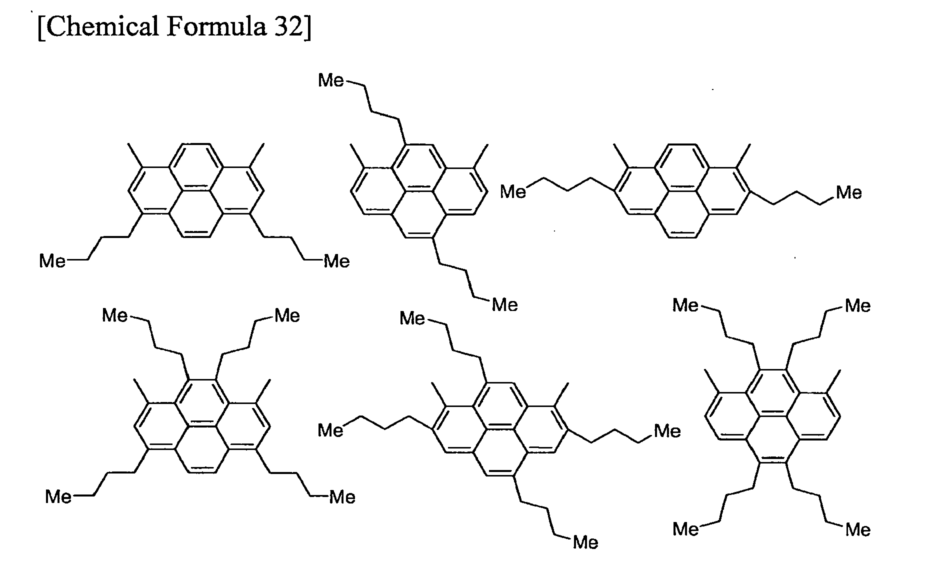

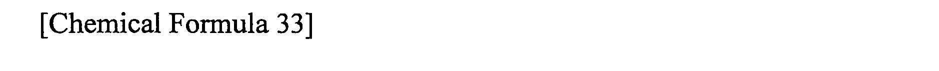

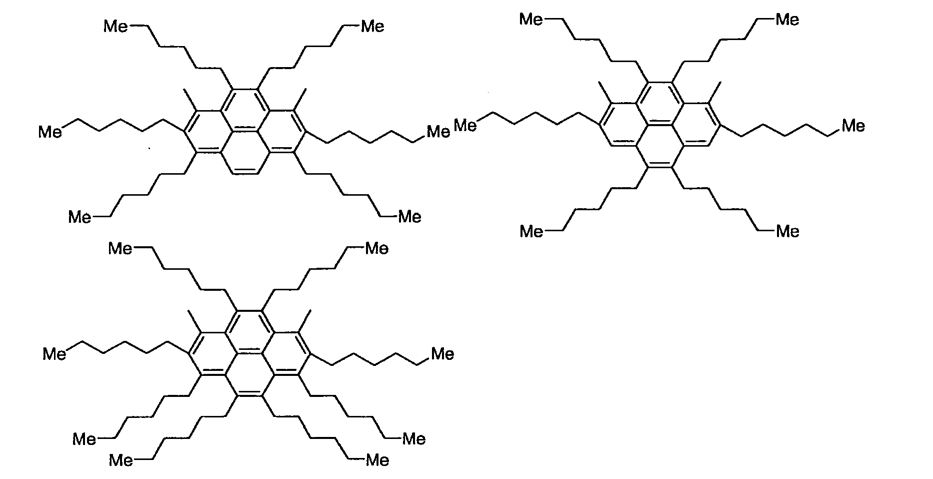

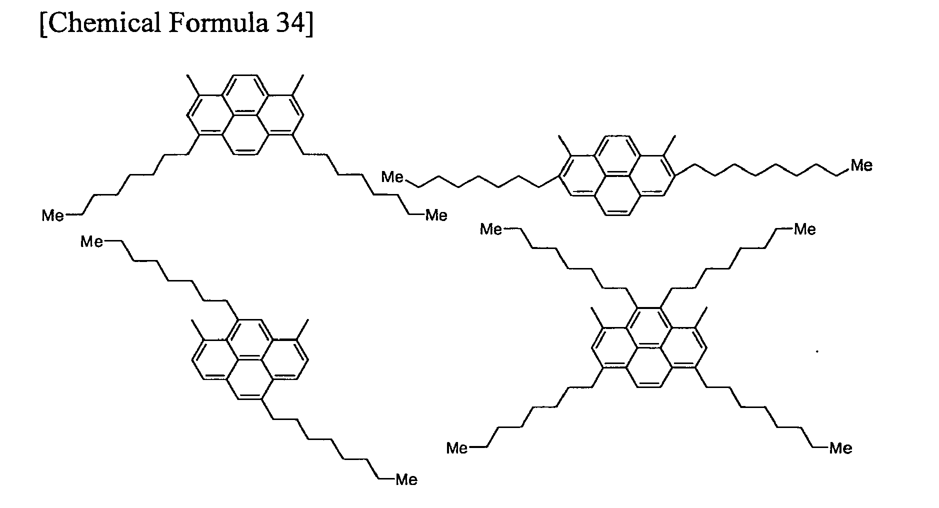

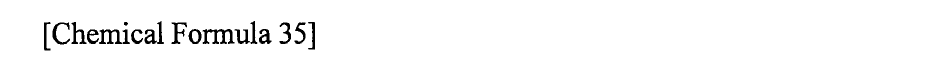

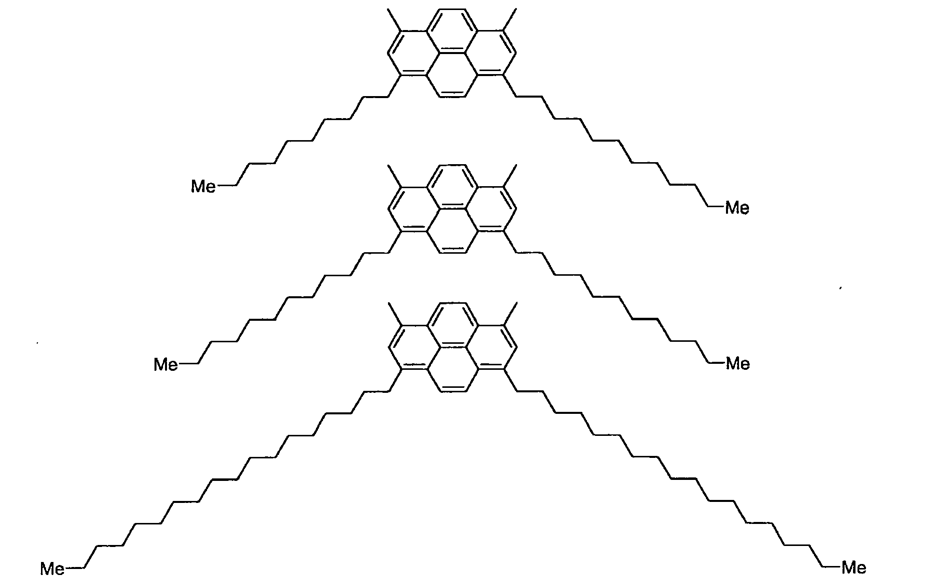

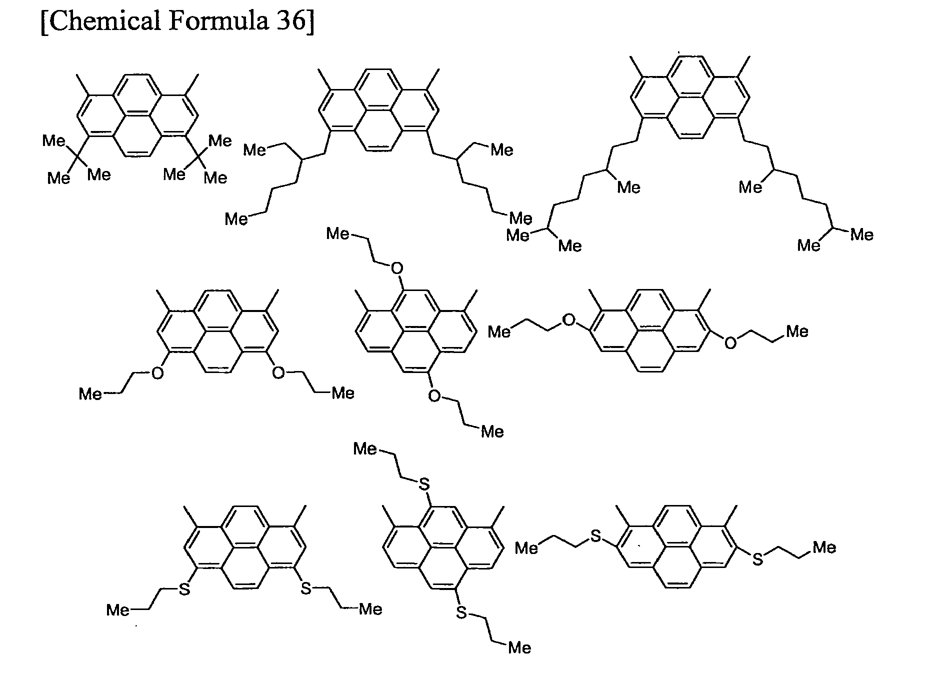

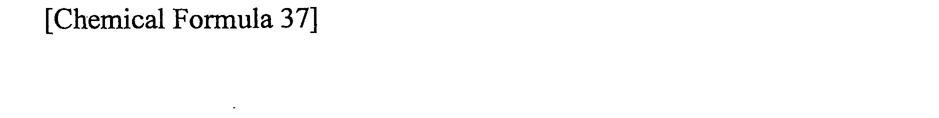

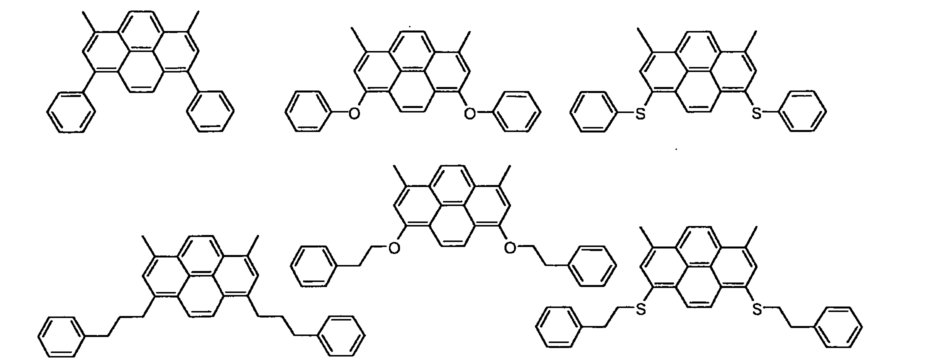

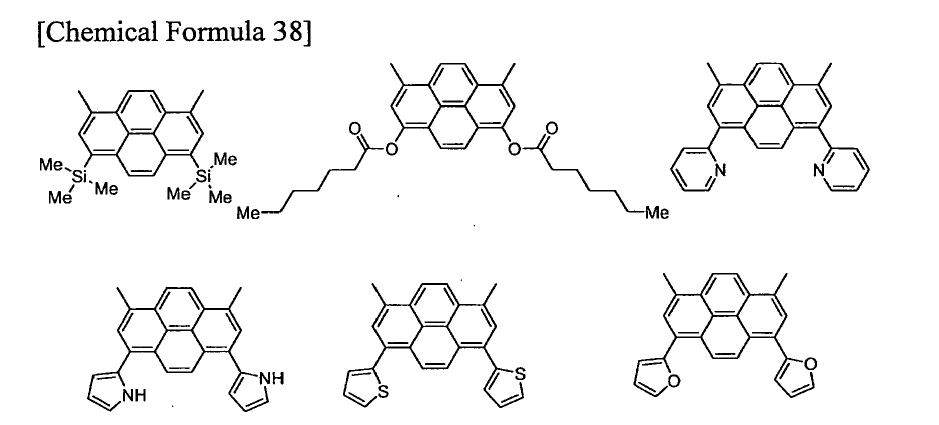

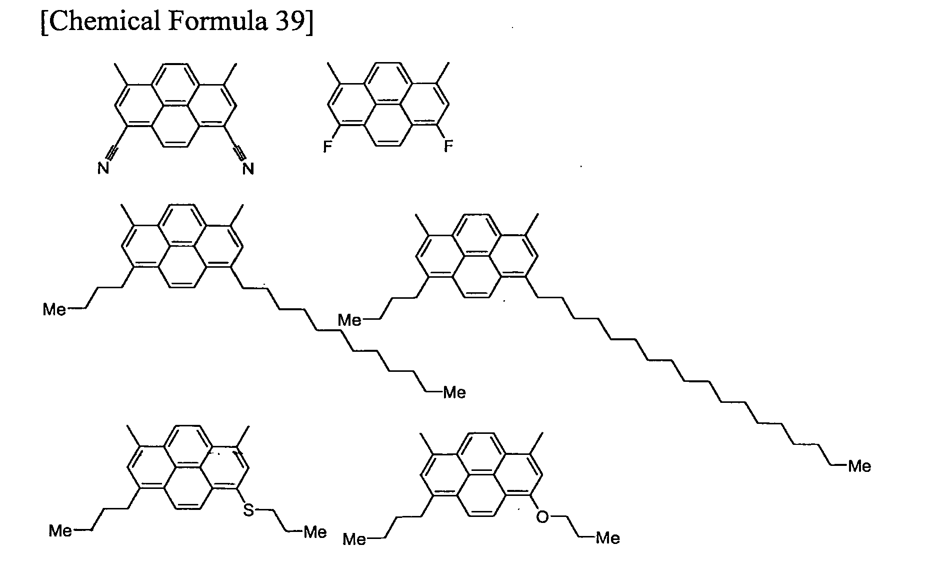

From the viewpoint of achieving more satisfactory packing of the main chain of the polymer compound for even higher mobility, the repeating units represented by formulas (2a) and (2b) above preferably have multiple substituents in line symmetry around any desired axis in the repeating unit, or point symmetry around the center of gravity.

From the same viewpoint, R²² and R²⁶ in formula (2a) are preferably similar groups other than hydrogen, and R³² and R³⁵ in formula (2b) are preferably similar groups other than hydrogen. Here, "similar group" means groups classified as the same type, such as alkyl groups or alkoxy groups. These similar groups are more preferably groups with identical structures (identical groups) with the same chain lengths, branching positions and substituents.

Also, from the viewpoint of achieving even more satisfactory packing of the main chain of the polymer compound and further improving planarity of the polymer compound for even more excellent mobility, R²¹, R²³, R²⁴, R²⁵, R²⁷ and R²⁸ in formula (2a) are preferably hydrogen and R²⁹, R³⁰, R³¹, R³³, R³⁴ and R³⁶ in formula (2b) are preferably hydrogen.

For this purpose, groups represented by the following formula (8a) are preferred for the repeating unit represented by formula (2a), and groups represented by the following formula (8b) are preferred for the repeating unit represented by formula (2b). R², R²⁶, R³² and R³⁵ in the following formulas have the same definitions as above. The two single bonds that are not attached to substituents in the following formulas are the bonding sites where other repeating units are bonded.

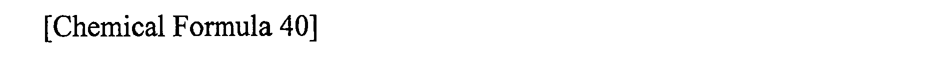

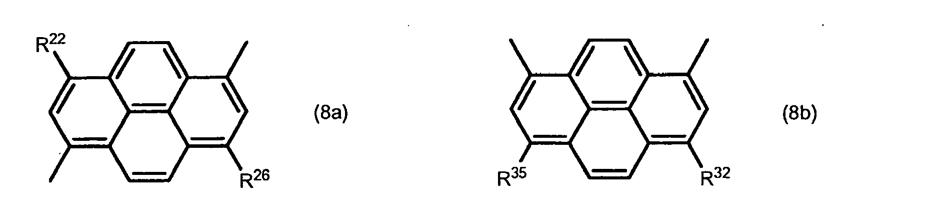

Particularly from the viewpoint of improved packing of the main chain of the polymer compound and improved planarity, as well as satisfactory solubility of the polymer compound in solvents, R²² and R²⁶ or R³² and R³⁵ in formulas (8a) and (8b) above are preferably alkyl, alkoxy or alkylthio groups having the same chain lengths and branching. Also, from the viewpoint of obtaining even higher mobility by dense stacking of planar repeating units, straight-chain alkyl, alkoxy and alkylthio groups are preferred.

From the viewpoint of obtaining even higher mobility by maintaining a fixed spacing between main chains of the polymer compound and thus obtaining a regular configuration, R²² and R²⁶ or R³² and R³⁵ are most preferably straight-chain alkyl groups of the same chain length. In addition, from the viewpoint of obtaining excellent solubility the numbers of carbon atoms of the straight-chain alkyl groups are more preferably C₈-C₁₈.

R²² and R²⁶ in formula (2a) and R³² and R³⁵ in formula (2b) may be different groups, in which case R²² and R²⁶ or R³² and R³⁵ are preferably arranged in a regular configuration to obtain satisfactory packing and planarity. Examples of such structures are the following formula (9a) for formula (2a) above and the following formula (9b) for formula (2b) above. In the formulas, R²¹-R³⁶ have the same definitions as above, and R²² and R²⁶ or R³² and R³⁵ are different from each other.

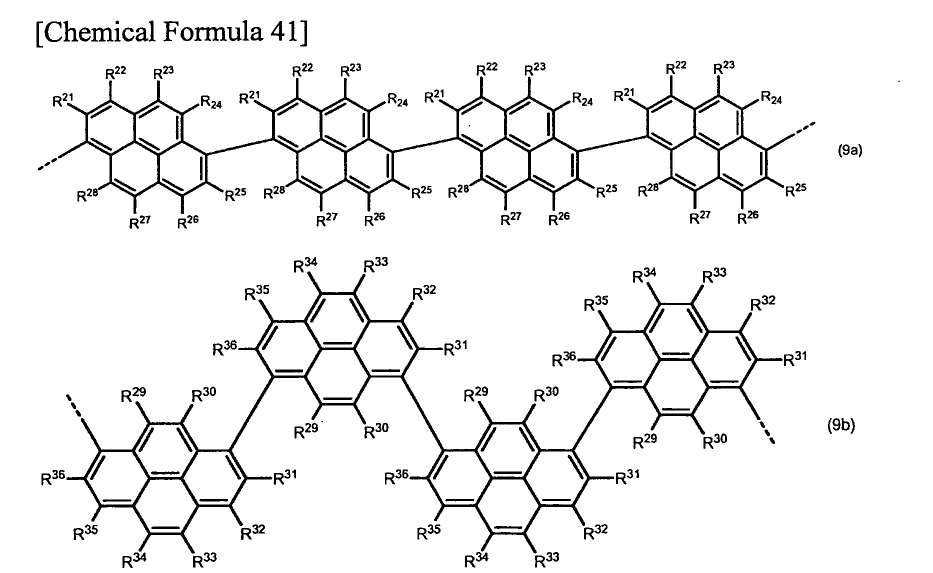

The polymer compound according to a preferred embodiment further comprises a repeating unit represented by formula (3) above in addition to the repeating unit represented by formula (1) and preferably the repeating unit represented by formula (2a) and/or (2b).

The group represented by X in the repeating unit represented by formula (3) above represents arylene, a divalent heterocyclic group, a divalent group with a metal complex structure, a divalent aromatic amine, a group represented by -CR⁴⁵=CR⁴⁶- (where R⁴⁵ and R⁴⁶ each independently represent hydrogen, alkyl, alkoxy, alkylthio, aryl, aryloxy, arylthio, arylalkyl, arylalkoxy, arylalkylthio, arylalkenyl, arylalkynyl, amino, substituted amino, silyl, substituted silyl, a fluorine atom, a monovalent heterocyclic group or a cyano group), or a group represented by -C=C-. An arylene group is a group comprising the group of atoms remaining after removing two hydrogen atoms from an aromatic hydrocarbon, and the term includes independent benzene rings and fused rings. An arylene group is preferably about C₆-C₆₀, more preferably C₆-C₄₈, even more preferably C₆-C₃₀ and most preferably C₆-C₁₈.

As specific examples of arylene groups include unsubstituted or substituted phenylene groups such as 1,4-phenylene, 1,3-phenylene and 1,2-phenylene; unsubstituted or substituted naphthalenediyl groups such as 1,4-naphthalenediyl, 1,5-naphthalenediyl and 2,6-naphthalenediyl; unsubstituted or substituted anthracenediyl groups such as 1,4-anthracenediyl, 1,5-anthracenediyl, 2,6-anthracenediyl and 9,10-anthracenediyl; unsubstituted or substituted phenanthrenediyl groups such as 2,7-phenanthrenediyl; unsubstituted or substituted naphthacenediyl groups such as 1,7-naphthacenediyl, 2,8-naphthacenediyl and 5,12-naphthacenediyl; unsubstituted or substituted fluorenediyl groups such as 2,7-fluorenediyl and 3,6-fluorenediyl; unsubstituted or monosubstituted pyrenediyl groups such as 1,6-pyrenediyl, 1,8-pyrenediyl, 2,7-pyrenediyl and 4,9-pyrenediyl; and unsubstituted or substituted perylenediyl groups such as 3,9-perylenediyl and 3,10-perylenediyl. Unsubstituted or substituted phenylene groups and unsubstituted or substituted fluorenediyl groups are preferred among these.

A divalent heterocyclic group is preferably about C₄-C₆₀, more preferably C₄-C₄₈, even more preferably C₄-C₃₀, yet more preferably C₄-C₂₂, particularly preferably C₄-C₁₂, and most preferably C₄. The number of carbon atoms of substituents are not included in these carbon numbers. As specific examples of divalent heterocyclic groups include unsubstituted or substituted thiophenediyl groups such as 2,5-thiophenediyl; unsubstituted or substituted furanediyl groups such as 2,5-furanediyl; unsubstituted or substituted selenophenediyl groups such as 2,5-selenophenediyl; unsubstituted or substituted pyrrolediyl groups such as 2,5-pyrrolediyl; unsubstituted or substituted pyridinediyl groups such as 2,5-pyridinediyl, 2,6-pyridinediyl; unsubstituted or substituted thienothiophenediyl groups such as 2,5-thieno[3,2-b]thiophenediyl, 2,5-thieno[2,3-b]thiophenediyl; unsubstituted or substituted quinolinediyl groups such as 2,6-quinolinediyl; unsubstituted or substituted isoquinolinediyl groups such as 1,4-isoquinolinediyl and 1,5-isoquinolinediyl; unsubstituted or substituted quinoxalinediyl groups such as 5,8-quinoxalinediyl; unsubstituted or substituted benzo[1,2,5]thiadiazolediyl groups such as 4,7-benzo[1,2,5]thiadiazolediyl; unsubstituted or substituted benzothiazolediyl groups such as 4,7-benzothiazolediyl; unsubstituted or substituted carbazolediyl groups such as 2,7-carbazolediyl and 3,6-carbazolediyl; unsubstituted or substituted phenoxazinediyl groups such as 3,7-phenoxazinediyl; unsubstituted or substituted phenothiazinediyl groups such as 3,7-phenothiazinediyl; unsubstituted or substituted dibenzosiloldiyl groups such as 2,7-dibenzosiloldiyl; and unsubstituted or substituted benzodithiophenediyl groups such as 2,6-benzo[1,2-b:4,5-b']dithiophenediyl, 2,6-benzo[1,2-b:5,4-b']dithiophenediyl, 2,6-benzo[2,1-b:3,4-b']dithiophenediyl and 2,6-benzo[1,2-b:3,4-b']dithiophenediyl. Among these, unsubstituted or substituted thiophenediyl groups such as 2,5-thiophenediyl; unsubstituted or substituted furanediyl groups such as 2,5-furanediyl; unsubstituted or substituted pyrrolediyl groups such as 2,5-pyrrolediyl; unsubstituted or substituted thienothiophenediyl groups such as 2,5-thieno[3,2-b]thiophenediyl and 2,5-thieno[2,3-b]thiophenediyl; unsubstituted or substituted quinolinediyl groups such as 2,6-quinolinediyl; 1,4-isoquinolinediyl groups; and unsubstituted or substituted benzodithiophenediyl groups such as 2,6-benzo[1,2-b:4,5-b']dithiophenediyl, 2,6-benzo[1,2-b:5,4-b']dithiophenediyl, 2,6-benzo[2,1-b:3,4-b']dithiophenediyl and 2,6-benzo[1,2-b:3,4-b']dithiophenediyl are preferred. Unsubstituted or substituted thiophenediyl groups such as 2,5-thiophenediyl; and unsubstituted or substituted thienothiophenediyl groups such as 2,5-thieno[3,2-b]thiophenediyl and 2,5-thieno[2,3-b]thiophenediyl are more preferred, unsubstituted 2,5-thiophenediyl and 2,5-thieno[3,2-b]thiophenediyl groups are especially preferred.

When the divalent heterocyclic group has substituents, preferred substituents are selected from among alkyl, alkoxy, alkylthio, aryl, aryloxy, arylthio, arylalkyl, arylalkoxy, arylalkylthio, substituted silyl, monovalent heterocyclic groups, substituted carboxyl, nitro, cyano and fluorine atoms. More preferred among these are alkyl, alkoxy, aryl, aryloxy and monovalent heterocyclic groups, with alkyl, alkoxy and alkylthio groups being even more preferred and alkyl groups being most preferred.

Of the groups represented by X, a divalent group having a metal complex structure is a group comprising the group of atoms remaining after removing two hydrogen atoms from the organic ligand of a metal complex having an organic ligand and a central metal. As examples of metal complexes there may be mentioned metal complexes known as low molecular fluorescent materials and phosphorescent materials and triplet emitting complexes.

The number of carbons of the organic ligand in the metal complex is preferably about C₄-C₆₀. As specific examples of such organic ligands there may be mentioned 8-quinolinol and its derivatives, benzoquinolinol and its derivatives, 2-phenyl-pyridine and its derivatives, 2-phenyl-benzothiazole and its derivatives, 2-phenyl-benzoxazole and its derivatives and porphyrin and its derivatives. As examples of central metals for the metal complex there may be mentioned aluminum, zinc, beryllium, iridium, platinum, gold, europium and terbium.

Specific examples of divalent groups with metal complex structures include those represented by the following formulas (10a)-(10d) and (11a)-(11c).

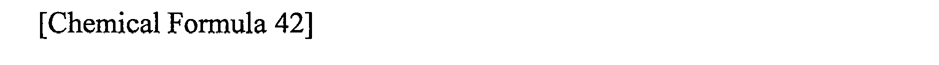

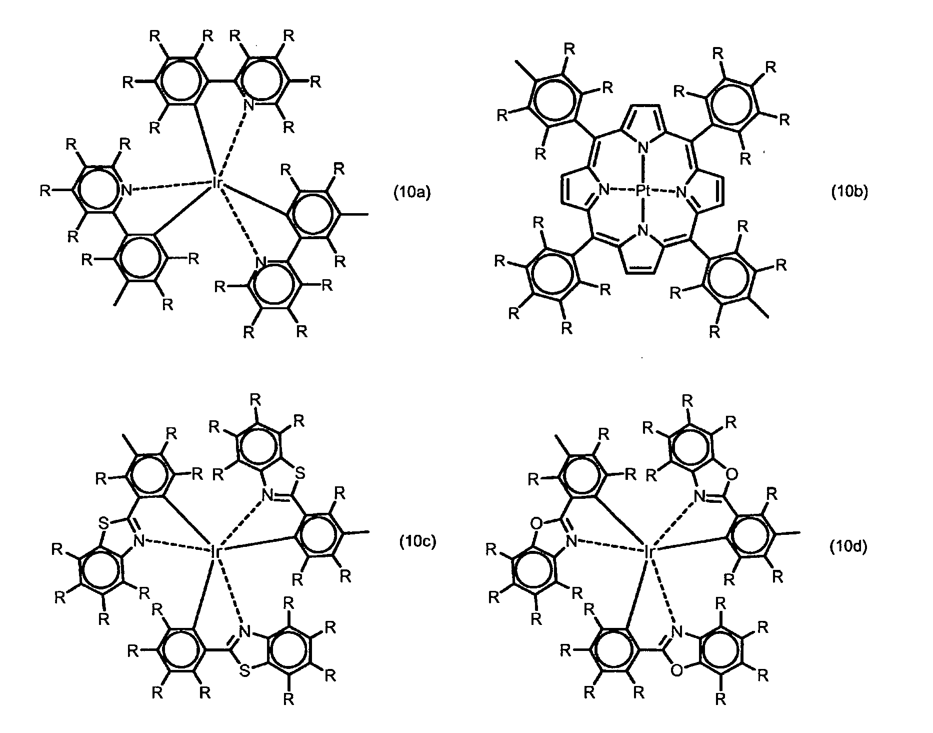

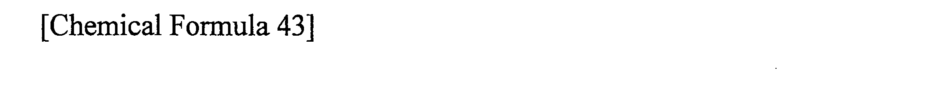

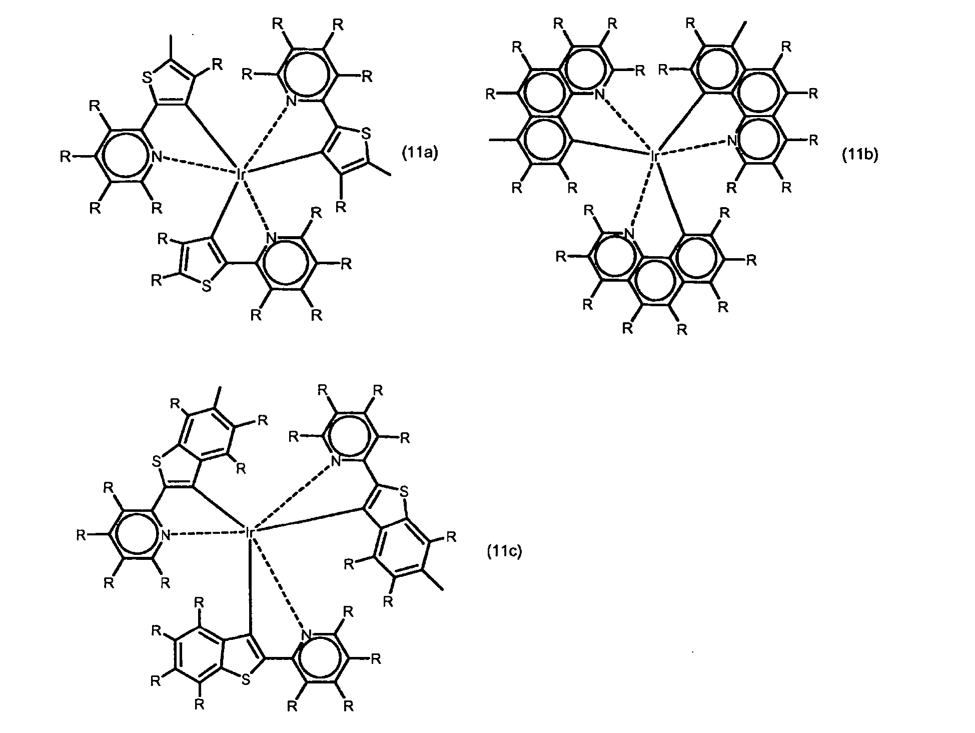

In formulas (10a)-(10d) and (11a)-(11c), the groups represented by R are each independently hydrogen, alkyl, alkoxy, alkylthio, aryl, aryloxy, arylthio, arylalkyl, arylalkoxy, arylalkylthio, arylalkenyl, arylalkynyl, amino, substituted amino, silyl, substituted silyl, a halogen atom, acyl, acyloxy, an imine residue, an amide, an acid amide group, a monovalent heterocyclic group, carboxyl, substituted carboxyl or cyano, and multiple R groups may be the same or different. The carbon atoms of the divalent groups represented by formulas (10a)-(10d) and (11a)-(11c) may be replaced with nitrogen atoms, oxygen atoms or sulfur atoms so long as the structure described above is maintained, and their hydrogens may also be replaced by fluorine atoms.

Divalent aromatic amine groups are divalent groups with an aromatic amine in the structure, and examples include the groups represented by the following formulas (23a)-(23g). R in the following formulas may be the same groups as in formulas (10a)-(10d) and (11a)-(11 c), and multiple R groups in the same group may be the same or different.

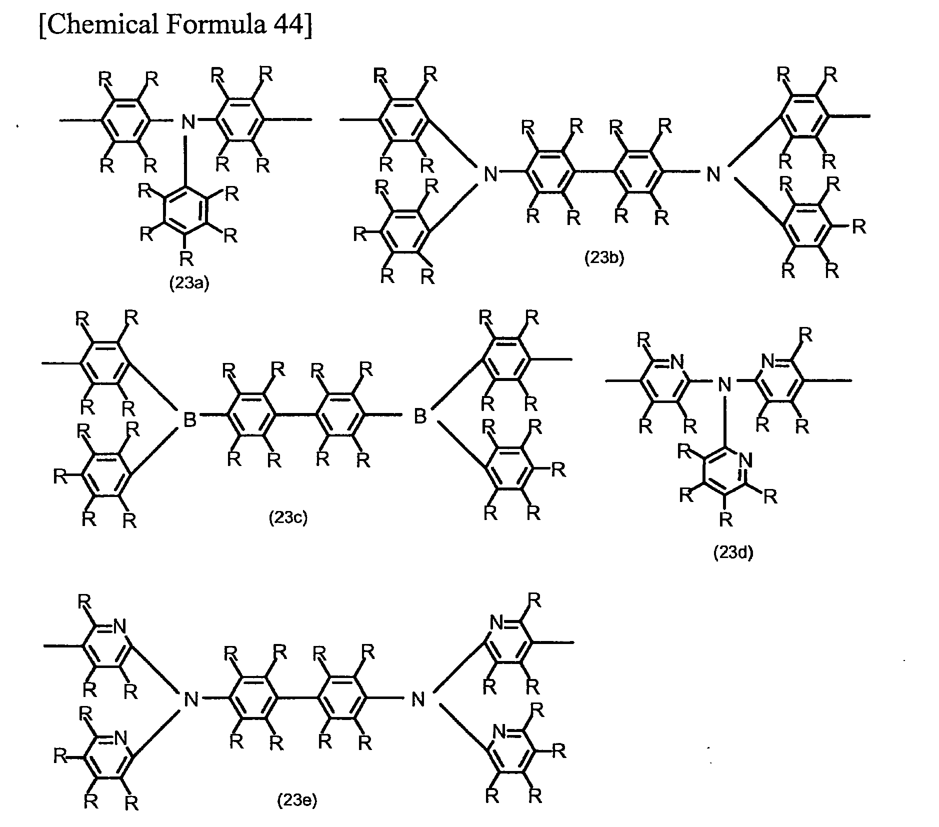

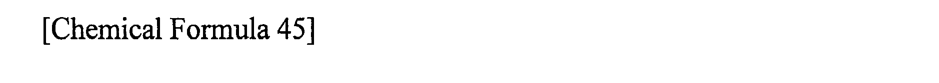

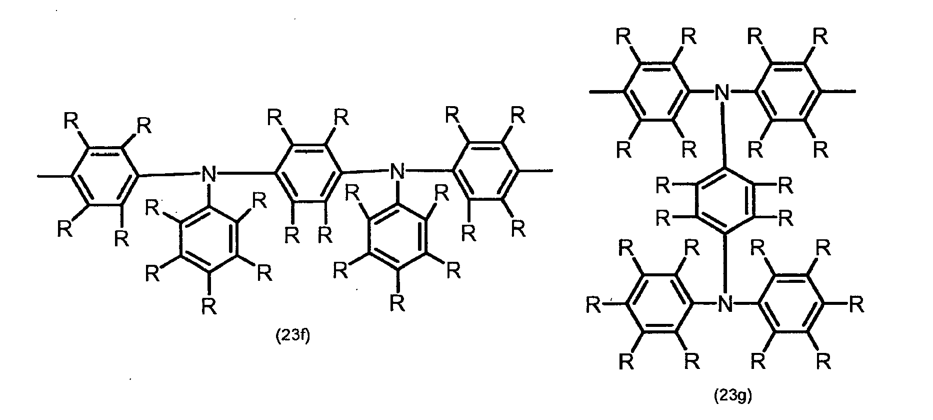

R⁴⁵ and R⁴⁶ in the group represented by -CR⁴⁵=CR⁴⁶- are each independently hydrogen, alkyl, alkoxy, alkylthio, aryl, aryloxy, arylthio, arylalkyl, arylalkoxy, arylalkylthio, arylalkenyl, arylalkynyl, amino, substituted amino, silyl, substituted silyl, a fluorine atom, a monovalent heterocyclic group or a cyano group. Among these, hydrogen, alkyl, aryl, fluorine and cyano are preferred, hydrogen, aryl and cyano are more preferred, and hydrogen and cyano are especially preferred.

The letter n for the repeating unit represented by formula (3) above is an integer of 1-5, preferably an integer of 1-4, more preferably an integer of 1-3, even more preferably 1 or 2, and most preferably 2. If n is within these preferred numerical ranges, the charge injection property of an organic semiconductor layer or the like composed of the polymer compound will tend to be more satisfactory.

Formula (3) is a repeating unit having the structure described above, and when the repeating unit has multiple X groups, the X groups may have the same structure or different structures. From the viewpoint of obtaining stable characteristics, however, multiple X groups more preferably have the same structure.

The repeating unit represented by formula (3) is most preferably a repeating unit represented by formula (4) above. If the polymer compound comprises a repeating unit represented by formula (4), an organic semiconductor layer or the like composed of the polymer compound will be highly satisfactory in terms of both mobility and charge injection property, thus allowing organic transistors with more excellent characteristics to be obtained.

In formula (4), R⁴¹-R⁴⁴ each independently represent hydrogen, alkyl, alkoxy, alkylthio, aryl, aryloxy, arylalkyl, arylalkoxy, substituted silyl, carboxyl, a monovalent heterocyclic group, cyano or a fluorine atom. From the viewpoint of obtaining satisfactory solubility, 10⁴¹-R⁴⁴ are preferably alkyl, alkoxy, alkylthio or carboxyl groups, and more preferably alkyl or alkoxy groups from the viewpoint of reducing steric hindrance between adjacent repeating units. Alkyl groups are particularly preferred from the viewpoint of improving the main chain packing and planarity.

In the structure represented by formula (4), R⁴² and R⁴³ are preferably hydrogen from the viewpoint of improving the planarity between thiophene rings and increasing the main chain packing and charge mobility. In such cases, the repeating unit represented by formula (4) preferably has a structure represented by the following formula (24). R⁴¹ and R⁴⁴ in the following formula (24) are the same as defined above.

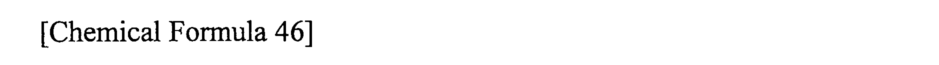

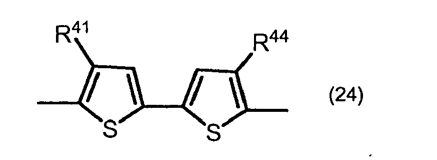

Repeating units in a polymer compound according to a preferred embodiment were described above, but the amount of the repeating unit represented by formula (1) in a polymer compound of this embodiment, among the total repeating units composing the polymer compound, is preferably 50-100 mol%, more preferably 50-90 mol%, even more preferably 50-80 mol% and most preferably about 50 mol%. Including a repeating unit represented by formula (1) in this proportion will tend to result in more satisfactory charge injection of organic semiconductor layers and the like composed of the polymer compound, and more satisfactory solubility of the polymer compound. When repeating units represented by formulas (2a) and (2b) are both present as repeating units represented by formula (1), these ranges are for their total proportions. The proportions may be appropriately set depending on the desired properties. For example, a polymer compound with a proportion of 100 mol% for the repeating unit represented by formula (1) exhibits excellent fluorescent properties and electric field luminescence properties, and is suitable for a luminescent material utilizing such properties.

When the polymer compound comprises repeating units represented by both formulas (2a) and (2b) as repeating units represented by formula (1), the lower repeating unit ratio of the total number of moles is preferably no greater than 10 mol%, more preferably no greater than 5 mol%, even more preferably no greater than 1 mol% and yet more preferably no greater than 0.05 mol%. This will result in highly satisfactory orientation of the polymer compound main chain, to obtain more excellent mobility and charge injection properties.

When the ratio of the repeating unit represented by formula (1) in the polymer compound is not 100 mol%, as with the preferred ratios mentioned above, the repeating unit other than the repeating unit represented by formula (1) is most preferably a repeating unit represented by formula (3). This will tend to result in a highly superior charge injection property. Most preferably, the polymer compound is a copolymer comprising a repeating unit represented by formula (1) and a repeating unit represented by formula (3) at 1:1 (molar ratio).

When the polymer compound of this embodiment has multiple different repeating units, it may be any type of copolymer with no restrictions on the polymerization mode. For example, it may be a block copolymer, random copolymer, alternating copolymer or graft copolymer. From the viewpoint of obtaining satisfactory charge injection, charge mobility, main chain packing and solubility in solvents for the polymer compound, however, it preferably has a structure with alternating bonding of the repeating unit represented by formula (1) (preferably a repeating unit of formula (2a) and/or (2b)) and a repeating unit represented by formula (3). The ratio of such a structure is preferably 90% or greater, more preferably 99% or greater, even more preferably 99.5% or greater and most preferably 99.9% or greater.

More specifically, the polymer compound of this embodiment preferably has a structure with alternating bonding of a repeating unit represented by formulas (8a) and/or (8b) above and a repeating unit represented by formula (3), from the viewpoint of improving the properties including the charge injection property, charge mobility, main chain packing and solubility in solvents. The properties mentioned above can be obtained very satisfactorily if such a structure has only either one of the repeating units represented by formulas (8a) and (8b), and especially if it has only a repeating unit of formula (8a).

The polymer compound of this embodiment has a number-average molecular weight (Mn) of preferably about 1 × 10³ to 1 × 10⁸ and more preferably 1 × 10⁴ to 1 × 10⁶, as measured by gel permeation chromatography (hereunder, "GPC") based on polystyrene. The weight-average molecular weight (Mw) based on polystyrene is preferably between about 1 × 10³ and 1 × 10⁸, and from the viewpoint of film formability and improving the characteristics for formed devices, it is more preferably between 1 × 10⁴ and 5 × 10⁶ , even more preferably between 1 × 10⁴ and 5 × 10⁵ and most preferably between 1.5 × 10⁴ and 5 × 10⁵_{.}

If the polymer compound of this embodiment has polymerizing active groups at its ends during production of the polymer compound, such groups can lower the characteristics such as mobility and usable life when the polymer compound is employed as the organic semiconductor layer of an organic transistor or the like, and therefore the end groups are preferably stable groups. Such end groups are preferably conjugated with the main chain, and for example, the structure may include bonding with aryl or heterocyclic groups via carbon-carbon bonds. Specific examples for end groups include the substituents shown in Formula 10 of Japanese Unexamined Patent Publication HEI No. 9-45478. From the viewpoint of improving the charge injection and charge mobility, the polymer compound is preferably a conjugated polymer.

### [Method for producing polymer compound]

A preferred mode of a method for producing a polymer compound having the structure described above will now be explained.

The polymer compound can be produced by a polymerization step in which a compound (starting compound) represented by formula (5) above is polymerized, which satisfactorily yields a polymer compound having a repeating unit represented by formula (1). More specifically, for production of a polymer compound having a repeating unit represented by formula (2a) and/or (2b), a starting compound represented by formula (6a) and/or (6b) is used as the starting compound represented by formula (5). R¹ and R²¹-R³⁶ in formulas (5), (6a) and (6b) have the same definitions as the groups in formulas (1), (2a) and (2b), and their preferred groups are also the same. The letter 1 in formula (5) also has the same definition.

A starting compound represented by formula (7) may also be polymerized in the method for producing a polymer compound of this embodiment. This can yield a polymer compound having a repeating unit represented by formula (3) above in addition to the repeating unit represented by formula (1) (preferably the repeating unit represented by formula (2a) and/or (2b)). X in formula (7) has the same definition as X in formula (3), and its preferred structures are also the same. The letter n in formula (7) also has the same definition.

These starting compounds represented by formulas (5), (6a), (6b) and (7) can satisfactorily yield polymer compounds according to the aforementioned preferred embodiments, and such compounds are highly useful as starting compounds for synthesis of polymer compounds with the structures described above.

Y⁵¹, Y⁵², Y⁶¹-Y⁶⁴, Y⁷¹ and Y⁷² in the starting compounds represented by formulas (5), (6a), (6b) and (7) are each substituents that are polymerizable (hereinafter referred to as "polymerizable substituents"), and they are selected according to the combination of starting compounds that are to be polymerized during production of the polymer compound. Specifically, when a starting compound represented by formula (5) (preferably formula (6a) and/or (6b)) is to be polymerized alone, a combination of polymerizable substituents is selected that will allow the compounds to undergo polymerization reaction, and when a starting compound represented by formula (7) is also to be polymerized, a combination of polymerizable functional groups is selected that will allow those compounds to undergo polymerization reaction. Appropriate selection of the combination of polymerizable functional groups will give the obtained polymer compound the desired polymerization mode (block copolymerization, alternating copolymerization, etc.).

As specific polymerizable functional groups represented by Y⁵¹, Y⁵², Y⁶¹-Y⁶⁴, Y⁷¹ and Y⁷² there may be mentioned halogen atoms, sulfonates represented by the following formula (12a), methoxy, boric acid ester residues, boric acid residue (i.e. the group represented by - B(OH)₂), groups represented by the following formula (12b), groups represented by the following formula (12c) and groups represented by the following formula (12d). These are preferably selected as appropriate for the polymerization reaction to be conducted. The polymerization reaction produced by these polymerizable functional groups is a condensation polymerization reaction. 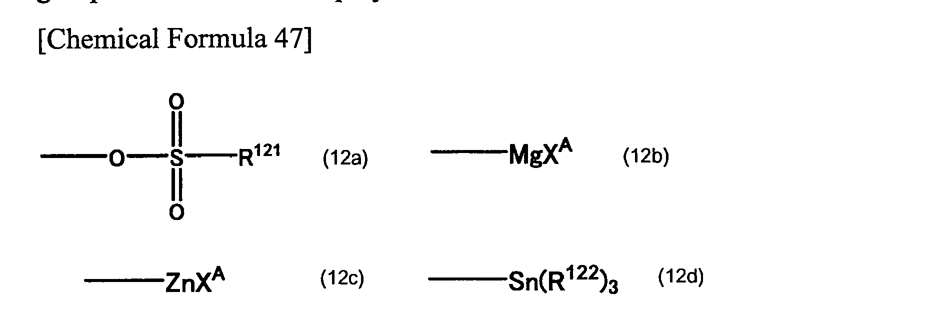 [In the formula, R¹²¹ and R¹²² each independently represent optionally substituted alkyl or optionally substituted aryl, and X^{A} represents a halogen atom.]

Halogen atoms as polymerizable functional groups or groups represented by X^{A} may be chlorine, bromine or iodine.

As examples of sulfonate groups represented by formula (12a) there may be mentioned methane sulfonate, trifluoromethane sulfonate, phenyl sulfonate and 4-methylphenyl sulfonate. As examples of boric acid ester residues there may be mentioned groups represented by the following chemical formulas.

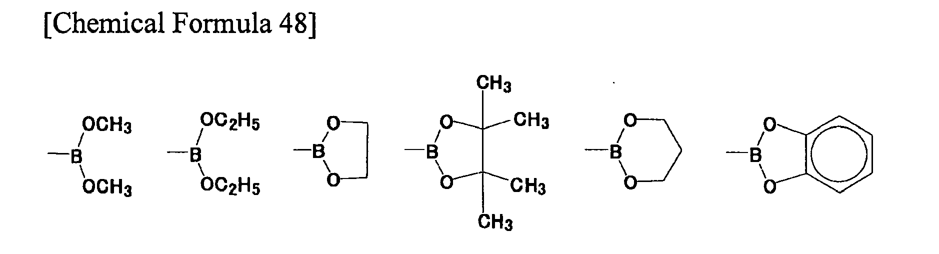

Examples of groups represented by formula (12d) include trimethylstannanyl, triethylstannanyl and tributylstannanyl. Examples of alkyl and aryl groups as polymerizable functional groups represented by Y⁵¹, Y⁵², Y⁶¹-Y⁶⁴, Y⁷¹ and Y⁷², and alkyl or aryl groups as R¹²¹ and R¹²² in formulas (12a) and (12d), include the same alkyl and aryl groups mentioned for R¹ in formula (1) above, and the preferred examples are also the same.

Preferred polymerizable functional groups represented by Y⁵¹, Y⁵², Y⁶¹-Y⁶⁴, Y⁷¹ and Y⁷² are halogen atoms, boric acid ester residues and boric acid residue, from the viewpoint of facilitating synthesis and handling of the starting compounds.

For production of a polymer compound according to this embodiment, a starting compound represented by formula (5) (preferably formula (6a) and/or (6b)) and a starting compound represented by formula (7) are combined appropriately and subjected to condensation polymerization, if necessary in the presence of a catalyst or a base. The starting compounds may be synthesized and isolated beforehand for the reaction, or they may be prepared in the reaction system and used directly.

Examples of catalysts to be used in the reaction include transition metal complexes which may be palladium complexes such as palladium [tetrakis(triphenylphosphine)], [tris(dibenzylideneacetone)]dipalladium and palladium acetate or nickel complexes such as nickel [tetrakis(triphenylphosphine)], [1,3-bis(diphenylphosphino)propane]dichloronickel and [bis(1,4-cyclooctadiene)]nickel, or catalysts comprising these transition metal complexes with ligands such as triphenylphosphine, tri(o-tolyl)phosphine), tri(o-methoxyphenyl)phosphine, tri(t-butyl)phosphine), tricyclohexylphosphine, diphenylphosphinopropane, tri-t-butylphosphonium tetrafluoroborate or bipyridyl. The catalyst may be synthesized beforehand or prepared in the reaction system and used directly. Also, a single catalyst may be used alone or two or more may be used in combination.

There are no particular restrictions on the amount of a catalyst which is used, and for example, it is preferably used at 0.00001-3 mol equivalents, more preferably 0.00005-0.5 mol equivalents and even more preferably 0.0001-0.2 mol equivalents, as the amount of transition metal compound with respect to the total number of moles of the compounds represented by formulas (5) and (7).

As examples of the aforementioned bases there may be mentioned inorganic bases such as sodium carbonate, potassium carbonate, cesium carbonate, potassium fluoride, cesium fluoride and tripotassium phosphate, and organic bases such as tetrabutylammonium fluoride, tetrabutylammonium chloride tetrabutylammonium bromide and tetrabutylammonium hydroxide. There are no particular restrictions on the amount of a base when it is used, and for example, it is preferably used at 0.5-20 mol equivalents and more preferably 1-10 mol equivalents, as the amount of transition metal compound with respect to the total number of moles of the compounds represented by formulas (5) and (7).

The condensation polymerization reaction may be carried out in the presence of a solvent, or it may be carried out in the absence of a solvent if none is particularly required, although it is preferably carried out in the presence of a solvent for better reaction efficiency. The suitable solvents will differ depending on the type of starting compounds and the manner of polymerization reaction to be conducted, and as examples there may be mentioned organic solvents such as toluene, xylene, mesitylene, tetrahydrofuran, 1,4-dioxane, dimethoxyethane, N,N-dimethylacetamide and N,N-dimethylformamide. From the viewpoint of minimizing secondary reactions, the solvent is preferably one that has been subjected to deoxidizing treatment. A single solvent may be used alone or two or more may be used in combination. The amount of solvent, when used, is an amount such that the total concentration of the starting compounds of formulas (5) or (7) is preferably 0.1-90 wt%, more preferably 1-50 wt% and even more preferably 2-30 wt%.

The reaction temperature for condensation polymerization is not particularly restricted, but it is preferably between -100°C and 200°C, more preferably between -80°C and 150°C and even more preferably between 0°C and 120°C. The reaction time will depend on the conditions including the reaction temperature, but it is preferably at least 1 hour and more preferably 2-500 hours.

The condensation polymerization reaction may be carried out under dehydrating conditions. It is preferably carried out under dehydrating conditions when the polymerizable functional group is a group represented by formula (12b), for example.

As specific condensation polymerization reactions there may be mentioned a method of polymerization by Suzuki reaction (Chem. Rev. Vol. 95, p.2457(1995)), a method of polymerization by Grignard reaction (Kobunshi Kinou Zairyo Series Vol.2, "Polymer Syntheses and Reactions (2), p.432-433, Kyoritsu Publishing), and a method of polymerization by Yamamoto polymerization (Prog. Polym. Sci., Vol. 17, 11 p.53-1205, 1992).

The condensation polymerization reaction is most preferably carried out by using a starting compound represented by formula (5) (preferably formula (6a) and/or (6b)) and a starting compound represented by formula (7), in a combination where the polymerizable functional group of one starting compound is a halogen atom and the polymerizable functional group of the other starting compound is a boric acid residue or boric acid ester residue, and conducting Suzuki polymerization between the two starting compounds. This will satisfactorily yield a polymer compound having a repeating unit represented by formula (1) (preferably a repeating unit represented by formula (2a) and/or (2b)) and a repeating unit represented by formula (3) above, in an alternating arrangement.

A compound represented by the following formula (13a) and/or (13b) is most preferred as the starting compound represented by formula (5). Using these compounds can yield a polymer compound having a repeating structure represented by formula (8a) and/or (8b) above as the repeating unit represented by formula (1). R²², R²⁶, R², R³⁵ and Y⁶¹-Y⁶⁴ in the formulas all have the same definitions as above.

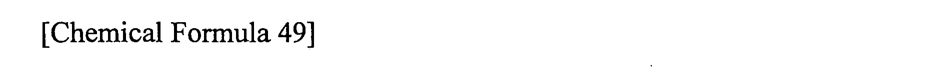

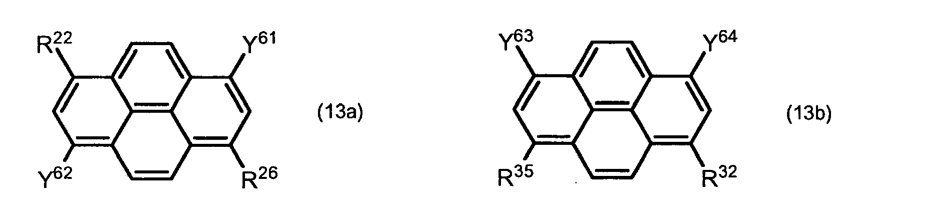

Post-treatment known in the art may be carried out after the condensation polymerization. An example of post-treatment is a method in which a precipitate deposited by adding the reaction mixture obtained by condensation polymerization to a lower alcohol such as methanol is filtered and dried. Such post-treatment can satisfactorily produce a polymer compound, but if the purity of the polymer compound is low it may be further purified by common methods such as recrystallization, continuous extraction with a Soxhlet extractor, or column chromatography.

### [Composition]

A preferred embodiment of a composition of the invention comprising a polymer compound as described above will now be explained.

The composition of this embodiment comprises a polymer compound according to the preferred embodiments described above, and additive materials to impart specific functions, such as a positive hole transport material, electron transport material and luminescent material. Such a composition is suitable as a charge transport material or luminescent material, for example. The content ratios of the polymer compound and additive materials in the composition of this embodiment may be appropriately selected depending on the desired function. When a luminescent material is used, for example, the amount of polymer compound is preferably 20-99 parts by weight and more preferably 40-95 parts by weight, with 100 parts by weight as the total weight of the composition.

The composition of this embodiment has an overall number-average molecular weight of preferably about 10³-10⁸ and more preferably 10⁴-10⁶, based on polystyrene. The weight-average molecular weight based on polystyrene is preferably about 10³-10⁸, and more preferably between 1 × 10⁴ and 5 × 10⁶ from the viewpoint of improving the film formability and the luminous efficiency of the obtained device. The average molecular weight is the value determined by analyzing the composition by GPC.

### [Ink composition]

The polymer compound of the embodiment described above may be prepared as an ink composition by combination with a solvent. That is, the ink composition according to a preferred embodiment comprises a polymer compound and a solvent. Such an ink composition may include a composition having specific functions by addition of the additive materials mentioned above. The ink composition of this embodiment is useful for printing and the like and allows satisfactory formation of desired thin-films.

The proportion of the polymer compound in the ink composition of this embodiment is preferably 1-99.9 parts by weight, more preferably 60-99.5 parts by weight and even more preferably 80-99.0 parts by weight with respect to 100 parts by weight of the ink composition. The viscosity of the ink composition may be varied as appropriate depending on the type of printing method, but when the solution is passed through a discharge apparatus as in ink jet printing, the viscosity is preferably in the range of 1-20 mPa·s at 25°C to prevent clogging or dropping trajectory of the ink during discharge.

In addition to the polymer compound and solvent and the additive materials to impart prescribed functions, the ink composition of this embodiment may also contain stabilizers, thickeners (high molecular weight compounds or poor solvents for increased viscosity), low-molecular-weight compounds to lower the viscosity, surfactants (to lower the surface tension), antioxidants and the like, depending on the desired properties.

A high molecular weight compound used as a thickener preferably is soluble in the same solvents as the polymer compound and does not interfere with the characteristics including luminescence and charge transport. High-molecular-weight polystyrene and high molecular weight polymethyl methacrylate may be mentioned as examples. These high molecular weight compounds preferably have weight-average molecular weights of 500,000 or greater and more preferably 1,000,000 or greater, based on polystyrene.

The viscosity of the ink composition can be increased by adding a small amount of a poor solvent as a thickener to the solid portion of the ink composition. When a poor solvent is added as a thickener, the type and amount of solvent may be selected in a range so that the solid portion in the solution is not deposited. In consideration of stability during storage, the amount of poor solvent is preferably no greater than 50 parts by weight and even more preferably no greater than 30 parts by weight with respect to 100 parts by weight as the total ink composition.

Addition of an antioxidant can also improve the storage stability of the ink composition. An antioxidant preferably is soluble in the same solvents as the polymer compound and does not interfere with the characteristics including luminescence and charge transport. As examples there may be mentioned phenol-based antioxidants and phosphorus-based antioxidants.

There are no particular restrictions on the solvent used in ink composition, but it is preferably one that can dissolve or uniformly disperse the solid components in solution. Examples of such solvents include chlorine-based solvents such as chloroform, methylene chloride, 1,2-dichloroethane, 1,1,2-trichloroethane, chlorobenzene and o-dichlorobenzene, ether-based solvents such as tetrahydrofuran, dioxane and anisole, aromatic hydrocarbon-based solvents such as toluene and xylene, aliphatic hydrocarbon-based solvents such as cyclohexane, methylcyclohexane, n-pentane, n-hexane, n-heptane, n-octane, n-nonane and n-decane, ketone-based solvents such as acetone, methyl ethyl ketone, cyclohexanone, benzophenone and acetophenone, ester-based solvents such as ethyl acetate, butyl acetate, ethylcellosolve acetate, methyl benzoate and phenyl acetate, polyhydric alcohols and their derivatives such as ethylene glycol, ethyleneglycol monobutyl ether, ethyleneglycol monoethyl ether, ethyleneglycol monomethyl ether, dimethoxyethane, propylene glycol, diethoxymethane, triethyleneglycol monoethyl ether, glycerin and 1,2-hexanediol, alcohol-based solvents such as methanol, ethanol, propanol, isopropanol and cyclohexanol, sulfoxide-based solvents such as dimethyl sulfoxide, and amide-based solvents such as N-methyl-2-pyrrolidone and N,N-dimethylformamide. These solvents may be used alone, or two or more may be used in combination.

Preferred solvents, from the viewpoint of solubility of the polymer compound and homogeneity and viscosity characteristics of film formation, include aromatic hydrocarbon-based solvents, ether-based solvents, aliphatic hydrocarbon-based solvents, ester-based solvents and ketone-based solvents, and specifically toluene, xylene, ethylbenzene, diethylbenzene, trimethylbenzene, n-propylbenzene, isopropylbenzene, n-butylbenzene, isobutylbenzene, s-butylbenzene, n-hexylbenzene, cyclohexylbenzene, 1-methylnaphthalene, tetralin, anisole, ethoxybenzene, cyclohexane, bicyclohexyl, cyclohexenylcyclohexanone, n-heptylcyclohexane, n-hexylcyclohexane, decalin, methyl benzoate, cyclohexanone, 2-propylcyclohexanone, 2-heptanone, 3-heptanone, 4-heptanone, 2-octanone, 2-nonanone, 2-decanone, dicyclohexylketone, acetophenone and benzophenone are more preferred.

From the viewpoint of obtaining satisfactory film formability and device characteristics, it is preferred to use a combination of two or more solvents, it is more preferred to use 2-3 different solvents, and it is especially preferred to use 2 different solvents.

When two different solvents are combined, one of the solvents may be a solid at 25°C. From the viewpoint of obtaining satisfactory film formability, one of the solvents preferably has a boiling point of 180°C or higher and more preferably 200°C or higher. From the viewpoint of obtaining suitable viscosity, either of the two different solvents is preferably capable of dissolving aromatic polymers at 1 wt% or greater at 60°C, and at least one of the two different solvents is preferably capable of dissolving aromatic polymers at 1 wt% or greater at 25°C.

When two or more solvents are present in the ink composition, the solvent with the highest boiling point is present at preferably 40-90 wt%, more preferably 50-90 wt% and even more preferably 65-85 wt% of the weight of all the solvents in the ink composition, from the viewpoint of obtaining satisfactory viscosity and film formability.

When the ink composition contains two different solvents, for example, preferred combinations from the viewpoint of viscosity and film formability include anisole and bicyclohexyl, anisole and cyclohexylbenzene, xylene and bicyclohexyl, xylene and cyclohexylbenzene, and mesitylene and methylbenzoate.

The polymer compound in the ink composition is not limited to a single type, and two or more of the aforementioned suitable polymer compounds may be used. In such cases, the combined polymer compounds are preferably selected in ranges that do not lower the characteristics of the thin-film that is to be obtained.

The ink composition of this embodiment may also contain water or a metal or its salt in a range of 1-1000 ppm by weight. As specific examples of metals there may be mentioned lithium, sodium, calcium, potassium, iron, copper, nickel, aluminum, zinc, chromium, manganese, cobalt, platinum and iridium. The ink composition may also contain silicon, phosphorus, fluorine, chlorine, bromine or the like in ranges of 1-1000 ppm by weight.

### [Thin-film]

A preferred embodiment of a thin-film of the invention comprising a polymer compound as described above will now be explained.

The thin-film of this embodiment comprises a polymer compound as described above, and this encompasses thin-films composed entirely of the polymer compound and thin-films composed of a composition according to the embodiments described above. The thin-film of this embodiment can be applied as an organic semiconductor thin-film, a luminescent thin-film, a conductive thin-film, or the like.

First, an organic semiconductor thin-film is a thin-film having an electron transport or hole transport property. The greater of the electron mobility or positive hole mobility of the organic semiconductor thin-film is preferably 10⁻⁵ cm²/Vs or greater, more preferably 10⁻³ cm²/Vs or greater and even more preferably 10⁻¹ cm²/Vs or greater. An organic transistor can be fabricated by, for example, forming an organic semiconductor thin-film on a Si substrate comprising a gate electrode and an insulating film made of SiO₂ or the like, and then forming a source electrode and drain electrode of Au or the like.

The organic semiconductor thin-film of this embodiment may consist entirely of a single polymer compound of the invention, or it may comprise a combination of two or more. In order to enhance the electron transport and hole transport properties of the organic semiconductor thin-film, a low molecular compound or high molecular compound having an electron transport or hole transport property may also be included in addition to the polymer compound of the invention.

Any known hole transport material may be used, examples of which include pyrazoline derivatives, arylamine derivatives, stilbene derivatives, triaryldiamine derivatives, oligothiophene and its derivatives, polyvinylcarbazole and its derivatives, polysilane and its derivatives, polysiloxane derivatives with aromatic amines on the side chains or main chain, polyaniline and its derivatives, polythiophene and its derivatives, polypyrrole and its derivatives, polyarylenevinylene and its derivatives, and polythienylenevinylene and its derivatives.

Any known electron transport material may also be used, examples of which include oxadiazole derivatives, quinodimethane and its derivatives, benzoquinone and its derivatives, naphthoquinone and its derivatives, anthraquinone and its derivatives, tetracyanoanthraquinodimethane and its derivatives, fluorenone derivatives, diphenyldicyanoethylene and its derivatives, diphenoquinone derivatives, metal complexes of 8-hydroxyquinoline and its derivatives, polyquinoline and its derivatives, polyquinoxaline and its derivatives, polyfluorene and its derivatives, and C₆₀ or other fullerenes and their derivatives.

An organic semiconductor thin-film of the invention may also contain a charge generation material for generation of an electrical charge upon absorption of light in the thin-film. Any publicly known charge generation material may be used, and examples include azo compounds and their derivatives, diazo compounds and their derivatives, ametallic phthalocyanine compounds and their derivatives, metallic phthalocyanine compounds and their derivatives, perylene compounds and their derivatives, polycyclic quinone-based compounds and their derivatives, squarylium compounds and their derivatives, azulenium compounds and their derivatives, thiapyrylium compounds and their derivatives, and C₆₀ or other fullerenes and their derivatives.

The organic semiconductor thin-film of the invention may also contain materials necessary for exhibiting various functions. As examples there may be mentioned sensitizing agents to enhance the function of generating charge by light absorption, stabilizers to increase stability, and UV absorbers for absorption of UV light.

The organic semiconductor thin-film may also contain high molecular compound materials as high molecular binders in addition to the polymer compound mentioned above, in order to improve the mechanical properties. As high molecular binders there are preferably used ones that produce minimal interference with the electron transport or hole transport property, and ones with weak absorption for visible light.

Examples of high molecular binders include poly(N-vinylcarbazole), polyaniline and its derivatives, polythiophene and its derivatives, poly(p-phenylenevinylene) and its derivatives, poly(2,5-thienylenevinylene) and its derivatives, polycarbonates, polyacrylates, polymethyl acrylates, polymethyl methacrylates, polystyrenes, polyvinyl chlorides, polysiloxanes and the like.

The film thickness of such an organic semiconductor thin-film is preferably about 1 nm-100 µm, more preferably 2 nm-1000 nm, even more preferably 3 nm-500 nm and most preferably 5 nm-200 nm.

There are no particular restrictions on the method for producing an organic semiconductor thin-film, and an example is a method of film formation using a solution comprising the polymer compound of the invention and, as necessary, an electron transport or hole transport material and a high molecular binder in admixture therewith (for example, the ink composition of the embodiment described above). When the polymer compound is an oligomer, a thin-film may be formed by vacuum vapor deposition.

The solvent in the solution used for film formation of the organic semiconductor thin-film is not particularly restricted so long as it can dissolve the polymer compound and the electron transport or hole transport material and high molecular binder combined therewith. Specific examples of such solvents include unsaturated hydrocarbon-based solvents such as toluene, xylene, mesitylene, tetralin, decalin, bicyclohexyl, n-butylbenzene, sec-butylbenzene and tert-butylbenzene, halogenated saturated hydrocarbon-based solvents such as carbon tetrachloride, chloroform, dichloromethane, dichloroethane, chlorobutane, bromobutane, chloropentane, bromopentane, chlorohexane, bromohexane, chlorocyclohexane and bromocyclohexane, halogenated unsaturated hydrocarbon-based solvents such as chlorobenzene, dichlorobenzene and trichlorobenzene, and ether-based solvents such as tetrahydrofuran and tetrahydropyran. Dissolution in such solvents will normally be to at least 0.1 wt%, although this will differ depending on the structure and molecular weight of the polymer compound.

The method for forming the film using the solution may be a coating method such as spin coating, casting, microgravure coating, gravure coating, bar coating, roll coating, wire bar coating, dip coating, spray coating, screen printing, flexographic printing, offset printing, ink jet printing or dispenser printing. Particularly preferred are spin coating, flexographic printing, ink jet printing and dispenser printing.

A polymer compound-orienting step may also be carried out for production of an organic semiconductor thin-film. Such a step will yield an organic semiconductor thin-film comprising the polymer compound in an oriented state, and the resulting organic semiconductor thin-film will have the main chain molecules or side chain molecules aligned in a single direction, thus resulting in high electron mobility or hole mobility.

The method of orienting the polymer compound in the organic semiconductor thin-film may be a known method for orienting liquid crystals. Rubbing, photoorientation, shearing (shear stress application) and pull-up coating methods are convenient, useful and easy orienting methods, and rubbing and shearing are preferred.

Since the organic semiconductor thin-film of this embodiment has an electron transport property or hole transport property, it is possible to effect transport control of the electrons or holes introduced from the electrodes, or electrical charge generated by photoabsorption. Such properties therefore allow it to be used in various organic thin-film devices such as organic electroluminescence devices, organic transistors, organic solar cells or optical sensors. When an organic semiconductor thin-film is used in such organic thin-film devices, it is preferably used after orientation by orienting treatment in order to further contribute to improvement in the electron transport property or hole transport property.

As mentioned above, a thin-film comprising a polymer compound of the invention may be a luminescent thin-film or conductive thin-film instead of an organic semiconductor thin-film. These may also be composed entirely of the polymer compound of the invention, or they may comprise combinations thereof with additive materials that confer prescribed functionality.

For example, a luminescent thin-film has a luminescent quantum yield of preferably 30% or greater, more preferably 50% or greater, even more preferably 60% or greater and most preferably 70% or greater, from the viewpoint of obtaining satisfactory device luminance and luminescence voltage.

For a conductive thin-film, the surface resistance is preferably no greater than 1K Ω/sq., more preferably no greater than 100 Ω/sq. and even more preferably no greater than 10 Ω/sq. The conductive thin-film may be doped with a Lewis acid, ionic compound or the like, thereby further increasing the electric conductivity.

Such thin-films can be formed using a solution (ink composition or the like) obtained by dissolution or dispersion of the polymer compound and optional additive materials in a solvent. For example, it may be formed by spin coating, casting, microgravure coating, gravure coating, bar coating, roll coating, wire bar coating, dip coating, spray coating, screen printing, flexographic printing, offset printing, ink jet printing, capillary coating or nozzle coating. Preferred methods are screen printing, flexographic printing, offset printing and ink jet printing, with ink jet printing being particularly preferred.

When such a solution is used to form the thin-film, baking may be carried out at a temperature of 100°C or higher due to the high glass transition temperature of the polymer compound of the invention in the solution, and reduction in the device characteristics can be minimized even with baking at a temperature of 130°C. Baking may even be possible at a temperature of 160°C or higher, depending on the type of polymer compound.

### [Organic transistor]

A preferred embodiment of an organic transistor provided with a thin-film comprising a polymer compound of the invention (organic thin-film transistor) will now be described.

The organic thin-film transistor of the embodiment described hereunder is provided with an organic semiconductor layer comprising the aforementioned organic semiconductor thin-film of the invention, as an active layer. Specifically, the organic thin-film transistor is provided with a source electrode and drain electrode, an organic semiconductor layer (active layer) as a current channel between them and a gate electrode that controls the level of current flowing through the current channel, and examples include field-effect and static induction transistors.

Of these organic thin-film transistors, a field-effect organic thin-film transistor preferably comprises a source electrode and drain electrode, an organic semiconductor layer (active layer) serving as a current channel between them, a gate electrode that controls the level of current flowing through the current channel, and an insulating layer situated between the active layer and the gate electrode. Preferably, the source electrode and drain electrode are provided in contact with the organic semiconductor layer (active layer) containing the polymer of the invention, and the gate electrode is provided sandwiching the insulating layer which is also in contact with the organic semiconductor layer.

A static induction organic thin-film transistor has a structure comprising a source electrode and drain electrode, an organic semiconductor layer which acts as a current channel between them, and a gate electrode that controls the level of current flowing through the current channel, preferably with the gate electrode in the organic semiconductor layer. Most preferably, the source electrode, the drain electrode and the gate electrode formed in the organic semiconductor layer are provided in contact with the organic semiconductor layer. The structure of the gate electrode in this case may be any one that forms a current channel for flow from the source electrode to the drain electrode, and that allows the level of current flowing through the current channel to be controlled by the voltage applied to the gate electrode; an example of such a structure is a combshaped electrode.

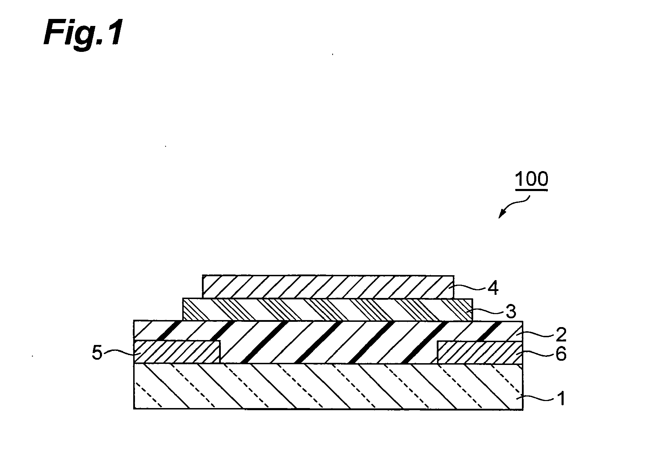

Fig. 1 is a schematic cross-sectional view of an organic thin-film transistor (field-effect organic thin-film transistor) according to a first embodiment. The organic thin-film transistor 100 shown in Fig. 1 comprises a substrate 1, a source electrode 5 and drain electrode 6 formed at a fixed spacing on the substrate 1, an active layer 2 formed on the substrate 1 covering the source electrode 5 and drain electrode 6, an insulating layer 3 formed on the active layer 2, and a gate electrode 4 formed on the insulating layer 3 covering the region of the insulating layer 3 between the source electrode 5 and drain electrode 6.

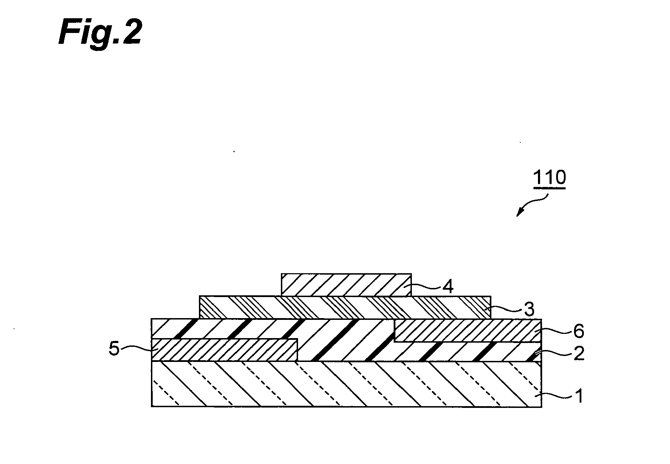

Fig. 2 is a schematic cross-sectional view of an organic thin-film transistor (field-effect organic thin-film transistor) according to a second embodiment. The organic thin-film transistor 110 shown in Fig. 2 comprises a substrate 1, a source electrode 5 formed on the substrate 1, an active layer 2 formed on the substrate 1 covering the source electrode 5, a drain electrode 6 formed on the active layer 2 at a prescribed spacing from the source electrode 5, an insulating layer 3 formed on the active layer 2 and drain electrode 6, and a gate electrode 4 formed on the insulating layer 3 covering a region of the insulating layer 3 between the source electrode 5 and drain electrode 6.

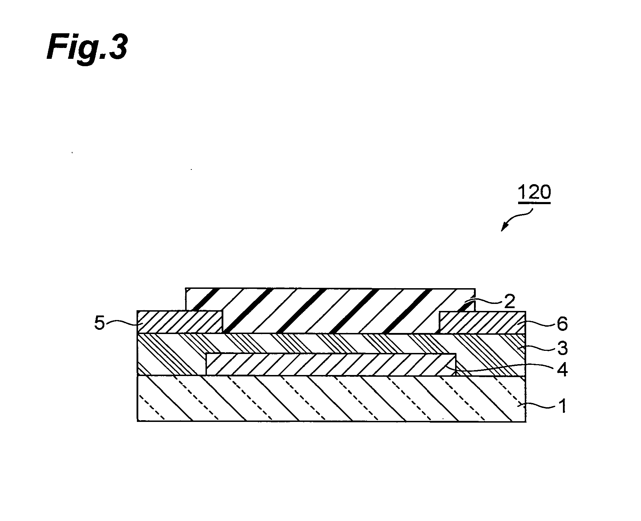

Fig. 3 is a schematic cross-sectional view of an organic thin-film transistor (field-effect organic thin-film transistor) according to a third embodiment. The organic thin-film transistor 120 shown in Fig. 3 comprises a substrate 1, a gate electrode 4 formed on the substrate 1, an insulating layer 3 formed on the substrate 1 covering the gate electrode 4, a source electrode 5 and drain electrode 6 formed at a prescribed spacing on the insulating layer 3 covering portions of the region of the insulating layer 3 under which the gate electrode 4 is formed, and an active layer 2 formed on the insulating layer 3 covering a region of the insulating layer 3 between the source electrode 5 and drain electrode 6.

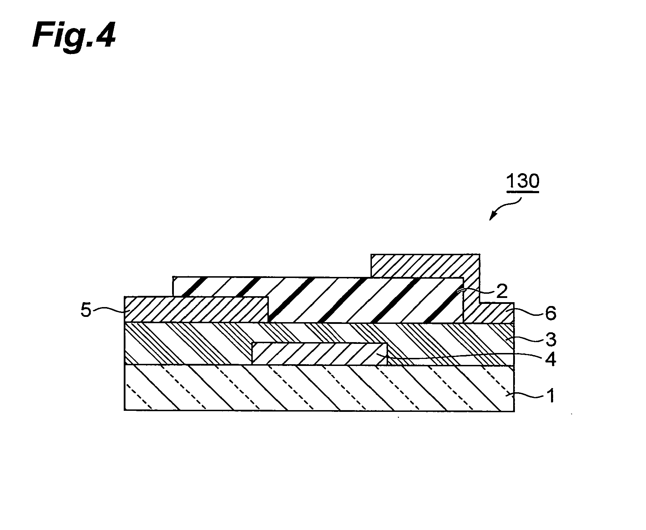

Fig. 4 is a schematic cross-sectional view of an organic thin-film transistor (field-effect organic thin-film transistor) according to a fourth embodiment. The organic thin-film transistor 130 shown in Fig. 4 comprises a substrate 1, a gate electrode 4 formed on the substrate 1, an insulating layer 3 formed on the substrate 1 covering the gate electrode 4, a source electrode 5 formed on the insulating layer 3 covering a portion of the region of the insulating layer 3 under which the gate electrode 4 is formed, an active layer 2 formed on the insulating layer 3 covering part of the region of the source electrode 5, and a drain electrode 6 formed on the insulating layer 3 at a prescribed spacing from the source electrode 5 and covering a portion of the region of the insulating layer 3 under which the gate electrode 4 is formed.

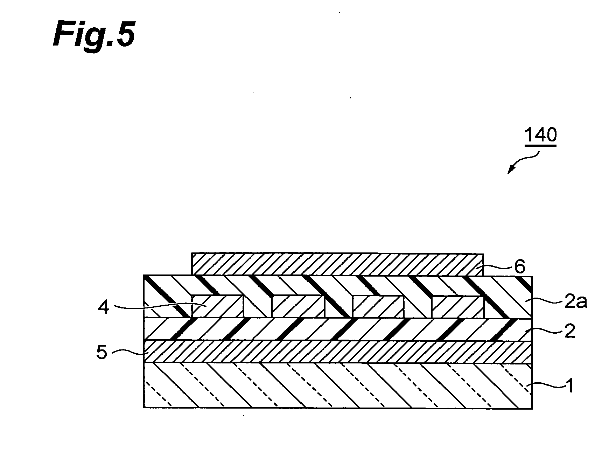

Fig. 5 is a schematic cross-sectional view of an organic thin-film transistor (static induction organic thin-film transistor) according to a fifth embodiment. The organic thin-film transistor 140 shown in Fig. 5 comprises a substrate 1, a source electrode 5 formed on the substrate 1, an active layer 2 formed on the source electrode 5, a plurality of gate electrodes 4 formed at prescribed spacings on the active layer 2, an active layer 2a formed on the active layer 2 covering all of the gate electrodes 4 (the material composing the active layer 2a may be the same as or different from that of the active layer 2), and a drain electrode 6 formed on the active layer 2a.

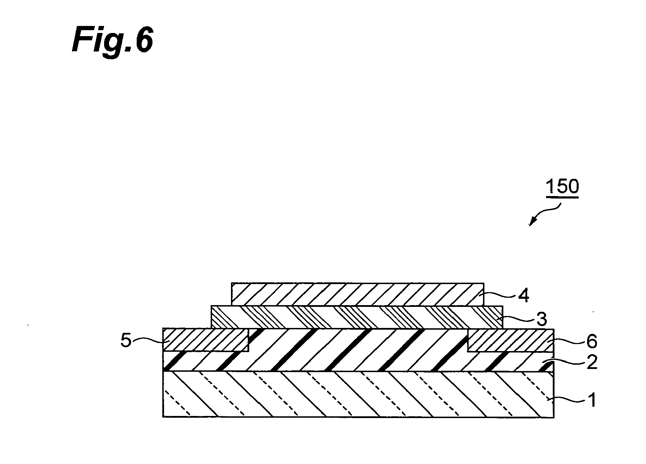

Fig. 6 is a schematic cross-sectional view of an organic thin-film transistor (field-effect organic thin-film transistor) according to a sixth embodiment. The organic thin-film transistor 150 shown in Fig. 6 comprises a substrate 1, an active layer 2 formed on the substrate 1, a source electrode 5 and drain electrode 6 formed at a prescribed spacing on the active layer 2, an insulating layer 3 formed on the active layer 2 covering a region of the active layer 2 between the source electrode 5 and drain electrode 6, and a gate electrode 4 formed on the insulating layer 3, covering a portion of the region of the insulating layer 3 under which the source electrode 5 is formed and a portion of the region of the insulating layer 3 under which the drain electrode 6 is formed.

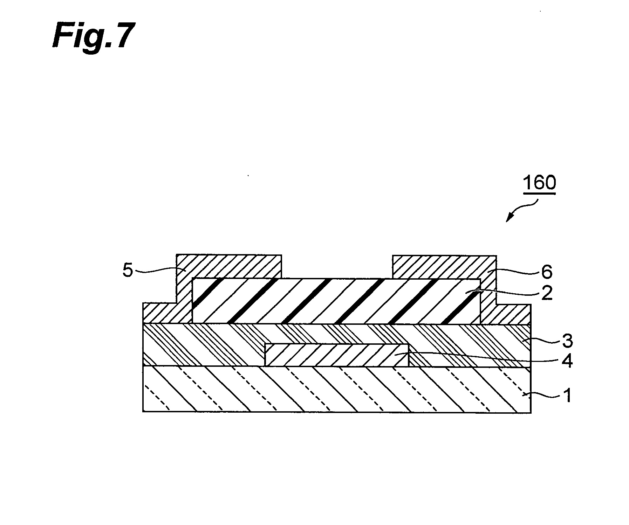

Fig. 7 is a schematic cross-sectional view of an organic thin-film transistor (field-effect organic thin-film transistor) according to a seventh embodiment. The organic thin-film transistor 160 shown in Fig. 7 comprises a substrate 1, a gate electrode 4 formed on the substrate 1, an insulating layer 3 formed on the substrate 1 covering the gate electrode 4, an active layer 2 formed covering the region of the insulating layer 3 under which the gate electrode 4 is formed, a source electrode 5 formed on the insulating layer 3 covering a portion of the region of the active layer 2 under which the gate electrode 4 is formed, and a drain electrode 6 formed on the insulating layer 3 at a prescribed spacing from the source electrode 5 and covering a portion of the region of the active layer 2 under which the gate electrode 4 is formed.

In the organic thin-film transistors of the first to seventh embodiments described above, the active layer 2 and/or the active layer 2a is constructed from an organic semiconductor thin-film containing a polymer compound according to the invention, and it forms a current channel between the source electrode 5 and drain electrode 6. The gate electrode 4 controls the level of current flowing through the current channel of the active layer 2 and/or active layer 2a by application of voltage. The constructions and production methods for the organic thin-film transistors of these embodiments will now be further explained.

Of the organic thin-film transistors mentioned above, a field-effect organic thin-film transistor can be manufactured by a publicly known process, such as the process described in Japanese Unexamined Patent Publication HEI No. 5-110069, for example. A static induction organic thin-film transistor can also be manufactured by a publicly known process such as the process described in Japanese Unexamined Patent Publication No. 2004-006476, for example.

The substrate 1 is not particularly restricted so long as it does not impair the characteristics of the organic thin-film transistor, and a glass panel, flexible film substrate or plastic panel may be used. In a field-effect organic thin-film transistor having a construction in which a gate electrode 4 according to the third, fourth or seventh embodiment contacts the substrate 1, a conductive substrate such as silicon may be used to provide a gate electrode function for the substrate.

It is advantageous for production and also preferred to form the active layer 2 by printing using a solution (ink composition). Therefore, formation of the active layer 2 is preferably carried out by applying the method for producing an organic semiconductor thin-film described above, and forming the organic semiconductor thin-film on a ground layer which is to form the active layer 2.

The insulating layer 3 in contact with the active layer 2 may be any material with high electrical insulating properties, and any publicly known one may be used. As examples there may be mentioned materials composed of SiOx, SiNx, Ta₂O₅, polyimide, polyvinyl alcohol, polyvinylphenol and organic glass. From the viewpoint of low voltage, it is preferred to use a material with high permittivity.

When the active layer 2 is formed on the insulating layer 3, the active layer 2 may be formed after surface modification by treatment of the surface of the insulating layer 3 with a surface treatment agent such as a silane coupling agent, from the viewpoint of improving the interfacial properties between the insulating layer 3 and active layer 2. As surface treatment agents there may be mentioned long-chain alkylchlorosilanes, long-chain alkylalkoxysilanes, fluorinated alkylchlorosilanes, fluorinated alkylalkoxysilanes and silylamine compounds such as hexamethyldisilazane. Before treatment with the surface treatment agent, the insulating layer 3 surface may be pretreated by ozone UV or O₂ plasma.

After the organic thin-film transistor having this construction has been fabricated, a protecting film is preferably formed on the organic thin-film transistor to protect the device. This will shield the organic thin-film transistor from air, thus helping to prevent reduction in the characteristics of the organic thin-film transistor. Forming a protecting film can also minimize adverse effects when an operating display device is formed on the organic thin-film transistor, for example.

The method of forming the protecting film may involve covering the organic thin-film transistor with a UV cured resin, thermosetting resin, inorganic SiONx film or the like. From the viewpoint of effective shielding from air, the steps after fabrication of the organic thin-film transistor and before formation of the protecting film are preferably carried out without exposure to air (for example, in a dry nitrogen atmosphere or in a vacuum).

### [Other organic thin-film devices]

An organic semiconductor thin-film comprising a polymer compound of the invention may be applied as an organic semiconductor layer for various other types of organic thin-film devices, in addition to the organic transistor described above.

Application in a solar cell may be mentioned as a first example.

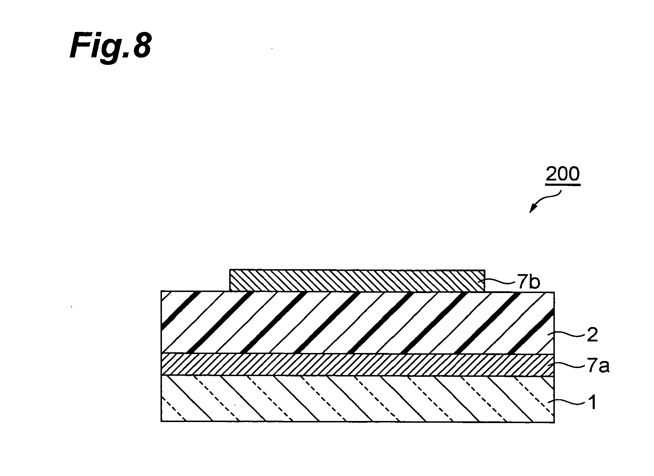

Fig. 8 is a schematic cross-sectional view of a solar cell according to a preferred embodiment. The solar cell 200 shown in Fig. 8 comprises a substrate 1, a first electrode 7a formed on the substrate 1, an active layer 2 comprising an organic semiconductor thin-film of the invention formed on the first electrode 7a, and a second electrode 7b formed on the active layer 2.

In the solar cell of this embodiment, a transparent or semi-transparent electrode is used for either or both the first electrode 7a and second electrode 7b. As electrode materials there may be used metals such as aluminum, gold, silver, copper, alkali metal and alkaline earth metals or their semi-transparent conductive films, or transparent conductive films. In order to obtain high open voltage, it is preferred to select the electrodes so as to produce a large work function difference. Carrier generators, sensitizing agents and the like may also be added in order to increase photosensitivity in the active layer 2 (organic semiconductor thin-film). The substrate 1 may be a silicon substrate, glass panel, plastic panel or the like.

Application of an organic semiconductor thin-film of the invention in an optical sensor will now be explained.

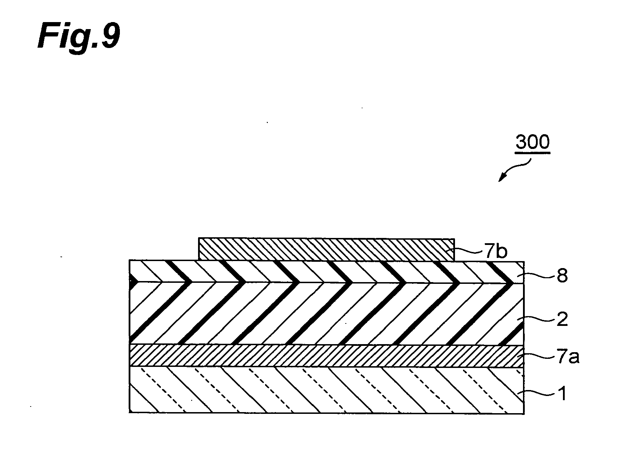

Fig. 9 is a schematic cross-sectional view of an optical sensor according to a first embodiment. The optical sensor 300 shown in Fig. 9 comprises a substrate 1, a first electrode 7a formed on the substrate 1, an active layer 2 comprising an organic semiconductor thin-film of the invention formed on the first electrode 7a, a charge generation layer 8 formed on the active layer 2, and a second electrode 7b formed on the charge generation layer 8.

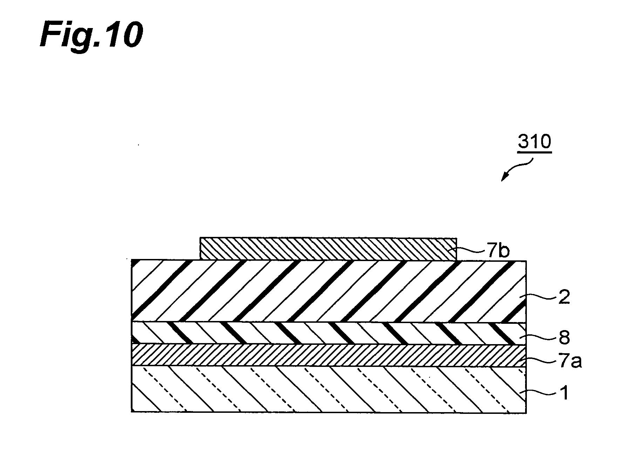

Fig. 10 is a schematic cross-sectional view of an optical sensor according to a second embodiment. The optical sensor 310 shown in Fig. 10 comprises a substrate 1, a first electrode 7a formed on the substrate 1, a charge generation layer 8 formed on the first electrode 7a, an active layer 2 comprising an organic semiconductor thin-film of the invention formed on the charge generation layer 8, and a second electrode 7b formed on the active layer 2.

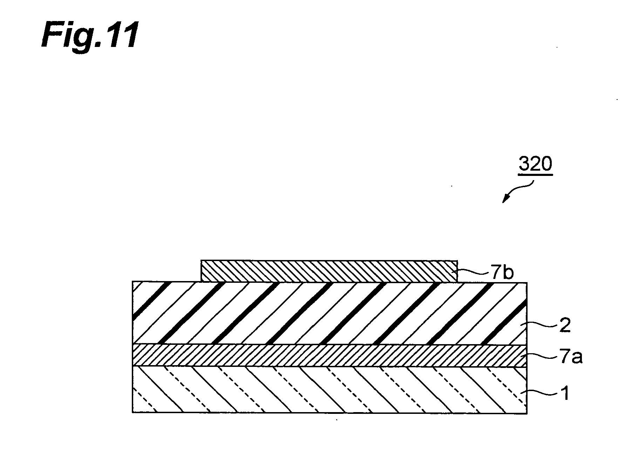

Fig. 11 is a schematic cross-sectional view of an optical sensor according to a third embodiment. The optical sensor 320 shown in Fig. 11 comprises a substrate 1, a first electrode 7a formed on the substrate 1, an active layer 2 comprising an organic semiconductor thin-film of the invention formed on the first electrode 7a, and a second electrode 7b formed on the active layer 2.

In the optical sensors of the first to third embodiments, a transparent or semi-transparent electrode is used for either or both the first electrode 7a and second electrode 7b. The charge generation layer 8 is a layer that generates an electrical charge upon absorption of light. As electrode materials there may be used metals such as aluminum, gold, silver, copper, alkali metal and alkaline earth metals or their semi-transparent films, or transparent conductive films. Carrier generators, sensitizing agents and the like may also be added in order to increase photosensitivity in the active layer 2 (organic semiconductor thin-film). The substrate 1 may be a silicon substrate, glass panel, plastic panel or the like.

### [Electronic device comprising organic transistor]

The organic transistor of the invention described above can be applied in a driving circuit for any of a variety of electronic devices. Examples of electronic devices to which the organic transistor of the invention may be applied include display devices used in the display devices of computers, televisions, portable terminals, cellular phones, car navigation systems, viewfinders of video cameras and the like, as well as planar light sources for backlights or illumination of liquid crystal display apparatuses. A flexible organic transistor can be used in a curved planar light source or display device.

### Examples

The present invention will now be explained in greater detail through the following examples, with the understanding that these examples are in no way limitative on the invention.

### [Measurement of number-average molecular weight and weight-average molecular weight]

The molecular weights of the polymer compounds and other components in the following examples were measured by determining the number-average molecular weight based on polystyrene, with measurement using a GPC by Shimadzu Corp. (trade name: LC-10Avp) or a GPC by GPC Laboratories (trade name: PL-GPC2000). First, for measurement with LC-10Avp, the polymer compound was dissolved in tetrahydrofuran to a concentration of about 0.5 wt% and 50 µl thereof was injected into the GPC. The GPC mobile phase was tetrahydrofuran, and the flow rate was 0.6 mL/min. The columns used were two TSKgel SuperHM-H (Tosoh Corp.) and one TSKgel SuperH2000 (Tosoh Corp.), connected in series. The detector used was a differential refractometer (trade name: RID-10A, product of Shimadzu Corp.).

For measurement with PL-GPC2000, the polymer compound was dissolved in o-dichlorobenzene to a concentration of about 1 wt%. The GPC mobile phase was o-dichlorobenzene, and the flow rate was 1 mL/min at a measuring temperature of 140°C. The columns were three PLGEL 10 µm MIXED-B (PL Laboratories, Inc.), connected in series.

### [Synthesis of starting compounds]

### (Synthesis Example 1: Synthesis of 1,6-didodecylpyrene)

In a 1000 ml three-necked flask there were placed 8.5 g (23.6 mmol) of 1,6-dibromopyrene and 520 ml of dehydrated THF, the mixture was cooled to -78°C, and then 37.36 ml of n-butyllithium (1.6 M hexane solution) was added dropwise with a gas-tight syringe. After stirring for 2 hours at -78°C, 14.71 g of bromododecane was further added dropwise. Upon completion of the dropwise addition, the temperature was returned to room temperature and reaction was conducted for approximately 5 hours. The obtained reaction mixture was slowly poured into water to suspend the reaction, and after extracting the organic layer with hexane, the organic layer was rinsed 3 times. The obtained organic layer was concentrated and purified twice with a silica gel column using hexane as the developing solvent, to obtain 2.75 g of 1,6-didodecylpyrene represented by the following chemical formula (14) below. The obtained compound was analyzed with a mass spectrometer, yielding the following results.
MS (APCI (+)): (M+H)⁺: 539

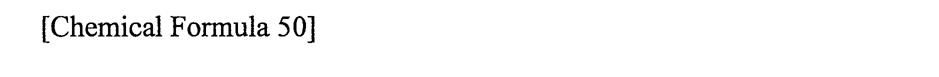

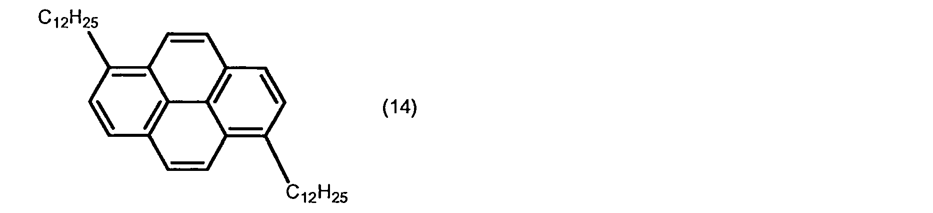

### (Synthesis Example 2: Synthesis of 1,6-dibromo-3,8-didodecylpyrene)

In a 300 ml argon-exchanged three-necked flask there were placed 2.7 g (5.01 mmol) of the 1,6-didodecylpyrene obtained in Synthesis Example 1 and 200 ml of chloroform, and the mixture was stirred at room temperature to dissolution. To this solution, a solution obtained by dissolving 1.602 g (10.02 mmol) of bromine in 20 ml of chloroform was added dropwise over a period of about one hour at room temperature. After stirring for 8 hours, 100 ml of saturated aqueous sodium thiosulfate was added to the obtained solution to terminate the reaction, and the mixture was stirred at room temperature to precipitate a solid. The precipitated solid (insoluble portion) was filtered and recovered. After then recrystallizing it in chloroform, the precipitated crystals were hot filtered with a chloroform-THF mixed solvent, and after further recrystallization, 2.35 g of 1,6-dibromo-3,8-didodecylpyrene represented by the following chemical formula (15) was obtained as white crystals. The obtained compound was analyzed by ¹H-NMR, yielding the following results.
¹H-NMR (300 MHz/CDCl₃):δ 8.45(2H,d), 8.26(2H,d), 8.14(2H,s), 3,29(4H,t), 1.81(4H,m), 1.31-1.26(36H,m), 0.88(6H,t)

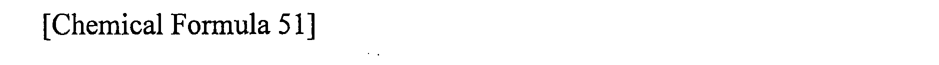

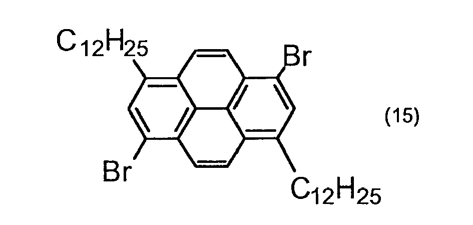

### (Synthesis Example 3: Synthesis of 1,6-bis(4,4,5,5-tetramethyl-1,3,2-dioxaborolane-2-yl)-3,8-didodecylpyrene)

To a 100 ml argon-exchanged 4-necked flask there were added 1.87 g (2.68 mmol) of the 1,6-dibromo-3,8-didodecylpyrene obtained in Synthesis Example 2, 1.50 g (5.91 mmol) of diboron bispinacolate, 0.13 g (0.16 mmol) of Pd(dppf)₂Cl₂, 0.09 g (0.16 mmol) of 1,1-diphenylphosphinoferrocene (dppf), 3.48 g (35.4 mmol) of potassium acetate and 23 ml of 1,4-dioxane under a nitrogen atmosphere, and the mixture was heated to 110°C and stirred. After 9 hours, the reaction mixture was filtered with Celite to remove the solvent. The remaining solid was dissolved in toluene, active carbon was added and the mixture was stirred at 80°C for 30 minutes. The mixture was hot filtered with Celite to remove the solvent, and the residue was redissolved in hexane and again subjected to activated carbon treatment. The filtrate was then recrystallized to obtain 0.38 g of 1,6-bis(4,4,5,5-tetramethyl-1,3,2-dioxaborolane-2-yl)-3,8-didodecylpyrene represented by the following chemical formula (16) as white crystals. The obtained compound was analyzed with a mass spectrometer, yielding the following results.
MS (APCI (+)): (M+H)⁺: 791

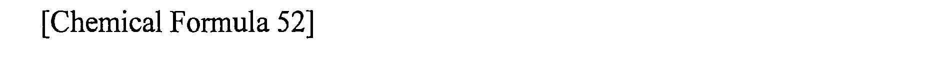

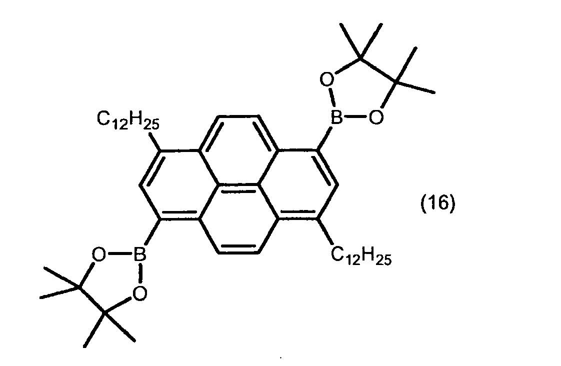

### [Synthesis of polymer compounds]

### (Example 1)

To a 50 ml nitrogen-exchanged three-necked flask there were added 0.34 g (0.43 mmol) of the 1,6-bis(4,4,5,5-tetramethyl-1,3,2-dioxaborolane-2-yl)-3,8-didodecylpyrene obtained in Synthesis Example 3, 0.14 g (0.43 mmol) of 5,5'-dibromo-2,2'-bithiophene, 0.215 mg of Pd(PPh₃)₂Cl₂, 0.05 g of tricaprylylmethylammonium chloride (trade name: Aliquat336, product of Aldrich) and 5.4 ml of toluene, and the mixture was heated to 105°C while adding 0.79 ml of aqueous sodium carbonate (2 M/L) dropwise. Upon completion of the dropwise addition, the mixture was heated to reflux for 5 hours, 11 mg of phenylboric acid was added and the mixture was further heated to reflux for 3 hours. Next, 0.25 g of sodium N,N-diethyldithiocarbamate trihydrate and water were added and the mixture was stirred at 90°C for 5 hours.

After then removing the aqueous layer, the organic layer was rinsed three times with hot water, three times with 3 wt% acetic acid and three times with hot water. After subsequently removing the solvent, the residue was redissolved in o-dichlorobenzene and passed through a silica gel-alumina column, and then added to 300 ml of methanol. The deposited precipitate was filtered and recovered, and dried under reduced pressure. The weight of the obtained polymer compound was 0.2 g. The number-average molecular weight based on polystyrene was 1.3 × 10⁴, and the weight-average molecular weight was 2.9 × 10⁴.

### (Comparative Example 1)

To a 1000 ml argon-exchanged separable flask there were added 18.5 g (35.0 mmol) of 2,7-bis(1,3,2-dioxaborolane-2-yl)-9,9-dioctylfluorene, 11.72 g (36.2 mmol) of 5,5'-dibromo-2,2'-bithiophene, 7.5 mg of Pd(OAc)₂, 49.9 mg of P(o-tol)₃, 4.0 g of tricaprylylmethylammonium chloride (trade name: Aliquat336, product of Aldrich) and 300 ml of mesitylene, and the mixture was bubbled with argon for 15 minutes. The container was then placed in an oil bath preheated to 55°C, and 60 ml of aqueous sodium carbonate (2 M/L) was added dropwise while stirring. Upon completion of the dropwise addition, the mixture was heated to 95°C and further heated to reflux for 8 hours, after which 2 g of phenylboric acid and 40 ml of THF were added and the mixture was further heated to reflux for 8 hours.

After adding 700 ml of mesitylene to the mixture for dilution, 200 ml of a 7.5 wt% sodium N,N-diethyldithiocarbamate trihydrate aqueous solution was added and the mixture was stirred at 85°C for 3 hours. After then removing the aqueous layer, rinsing was performed three times with 300 ml of hot water, three times with 3 wt% acetic acid and three times with hot water. The obtained solution was passed through a silica gel-alumina column, and then added to 3000 ml of methanol. The deposited precipitate was filtered and recovered, and dried under reduced pressure. The weight of the obtained polymer compound was 6.65 g. The number-average molecular weight based on polystyrene was 4.1 × 10⁴, and the weight-average molecular weight was 6.9 × 10⁴.

### (Comparative Example 2)

To a 200 ml nitrogen-exchanged three-necked flask there were added 2.33 g (4.4 mmol) of 2,7-bis(1,3,2-dioxaborolane-2-yl)-9,9-dioctylfluorene, 0.62 g (1.7 mmol) of 1,6-dibromopyrene, 0.84 g (2.6 mmol) of 5,5'-dibromo-2,2'-bithiophene, 6.0 mg of Pd(PPh₃)₂Cl₂, 0.7 g of tricaprylylmethylammonium chloride (trade name: Aliquat336, product of Aldrich) and 33 ml of toluene, and the mixture was heated to 105°C while adding 10 ml of aqueous sodium carbonate (2 M/L) dropwise. Upon completion of the dropwise addition, the mixture was heated to reflux for 1 hour, 60 mg of phenylboric acid was added and the mixture was further heated to reflux for 3 hours. Next, 1.0 g of sodium N,N-diethyldithiocarbamate trihydrate and 16 ml of water were added and the mixture was stirred at 90°C for 3 hours.

After then removing the aqueous layer from the obtained mixture, the organic layer was rinsed three times with hot water, three times with 3 wt% acetic acid and three times with hot water. The solution was then added to 860 ml of methanol. The deposited precipitate was filtered and recovered, and dried under reduced pressure. After subsequently removing the solvent, the residue was redissolved in toluene and passed through a silica gel-alumina column, after which 860 ml of methanol was added. The deposited precipitate was filtered and recovered, and dried under reduced pressure. The weight of the obtained polymer compound was 1.45 g. The number-average molecular weight based on polystyrene was 9.3 × 10⁴, and the weight-average molecular weight was 3.4 × 10⁵.

### [Measurement of transistor properties]

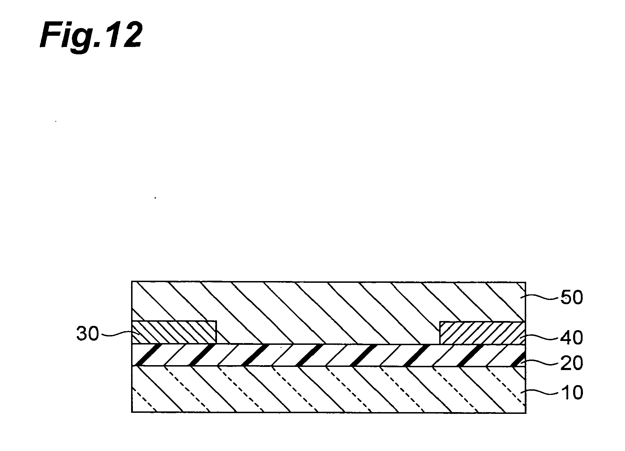

Each of the polymer compounds obtained in Example 1 and Comparative Examples 1-2 was used to fabricate an organic thin-film device as shown in Fig. 12, and the transistor properties thereof were measured.

### (Example 2)

First, the surface of an n-doped silicon substrate 10 doped to a high concentration, as a gate electrode, was thermally oxidized to form a 200 nm silicon oxide film 20. Next, a source electrode 30 and drain electrode 40 with a channel length of 20 µm and a channel width of 2 mm were formed on a thermal oxidation film (chromium, gold from the thermal oxidation film side) by photolithography. The substrate obtained in this manner was thoroughly washed and then hexamethylenedisilazane (HMDS) was used for silane treatment of the substrate surface by spin coating. Next, the polymer compound of Example 1 was dissolved in orthodichlorobenzene to prepare a 0.5 wt% solution, and after filtering with a membrane filter, it was coated onto the aforementioned surface treated substrate by spin coating. An approximately 60 nm organic semiconductor thin-film (active layer 50) comprising the polymer compound of Example 1 was thus formed.

The transistor properties of the organic thin-film device were measured under conditions with the gate voltage Vg varied between 0 to -60 V and the source/drain voltage Vsd varied between 0 to -60 V. As a result, the drain current was 34 µA at Vg = -60 V, Vsd = -60 V as the transfer characteristic. From this property, the field-effect mobility was calculated to be 2.6 × 10⁻² cm²/Vs and the current on/off ratio was calculated to be 1 × 10⁵.

### (Comparative Example 3)

An organic thin-film device was fabricated in the same manner as Example 2, except that a 0.5 wt% solution obtained by dissolving the polymer compound of Comparative Example 1 in toluene was used for formation of the active layer 50.

The transistor properties of the obtained organic thin-film device were measured under conditions with the gate voltage Vg varied between 0 to -60 V and the source/drain voltage Vsd varied between 0 to -60 V. As a result, the drain current value was 0.55 µA at Vg = -60 V, Vsd = -60 V as the transfer characteristic, which was lower compared to Example 2. The field-effect mobility was 1.1 × 10⁻³ cm²/Vs, and the current on/off ratio was 1 × 10³, which were both lower than Example 2.

### (Comparative Example 4)

An organic thin-film device was fabricated in the same manner as Example 2, except that a 0.5 wt% solution obtained by dissolving the polymer compound of Comparative Example 2 in orthodichlorobenzene was used for formation of the active layer 50.

The transistor properties of the obtained organic thin-film device were measured under conditions with the gate voltage Vg varied between 0 to -60 V and the source/drain voltage Vsd varied between 0 to -60 V. As a result, although satisfactory transistor operation was confirmed, a drain current value of 1.6 µA was obtained at Vg = -60 V, Vsd = -60 V as the transfer characteristic, which was lower compared to Example 2. Based on this property, the field-effect mobility was calculated to be 8.8 × 10⁻⁴ cm²/Vs and the current on/off ratio was calculated to be 1 × 10⁴, which were both lower than Example 2.

### [Synthesis of starting compounds]

### (Synthesis Example 4: Synthesis of 1,6-dioctadecylpyrene)

In a 1000 ml three-necked flask there were placed 8.5 g (23.6 mmol) of 1,6-dibromopyrene and 520 ml of dehydrated THF, the mixture was cooled to -78°C, and then 37.36 ml of n-butyllithium (1.6 M hexane solution) was added dropwise with a gas-tight syringe. After stirring for 2 hours at -78°C, 19.68 g (59.0 mmol) of bromooctadecane was further added dropwise. Upon completion of the dropwise addition, the temperature was returned to room temperature and reaction was conducted for approximately 8 hours. The obtained reaction mixture was slowly poured into water to suspend the reaction, and after extracting the organic layer with toluene, the organic layer was rinsed twice. The obtained organic layer was concentrated and recrystallized with hexane to obtain 1.90 g of 1,6-dioctadecylpyrene represented by the following formula (17). The obtained compound was analyzed with a mass spectrometer, yielding the following results.
MS (APCI (+)): (M+H)⁺: 707

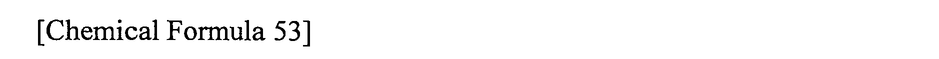

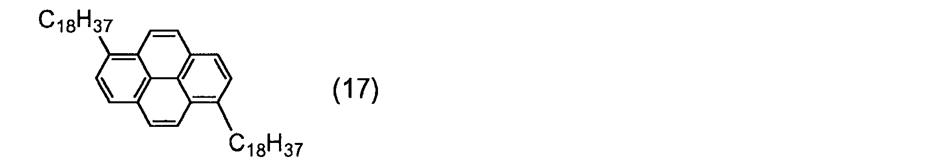

### (Synthesis Example 5: Synthesis of 1,6-dibromo-3,8-dioctadecylpyrene)

In a 200 ml argon-exchanged three-necked flask there were placed 1.9 g (2.69 mmol) of the 1,6-dioctadecylpyrene obtained in Synthesis Example 4 and 55 ml of chloroform, and the mixture was stirred at room temperature to dissolution. A solution obtained by dissolving 0.859 g (5.37 mmol) of bromine in 20 ml of chloroform was added dropwise thereto at room temperature. After stirring for 8 hours, a chloroform solution containing 0.215 g (1.34 mmol) of bromine was added dropwise and reaction was conducted for 3 hours. Next, 100 ml of saturated aqueous sodium thiosulfate was added to the obtained solution to terminate the reaction, and the mixture was stirred at room temperature to precipitate a solid. The precipitated solid (insoluble portion) was filtered and recovered. It was then hot filtered and recrystallized in a chloroform-THF mixed solvent to obtain 1.75 g of 1,6-dibromo-3,8-dioctadecylpyrene represented by the following formula (18) as white crystals.

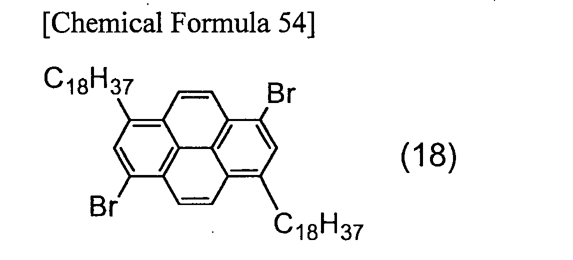

### (Synthesis Example 6: Synthesis of 1,6-bis(4,4,5,5-tetramethyl-1,3,2-dioxaborolane-2-yl)-3,8-dioctadecylpyrene)

To a 100 ml argon-exchanged 4-necked flask there were added 1.75 g (2.02 mmol) of the 1,6-dibromo-3,8-dioctadecylpyrene obtained in Synthesis Example 5, 1.13 g (4.45 mmol) of diboron bispinacolate, 0.10 g (0.12 mmol) of Pd(dppf)₂Cl₂; 0.07 g (0.12 mmol) of 1,1-diphenylphosphinoferrocene (dppf), 2.62 g (26.7 mmol) of potassium acetate and 17 ml of 1,4-dioxane under a nitrogen atmosphere, and the mixture was heated to 125°C and stirred. After 9 hours, the reaction mixture was filtered with Celite to remove the solvent. The remaining solid was dissolved in a hexane and toluene mixed solvent, active carbon was added, and the mixture was stirred for approximately 3 hours at 90°C. The mixture was hot filtered with Celite to remove the solvent and then recrystallized with hexane to obtain 1.02 g of 1,6-bis(4,4,5,5-tetramethyl-1,3,2-dioxaborolane-2-yl)-3,8-dioctadecylpyrene represented by the following formula (19) as white crystals. The obtained compound was analyzed with a mass spectrometer, yielding the following results.
MS (APCI (+)): (M+H)⁺: 959

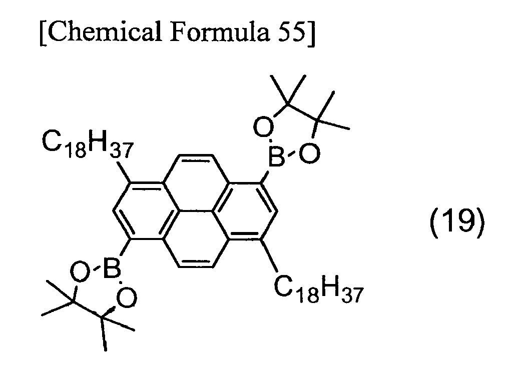

### [Synthesis of polymer compound]

### (Example 3)

To a 50 ml nitrogen-exchanged three-necked flask there were added 0.34 g (0.35 mmol) of the 1,6-bis(4,4,5,5-tetramethyl-1,3,2-dioxaborolane-2-yl)-3,8-dioctadecylpyrene obtained in Synthesis Example 6, 0.11 g (0.35 mmol) of 5,5'-dibromo-2,2'-bithiophene, 0.173 mg of Pd(PPh₃)₂Cl₂, 0.04 g of tricaprylylmethylammonium chloride (trade name: Aliquat336, product of Aldrich) and 5.4 ml of toluene, and the mixture was heated to 105°C while adding 0.64 ml of aqueous sodium carbonate (2 M/L) dropwise. Upon completion of the dropwise addition, the mixture was heated to reflux for 8 hours, 11 mg of phenylboric acid was added and the mixture was further heated to reflux for 3 hours. Next, 0.25 g of sodium N,N-diethyldithiocarbamate trihydrate and water were added and the mixture was stirred at 90°C for 5 hours.

After then removing the aqueous layer, the organic layer was rinsed three times with hot water, three times with 3 wt% acetic acid and three times with hot water. The organic layer was passed through a silica gel-alumina column, and 300 ml of methanol was added. The deposited precipitate was filtered and recovered, and dried under reduced pressure. The weight of the obtained polymer compound was 0.26 g. The number-average molecular weight based on polystyrene was 1.3 × 10⁴, and the weight-average molecular weight was 2.8 × 10⁴.

### [Measurement of transistor properties]

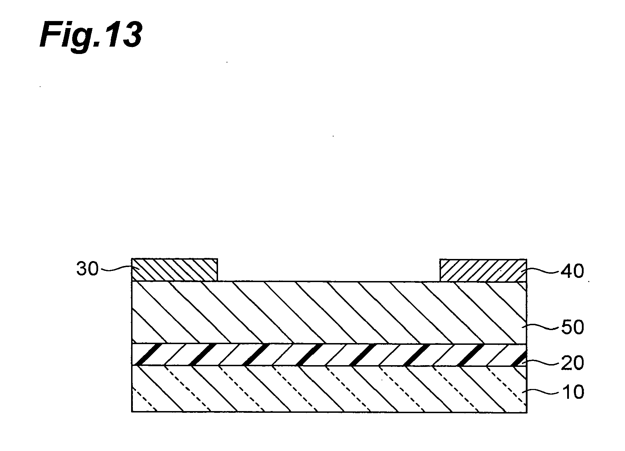

The polymer compounds obtained in Example 3 and Comparative Example 1 were used to fabricate an organic thin-film device as shown in Fig. 12 or 13, and the transistor properties thereof were measured.

### (Example 4)

The polymer compound obtained in Example 3 was used to fabricate an organic thin-film device having the construction shown in Fig. 12, in the same manner as Example 2.

The transistor properties of the organic thin-film device were measured under conditions with the gate voltage Vg varied between 0 to -60 V and the source/drain voltage Vsd varied between 0 to -60 V. As a result, the drain current value was 3.5 µA at Vg = -60 V, Vsd = -60 V as the transfer characteristic. The field-effect mobility was calculated to be 4.2 × 10⁻³ cm²/Vs, and the current on/off ratio was calculated to be 6 × 10⁴. The polymer compound of Example 3 therefore exhibited satisfactory characteristics.

### (Example 5)

The surface of an n-doped silicon substrate (gate electrode 10) doped to a high concentration, as a gate electrode, was thermally oxidized to form a 200 nm silicon oxide film (gate insulating film 20). The substrate was ultrasonically cleaned for 10 minutes with acetone and then irradiated with ozone UV for 30 minutes. Next, the substrate surface was subjected to silane treatment by dipping for 15 hours in hexamethylenedisilazane (HMDS) in a nitrogen-filled glove box. Next, the polymer compound obtained in Example 3 was dissolved in toluene to prepare a 0.5 wt% solution, and after filtering with a membrane filter, it was coated onto the aforementioned surface treated substrate by spin coating to form a coated film. The substrate was then heat treated at 100°C for 30 minutes in a nitrogen-filled glove box to form an organic semiconductor thin-film (active layer 50) comprising the polymer compound obtained in Example 3 from the coated film. Also, a source electrode 30 and drain electrode 40 with a channel length of 20 µm and a channel width of 2 mm (fullerene and gold laminated in that order from the organic semiconductor thin-film side) were formed on an organic semiconductor thin-film by vacuum vapor deposition using a metal mask, to obtain an organic thin-film device having the structure shown in Fig. 13.

The transistor properties of the organic thin-film device were measured under conditions with the gate voltage Vg varied between 0 to -60 V and the source/drain voltage Vsd varied between 0 to -60 V. As a result, the drain current was 15 µA at Vg = -60 V, Vsd = -60 V as the transfer characteristic. From this property, the field-effect mobility was calculated to be 0.011 cm²/Vs and the current on/off ratio was calculated to be 2 × 10⁴.

### (Comparative Example 5)

An organic thin-film device having the structure shown in Fig. 13 was fabricated in the same manner as Example 5, except that a 0.5 wt% solution obtained by dissolving the polymer compound of Comparative Example 1 in chloroform was used for formation of the active layer 50.

The transistor properties of the obtained organic thin-film device were measured under conditions with the gate voltage Vg varied between 0 to -60 V and the source/drain voltage Vsd varied between 0 to -60 V. As a result, although satisfactory transistor operation was confirmed, a drain current value of 13 µA was obtained at Vg = -60 V, Vsd = -60 V as the transfer characteristic, which was lower compared to Example 5. Based on this property, the field-effect mobility was calculated to be 8.2 × 10⁻³ cm²/Vs and the current on/off ratio was calculated to be 1 × 10⁴, which were both lower than Example 5.

### [Synthesis of polymer compound]

### (Example 6)

To a 100 mL nitrogen-exchanged three-necked flask there were added 0.52 g (0.74 mmol) of the 1,6-dibromo-3,8-didodecylpyrene obtained in Synthesis Example 2, 0.29 g (0.74 mmol) of 2,5-bis(4,4,5,5-tetramethyl-1,3,2-dioxaborolane-2-yl)thieno[3,2-b]thiophene, 13.6 mg (0.02 mmol) of tris(dibenzylidene)dipalladium(0), 17.2 mg (0.06 mmol) of tri-t-butylphosphonium tetrafluoroborate and 15 ml of dehydrated THF that had been bubbled with nitrogen for 30 minutes, and the mixture was stirred at 60°C while adding dropwise 1.12 ml of a 2 mol/L potassium carbonate aqueous solution. Upon completion of the dropwise addition, the mixture was heated to reflux for 3 hours, 10.5 mg of phenylboric acid and 4 ml of dehydrated THF were added, and the mixture was stirred for 17 hours. Next, 0.25 g of sodium N,N-diethyldithiocarbamate trihydrate and water were added and the mixture was stirred at 75°C for 4 hours.

The solvent was then removed, 1,2-dichlorobenzene was added and the mixture was stirred at 140°C, after which the aqueous layer was removed. The organic layer was washed once with hot water, twice with 3 wt% acetic acid and again twice with hot water. The organic layer was passed through a silica gel-alumina column, and added to 300 ml of methanol. The deposited precipitate was filtered and recovered, and dried under reduced pressure. The number-average molecular weight of the obtained polymer compound was 4.2 × 10³, and the weight-average molecular weight was 5.9 × 10³.

### [Measurement of transistor properties]

### (Example 7)

The surface of an n-doped silicon substrate (gate electrode 10) doped to a high concentration, as a gate electrode, was thermally oxidized to form a 200 nm silicon oxide film (gate insulating film 20). The substrate was ultrasonically cleaned for 10 minutes with acetone and then irradiated with ozone UV for 30 minutes. This was followed by silane treatment of the substrate surface by dipping for 15 hours using an octadecyltrichlorosilane (ODTS) octane diluent, in a nitrogen-filled glove box. Next, the polymer compound obtained in Example 6 was dissolved in orthodichlorobenzene to prepare a 0.5 wt% solution, and after filtering with a membrane filter, it was coated onto the aforementioned surface treated substrate by spin coating to form a coated film. The substrate was then heat treated at 140°C for 30 minutes in a nitrogen-filled glove box to form an organic semiconductor thin-film (active layer 50) comprising the polymer compound obtained in Example 6 from the coated film. Also, a source electrode 30 and drain electrode 40 with a channel length of 20 µm and a channel width of 2 mm (fullerene and gold laminated in that order from the organic semiconductor thin-film side) were formed on an organic semiconductor thin-film by vacuum vapor deposition using a metal mask, to obtain an organic thin-film device having the structure shown in Fig. 13.

The transistor properties of the organic thin-film device were measured under conditions with the gate voltage Vg varied between 0 to -60 V and the source/drain voltage Vsd varied between 0 to -60 V. As a result, the drain current was 23 µA at Vg = -60 V, Vsd = -60 V as the transfer characteristic. From this property, the field-effect mobility was calculated to be 0.033 cm²/Vs and the current on/off ratio was calculated to be 1 × 10⁶.

### [Synthesis of starting compounds]

### (Synthesis Example 7: Synthesis of 1,6-ditetradecylpyrene)

In a 2000 ml argon-exchanged three-necked flask there were placed 805 ml (402 mmol) of 9-borabicyclo[3,3,1]nonane (0.5 mol/L tetrahydrofuran solution) and 79.1 g (402 mmol) of 1-tetradecene, and after heating to reflux at 85°C for approximately 3 hours, the mixture was cooled to room temperature and stirred overnight. To this solution there were added 14.5 g (40.3 mmol) of 1,6-dibromopyrene, 1.973 g (2.42 mmol) of [1,1'-bis(diphenylphosphino)ferrocene]dichloropalladium, 120 ml of a 2 mol/L sodium hydroxide aqueous solution that had been bubbled with argon for 30 minutes and 150 ml of dehydrated THF, and the mixture was heated to reflux for 5.5 hours. Stirring was suspended, the aqueous layer was removed and the remainder was cooled to room temperature. The precipitated crystals were filtered and recovered, rinsed with isopropanol and hot filtered with Celite. The solvent was then removed and recrystallization was performed with THF to obtain 14.8 g of 1,6-ditetradecylpyrene represented by the following chemical formula (20) as a white solid. The obtained compound was analyzed with a mass spectrometer, yielding the following results.
MS (APCI (+)):M⁺: 595

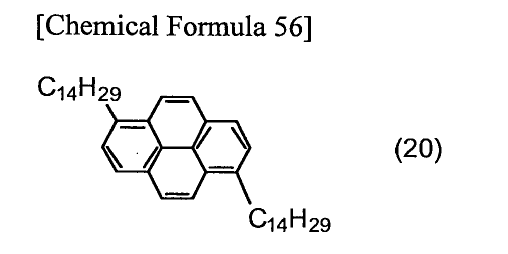

### (Synthesis Example 8: Synthesis of 1,6-dibromo-3,8-tetradecylpyrene)

In a 1000 ml argon-exchanged three-necked flask there were placed 1.46 g (24.5 mmol) of the 1,6-ditetradecylpyrene obtained in Synthesis Example 7 and 350 ml of chloroform, and the mixture was stirred at room temperature for approximately 15 minutes. Into this solution there were added dropwise and dissolved 2.8 ml (54.0 mmol) of bromine and 50 ml of chloroform. After then stirring for approximately 8 hours at room temperature, saturated aqueous sodium thiosulfate was added to suspend the reaction. The organic layer was extracted with chloroform and rinsed twice, and the solvent was removed. THF was then added and the mixture was filtered while hot and cooled to room temperature. The precipitated crystals were recovered and vacuum dried to obtain 15.9 g of the target 1,6-dibromo-3,8-ditetradecylpyrene represented by the following chemical formula (21) as white crystals. The obtained compound was analyzed with a mass spectrometer, yielding the following results.
MS (APCI (+)):M⁺: 753

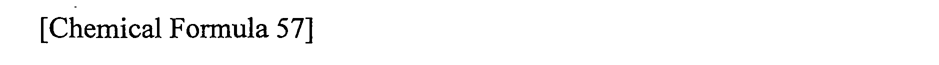

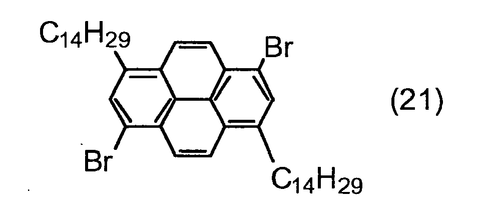

### [Synthesis of polymer compound]

### (Example 8)

To a 100 mL nitrogen-exchanged three-necked flask there were added 0.52 g (0.68 mmol) of the 1,6-dibromo-3,8-ditetradecylpyrene obtained in Synthesis Example 8, 0.27 g (0.68 mmol) of 2,5-bis(4,4,5,5-tetramethyl-1,3,2-dioxaborolane-2-yl)thieno[3,2-b]thiophene, 12.5 mg (0.01 mmol) of tris(dibenzylidene)dipalladium(0), 15.9 mg (0.06 mmol) of tri-t-butylphosphonium tetrafluoroborate and 15 ml of dehydrated THF that had been bubbled with nitrogen for 30 minutes, and the mixture was stirred at 60°C while adding dropwise 1.10 ml of a 2 mol/L potassium carbonate aqueous solution. Upon completion of the dropwise addition, the mixture was heated to reflux for 5 hours, and then 10.5 mg of phenylboric acid and 4 ml of dehydrated THF were added and the mixture was stirred for overnight. Next, 0.31 g of sodium N,N-diethyldithiocarbamate trihydrate and water were added and the mixture was stirred at 75°C for 3 hours.

The solvent was then removed, 1,2-dichlorobenzene was added and the mixture was stirred at 140°C, after which the aqueous layer was removed. The organic layer was washed once with hot water, twice with 3 wt% acetic acid and again twice with hot water. The organic layer was passed through a silica gel-alumina column, and 300 ml of methanol was added. The deposited precipitate was filtered and recovered, and dried under reduced pressure. The number-average molecular weight of the obtained polymer compound was 4.8 × 10³, and the weight-average molecular weight was 6.2 × 10³.

### [Measurement of transistor properties]

### (Example 9)

The polymer compound obtained in Example 8 was used to fabricate an organic thin-film device having the construction shown in Fig. 13, in the same manner as Example 7.

The transistor properties of the organic thin-film device were measured under conditions with the gate voltage Vg varied between 0 to -60 V and the source/drain voltage Vsd varied between 0 to -60 V. As a result, the drain current value was 5.4 µA at Vg = -60 V, Vsd = -60 V as the transfer characteristic. The field-effect mobility was calculated to be 6.6 × 10⁻³ cm²/Vs, and the current on/off ratio was calculated to be 1 × 10⁵.

### [Measurement of transistor properties]

### (Comparative Example 6)

An organic thin-film device having the structure shown in Fig. 13 was fabricated in the same manner as Example 7, except that a 0.5 wt% solution obtained by dissolving the polymer compound of Comparative Example 1 in chloroform was used for formation of the active layer 50.

The transistor properties of the obtained organic thin-film device were measured under conditions with the gate voltage Vg varied between 0 to -60 V and the source/drain voltage Vsd varied between 0 to -60 V. As a result, although satisfactory transistor operation was confirmed, a drain current value of 5.0 µA was obtained at Vg = -60 V, Vsd = -60 V as the transfer characteristic, which was lower compared to Examples 6 and 7. Based on this property, the field-effect mobility was calculated to be 4.8 × 10⁻³ cm²/Vs and the current on/off ratio was calculated to be 1 × 10⁴, which were both lower than Examples 6 and 7.

### [Synthesis of starting compound]

### (Synthesis Example 9: Synthesis of 1,6-bis(4,4,5,5-tetramethyl-1,3,2-dioxaborolane-2-yl)pyrene)

After placing 2.0 g (5.56 mmol) of 1,6-dibromopyrene, 3.09 g (12.2 mmol) of bispinacolato diboron, 0.27 g (0.33 mmol) of dichlorobis(diphenylphosphinoferrocene)palladium, 7.20 g (73.3 mmol) of potassium acetate, 0.19 g (0.33 mmol) of 1,1-diphenylphosphinoferrocene and 47 ml of dehydrated dioxane in a 200 ml three-necked flask under a nitrogen atmosphere, the mixture was heated to reflux for approximately 10 hours. The reaction mixture was filtered with Celite, and then the insoluble portion was rinsed with hot toluene. The filtrate was concentrated, hexane was again added, and the mixture was heated and rinsed and then hot filtered. Active carbon was added to the filtrate for decoloration treatment, and then Celite filtration was performed. After concentrating the obtained colorless transparent filtrate, it was dried under reduced pressure to obtain 0.29 g of 1,6-bis(4,4,5,5-tetramethyl-1,3,2-dioxaborolane-2-yl)pyrene represented by the following chemical formula (22) as a white solid. The obtained compound was analyzed by ¹H-NMR, yielding the following results.
¹H-NMR (300 MHz/CDCl₃)δ 9.08(2H,d), 8.56(2H,d), 8.48(2H,s), 8.21(4H,m), 1.49(24H,m)

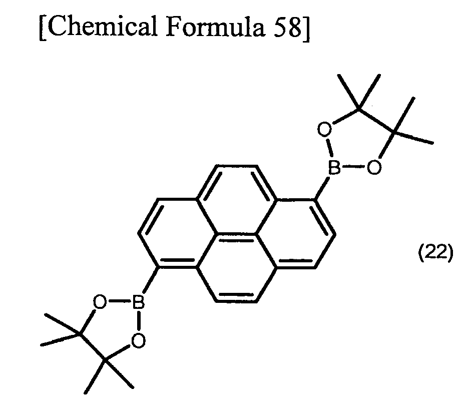

### [Synthesis of polymer compound]

### (Comparative Example 7)

To a 50 mL nitrogen-exchanged three-necked flask there were added 0.20 g (0.43 mmol) of the 1,6-bis(4,4,5,5-tetramethyl-1,3,2-dioxaborolane-2-yl)pyrene obtained in Synthesis Example 9, 0.28 g (0.43 mmol) of 5,5'-dibromo-4,4'-didodecylthiophene, 0.22 mg (3.06 µmol) of dichlorobis(triphenylphosphine)palladium, 49.4 mg (0.12 mmol) of tricaprylylmethylammonium chloride (trade name: Aliquat336, product of Aldrich) and 15 ml of toluene, and then the mixture was stirred at 55°C while adding dropwise 0.79 ml of a 2 mol/L potassium carbonate aqueous solution. Upon completion of the dropwise addition, the mixture was raised to a temperature of 105°C and heated to reflux for 4.5 hours, and then 30.0 mg of phenylboric acid and 2 ml of dehydrated THF were added and the mixture was stirred at 95°C for 3 hours. Next, 0.25 g of sodium N,N-diethyldithiocarbamate trihydrate and water were added and the mixture was stirred for 6 hours.

After then removing the aqueous layer from the obtained mixture, the organic layer was rinsed once with hot water, once with 2 wt% acetic acid and once with hot water. The organic layer was added to methanol, and the precipitated solid was recovered and dried under reduced pressure. The solid was redissolved in o-dichlorobenzene and passed through a silica gel-alumina column, and then 300 ml of methanol was added. The deposited precipitate was filtered and recovered, and dried under reduced pressure. The number-average molecular weight of the obtained polymer compound was 1.2 × 10³, and the weight-average molecular weight was 1.4 × 10³.

### [Measurement of transistor properties]

### (Comparative Example 8)

The polymer compound obtained in Comparative Example 7 was used to fabricate an organic thin-film device having the construction shown in Fig. 13, in the same manner as Example 7.

The transistor properties of the organic thin-film device were measured under conditions with the gate voltage Vg varied between 0 to -60 V and the source/drain voltage Vsd varied between 0 to -60 V. As a result, almost no drain current was observed as the transfer characteristic, and the field-effect mobility and current on/off ratio could not be calculated.

## Claims

1. A polymer compound comprising a repeating unit represented by the following formula (1). 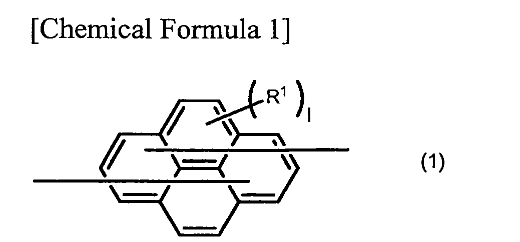 [In the formula, R¹ represents an alkyl group, alkoxy group, alkylthio group, aryl group, aryloxy group, arylthio group, arylalkyl group, arylalkoxy group, arylalkylthio group, substituted silyl group, substituted carboxyl group, monovalent heterocyclic group, cyano group or a fluorine atom, and 1 is an integer of 2 to 8. The multiple R¹ groups may be the same or different.]

2. The polymer compound according to claim 1, wherein the repeating unit represented by formula (1) is a repeating unit selected from the group consisting of repeating units represented by the following formulas (2a) and (2b). 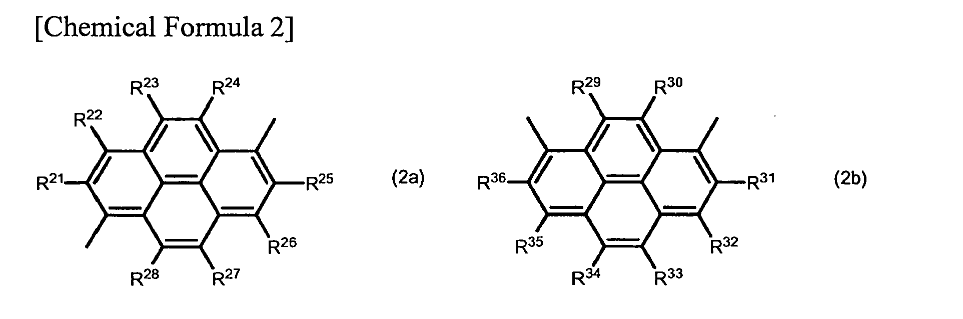 [In the formulas, R²¹ to R³⁶ each independently represent a hydrogen atom, an alkyl group, alkoxy group, alkylthio group, aryl group, aryloxy group, arylthio group, arylalkyl group, arylalkoxy group, arylalkylthio group, substituted silyl group, substituted carboxyl group, monovalent heterocyclic group, cyano group or a fluorine atom. This is with the provision that at least two of R²¹ to R²⁸ are groups other than hydrogen atom, and at least two of R²⁹ to R³⁶ are groups other than hydrogen atom.]

3. The polymer compound according to claim 1 or 2, further comprising a repeating unit represented by the following formula (3). 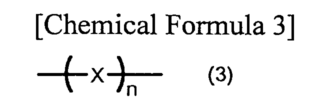 [In the formula, X represents an arylene group, a divalent heterocyclic group, divalent group with a metal complex structure, divalent aromatic amine, group represented by -CR⁴⁵=CR⁴⁶- (where R⁴⁵ and R⁴⁶ each independently represent hydrogen atom, an alkyl group, alkoxy group, alkylthio group, aryl group, aryloxy group, arylthio group, arylalkyl group, arylalkoxy group, arylalkylthio group, arylalkenyl group, arylalkynyl group, amino group, substituted amino group, silyl group, substituted silyl group, fluorine atom, monovalent heterocyclic group or cyano group), or a group represented by -C≡C-, and any of these may be optionally substituted. n represents an integer of 1 to 5. When several X groups are present, the X groups may be the same or different.]

4. The polymer compound according to claim 2 or 3, wherein R²² and R²⁶ of formula (2a) are similar groups other than hydrogen atom, and/or R³² and R³⁵ in formula (2b) are similar groups other than hydrogen atom.

5. The polymer compound according to any one of claims 2 to 4, wherein R²¹, R²³, R²⁴, R²⁵, R²⁷ and R²⁸ in formula (2a) are hydrogen atom, and/or R²⁹, R³⁰, R³¹, R³³, R³⁴ and R³⁶ in formula (2b) are hydrogen atom.

6. The polymer compound according to any one of claims 3 to 5, wherein X in formula (3) is a divalent heterocyclic group.

7. The polymer compound according to any one of claims 3 to 6, wherein n in formula (3) is 2.

8. The polymer compound according to any one of claims 3 to 7, wherein the repeating unit represented by formula (3) is a structure represented by the following formula (4). 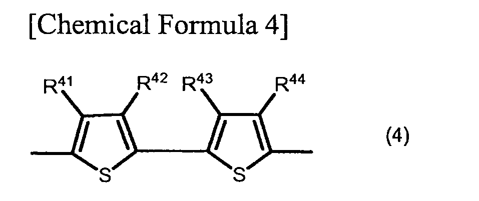 [In the formula, R⁴¹ to R⁴⁴ each independently represent a hydrogen atom, alkyl group, alkoxy group, alkylthio group, aryl group, aryloxy group, arylalkyl group, arylalkoxy group, substituted silyl group, carboxyl group, a monovalent heterocyclic group, cyano group or fluorine atom.]

9. A method for producing a polymer compound comprising a repeating unit represented by the following formula (1), comprising a polymerization step in which a compound represented by the following formula (5) is polymerized. 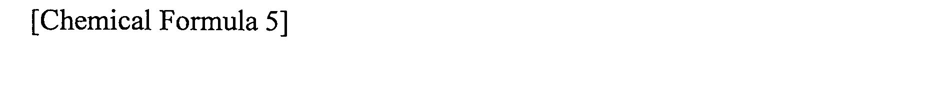 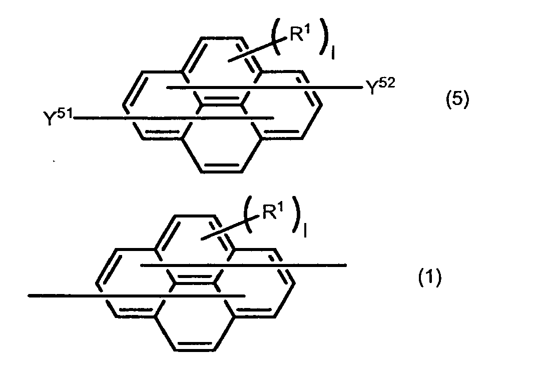 [In the formula, R¹ represents an alkyl group, alkoxy group, alkylthio group, aryl group, aryloxy group, arylthio group, arylalkyl group, arylalkoxy group, arylalkylthio group, substituted silyl group, substituted carboxyl group, a monovalent heterocyclic group, cyano group or fluorine atom, and 1 is an integer of 2 to 8. The multiple R¹ groups may be the same or different. Y⁵¹ and Y⁵² are each independently a polymerizable substituent.]

10. The method for producing a polymer compound according to claim 9, wherein the compound represented by formula (5) is a compound selected from the group consisting of the following formulas (6a) and (6b). 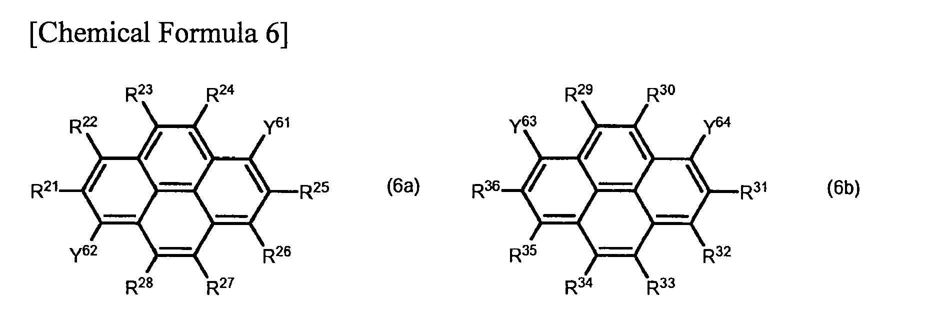 [In the formulas, R²¹ to R³⁶ each independently represent a hydrogen atom, alkyl group, alkoxy group, alkylthio group, aryl group, aryloxy group, arylthio group, arylalkyl group, arylalkoxy group, arylalkylthio group, substituted silyl group, substituted carboxyl group, a monovalent heterocyclic group, cyano group or fluorine atom. This is with the provision that at least two of R²¹ to R²⁸ are groups other than hydrogen atom, and at least two of R²⁹ to R³⁶ are groups other than hydrogen. Y⁶¹ to Y⁶⁴ are each independently a polymerizable substituent.]

11. The method for producing a polymer compound according to claim 9 or 10, wherein a compound represented by the following formula (7) is further polymerized in the polymerization step. 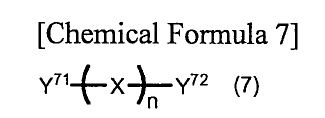 [In the formula, X represents an arylene group, a divalent heterocyclic group, a divalent group with a metal complex structure, or -C≡C-, and any of these may be optionally substituted. n represents an integer of 1 to 5. When several X groups are present, the X groups may be the same or different. Y⁷¹ and Y⁷² are each independently a polymerizable substituent.]

12. A composition comprising a polymer compound according to any one of claims 1 to 8.

13. An ink composition comprising a polymer compound according to any one of claims 1 to 8, and a solvent.

14. The ink composition according to claim 13, wherein the 25°C viscosity is 1-20 mPa·s.

15. A thin-film comprising a polymer compound according to any one of claims 1 to 8.

16. An organic transistor provided with an organic semiconductor layer comprising a thin-film according to claim 15.
